# EUROPÄISCHE PATENTSCHRIFT

(11) **EP 2 780 345 B1**
(45) Veröffentlichungstag und Bekanntmachung des Hinweises auf die Patenterteilung: **12.04.2017**
(21) Anmeldenummer: 12809626.0
(22) Anmeldetag: 16.11.2012
(51) Int. Cl.: C07F 1/08, H01L 51/00

(54) **HETEROLEPTISCHE KUPFER-KOMPLEXE FÜR OPTOELEKTRONISCHE ANWENDUNGEN**
COPPER COMPLEXES FOR OPTOELECTRONIC APPLICATIONS
COMPLEXES CUIVRÉS POUR APPLICATIONS OPTOÉLECTRONIQUES

(30) Priorität: 16.11.2011 EP 11189397; 21.12.2011 EP 11195010
(43) Veröffentlichungstag der Anmeldung: 24.09.2014
(73) Patentinhaber: cynora GmbH, 76646 Bruchsal (DE)
(72) Erfinder: GRAB, Tobias, 76133 Karlsruhe (DE); VOLZ, Daniel, 76137 Karlsruhe (DE); BAUMANN, Thomas, 76133 Karlsruhe (DE); ZINK, Daniel, 76646 Bruchsal (DE)
(74) Vertreter: Hoppe, Georg Johannes
(86) Internationale Anmeldenummer: PCT/EP2012/072927
(87) Internationale Veröffentlichungsnummer: WO 2013/072508

(56) Entgegenhaltungen:
- WO-A1-2010/149748

## Beschreibung

Die Erfindung betrifft heteroleptische Kupfer(I)komplexe der allgemeinen Formel A, insbesondere zur Verwendung in optoelektronischen Bauelementen.

### Einleitung

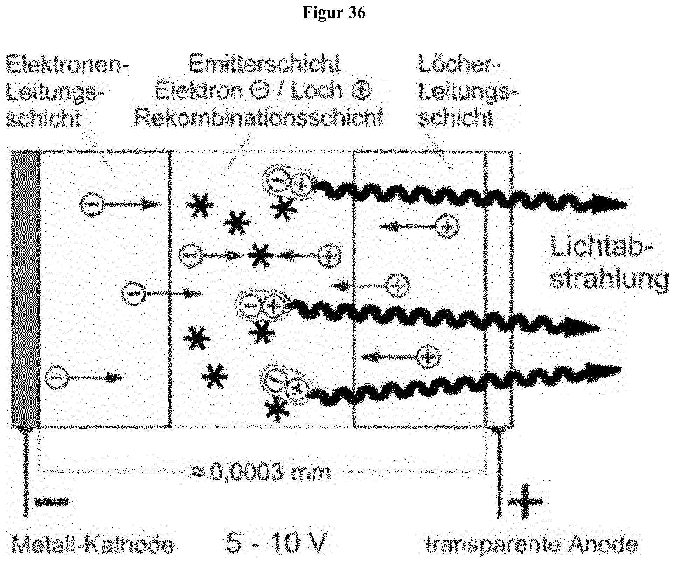

Zur Zeit zeichnet sich ein drastischer Wandel im Bereich der Bildschirm- und Beleuchtungstechnik ab. Es wird möglich sein, flache Displays oder Leuchtflächen mit einer Dicke von unter 0,5 mm zu fertigen. Diese sind durch viele faszinierende Eigenschaften ausgezeichnet. So werden z. B. Leuchtflächen als Tapeten mit sehr geringem Energieverbrauch realisierbar sein. Ferner werden Farbbildschirme mit bisher nicht erreichbarer Farb-Echtheit, Helligkeit und Blickwinkelunabhängigkeit, mit geringem Gewicht sowie sehr niedrigem Stromverbrauch herstellbar sein. Die Bildschirme werden sich als Mikro-Displays oder Großbildschirme mit mehreren m² Fläche in starrer Form oder flexibel, aber auch als Transmissions- oder Reflexions-Displays gestalten lassen. Ferner wird es möglich sein, einfache und kostensparende Herstellungsverfahren wie Siebdruck oder Tintenstrahldruck oder Vakuum-Sublimation einzusetzen. Dadurch wird im Vergleich zu herkömmlichen Flachbildschirmen eine sehr preiswerte Fertigung ermöglicht. Diese neue Technik basiert auf dem Prinzip der **OLED**s, den **O**rganic **L**ight **E**mitting **D**iodes, die in Figur 36 schematisch und vereinfacht dargestellt ist.

Derartige Bauteile bestehen vorwiegend aus organischen Schichten, wie in Figur 36 schematisch und vereinfacht gezeigt ist. Bei einer Spannung von z. B. 5 V bis 10 V treten aus einer leitenden Metallschicht, z. B. aus einer Aluminium-Kathode, negative Elektronen in eine dünne Elektronen-Leitungsschicht und wandern in Richtung der positiven Anode. Diese besteht z. B. aus einer durchsichtigen, aber elektrisch leitenden, dünnen Indium-Zinn-Oxid-Schicht, von der positive Ladungsträger, sog. Löcher, in eine organische Löcher-Leitungsschicht einwandern. Diese Löcher bewegen sich im Vergleich zu den Elektronen in entgegengesetzter Richtung, und zwar auf die negative Kathode zu. In einer mittleren Schicht, der Emitterschicht, die ebenfalls aus einem organischen Material besteht, befinden sich zusätzlich besondere Emitter-Moleküle, an denen oder in deren Nähe die beiden Ladungsträger rekombinieren und dabei zu neutralen, aber energetisch angeregten Zuständen der Emitter-Moleküle führen. Die angeregten Zustände geben dann ihre Energie als helle Lichtemission ab, z. B. in blauer, grüner oder roter Farbe. Auch Weiß-LichtEmission ist realisierbar. Auf die Emitterschicht kann gegebenenfalls auch verzichtet werden, wenn die Emittermoleküle sich in der Loch- oder Elektronen-Leitungsschicht befinden.

Die neuen OLED-Bauelemente lassen sich großflächig als Beleuchtungskörper oder auch äußerst klein als Pixel für Displays gestalten. Entscheidend für den Bau hoch-effektiver OLEDs sind die verwendeten Leuchtmaterialien (Emitter-Moleküle). Diese können in verschiedener Weise realisiert werden, und zwar unter Verwendung rein organischer oder metall-organischer Moleküle sowie von Komplexverbindungen. Es lässt sich zeigen, dass die Lichtausbeute der OLEDs mit metallorganischen Substanzen, den sog. Triplett-Emittern, wesentlich größer sein kann als für rein organische Materialien. Aufgrund dieser Eigenschaft kommt der Weiterentwicklung der metallorganischen Materialien ein wesentlicher Stellenwert zu. Die Funktion von OLEDs ist bereits sehr häufig beschrieben worden.^{[i-vi]} Unter Einsatz von metallorganischen Komplexen mit hoher Emissionsquantenausbeute (Übergänge unter Einbeziehung der untersten Triplett-Zustände zu den Singulett-Grundzuständen) lässt sich eine besonders hohe Effizienz des Devices erzielen. Diese Materialien werden häufig als Triplett-Emitter oder phosphoreszierende Emitter bezeichnet. Diese Erkenntnis ist seit längerem bekannt.^{[i-v]} Für Triplett-Emitter wurden bereits viele Schutzrechte beantragt bzw. erteilte.^{[vii-xix]}

Kupferkomplexe der Form Cu₂X₂L₄, Cu₂X₂L'₂ und Cu₂X₂L₂L' (L = Phosphan-, Amin-, Imin-Ligand; L' = zweizähniger Phosphan-, Imin-, Amin-Ligand, s.u.) sind bereits aus dem Stand der Technik bekannt. Sie zeigen intensive Lumineszenz bei Anregung mit UV Licht. Die Lumineszenz kann entweder von einem MLCT-, CC (*cluster centered*)- oder XLCT (*halogen-to-ligand-charge-transfer*)*-*Zustand oder einer Kombination dieser stammen. Weitere Einzelheiten zu ähnlichen Cu(I)-Systemen können der Literatur entnommen werden.^{[xx]} Bei dem verwandten [Cu₂X₂(PPh₃)₂nap]-Komplex (nap = 1,8-Naphthyridin, X = Br, I) wird ein Übergang zwischen dem Molekülorbital der {Cu₂X₂}-Einheit (Cu d und Halogen p-Orbitale) und den π*-Orbitalen der nap-Gruppe diskutiert.^{[xxi]}

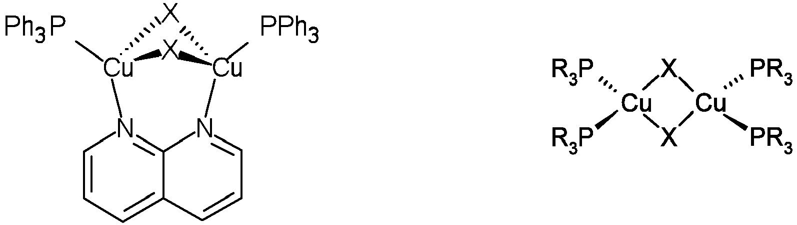

### Beispiel einer Struktur der Komplexe der Form Beispiele der Komplexe der Form Cu₂X₂L₄ (L = Cu₂X₂L₂L' (L = PPh₃, L' = 1,8-Naphthyridin, X PR₃, X = Cl, Br, oder I) = Br, I)

Triplett-Emitter weisen ein großes Potential zur Lichterzeugung in Displays (als Pixel) und in Beleuchtungsflächen (z. B. als Leuchttapete) auf. Sehr viele Triplett-Emitter-Materialien wurden bereits patentiert und werden mittlerweile auch technologisch in ersten Devices eingesetzt. Die bisherigen Lösungen weisen Nachteile und Probleme auf, und zwar in folgenden Bereichen:
- Langzeitstabilität der Emitter in den OLED-Devices,
- Thermische Stabilität,
- Chemische Stabilität gegenüber Wasser und Sauerstoff,
- Verfügbarkeit wichtiger Emissionsfarben,
- Fertigungstechnische Reproduzierbarkeit,
- Erreichbarkeit einer hohen Effizienz bei hohen Stromdichten,
- Erreichbarkeit sehr hoher Leuchtdichten,
- Hoher Preis der Emittermaterialien,
- Emittermaterialien sind toxisch und
- Synthesen sind aufwendig.

Vor diesem Hintergrund lag der vorliegenden Erfindung die Aufgabe zu Grunde, zumindest einige der oben genannten Nachteile zu überwinden.

### Beschreibung der Erfindung

Das der Erfindung zu Grunde liegende Problem wird durch die Bereitstellung von heteroleptischen zweikernigen Kupfer(I)komplexen der Form Cu₂X₂(E∩N*)L₂ gelöst, die eine Struktur gemäß Formel A aufweisen oder von einer Struktur nach Formel A sind:

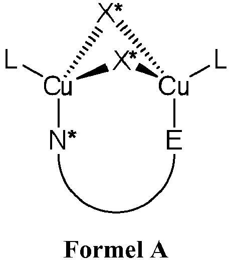

In Formel A (nachfolgend auch als Cu₂X₂(E∩N*)L₂ bezeichnet) steht E∩N* für einen chelatisierenden N-heterozyklischen Liganden, der über ein Stickstoffatom und entweder ein Phosphor-, Arsen- oder Antimonatom an den Cu₂X₂-Kern bindet, und L unabhängig voneinander für einen Phosphan-, Arsan- oder Antimon-Liganden, wobei beide Liganden L auch miteinander verbunden sein können, so dass sich ein zweibindiger Ligand ergibt, oder wobei ein Ligand L bzw. beide Liganden L auch mit E∩N* verbunden sein können, so dass sich ein dreibindiger oder vierbindiger Ligand ergibt. Mindestens ein L ist ungleich zu E∩N*.
Spezielle Ausführungsformen der erfindungsgemäßen zweikernigen Kupfer(I)komplexe der Formel A werden durch die Verbindung der Formeln I und II und III dargestellt und im Folgenden erläutert. 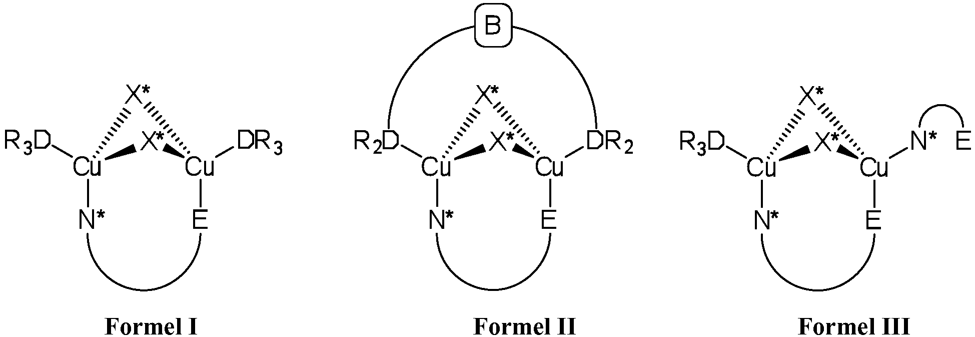 mit:
X* = Cl, Br, I, CN, OCN, SCN, Alkinyl und/oder N₃ (also unabhängig voneinander, so dass der Komplex zwei gleiche oder zwei unterschiedliche Atome X* aufweisen kann),
N*∩E = unabhängig voneinander zweibindige Liganden mit E = Phosphanyl/Arsenyl/Antimonyl-Rest der Form R₂E (R = Alkyl, Aryl, Heteroaryl, Alkoxyl, Phenoxyl, Amid); N* = Imin-Funktion. Bei "∩" handelt es sich um ein Kohlenstoffatom. Insbesondere handelt es sich bei E um eine Ph₂P-Gruppe (Ph = Phenyl), die Imin-Funktion ist Bestandteil einer aromatische Gruppe (z. B. Pyridyl, Pyridazinyl, Pyrimidyl, Pyrazinyl, Triazinyl, Tetrazinyl, Oxazolyl, Thiazolyl, Imidazolyl, Pyrazolyl, Isoxazolyl, Isothiazolyl, 1,2,3-Triazolyl, 1,2,4-Triazolyl, 1,2,4-Oxadiazolyl, 1,2,4-Thiadiazolyl, Tetrazolyl, 1,2,3,4-Oxatriazolyl, 1,2,3,4-Thiatriazolyl, Chinolyl, Isochinolyl, Chinoxalyl, Chinazolyl, etc.), die optional weiter substituiert und/oder anneliert ist. "∩" ist ebenfalls Bestandteil dieser aromatischen Gruppe. Das Kohlenstoffatom befindet sich sowohl direkt benachbart zum Imin-Stickstoff-Atom als auch zum E-Atom.
D = unabhängig voneinander P und/oder As und/oder Sb.

R = jeweils unabhängig voneinander Wasserstoff, Halogen oder Substituenten, die über Sauerstoff-(-OR), Stickstoff- (-NR₂) oder Siliziumatome (-SiR₃) gebunden sind sowie Alkyl- (auch verzweigt oder zyklisch), Heteroalkyl-, Aryl-, Heteroaryl-, Alkenyl-, Alkinyl-Crruppen bzw. substituierte Alkyl- (auch verzweigt oder zyklisch), Heteroalkyl-, Aryl-, Heteroaryl- und Alkenyl-Gruppen mit Substituenten wie Halogene oder Deuterium, Alkylgruppen (auch verzweigt oder zyklisch), Heteroalkyl-, Aryl-, Heteroaryl- und weitere allgemein bekannte Donor- und Akzeptor-Gruppen, wie beispielsweise Amine, Carboxylate und deren Ester, und CF₃-Gruppen. Die Reste R können optional auch zu annelierten Ringsystemen führen.
N*∩E und/oder L kann optional substituiert sein, insbesondere mit funktionellen Gruppen, die den Ladungsträgertransport verbessern und/oder Gruppen, die die Löslichkeit des Kupfer(I)komplexes in den gängigen organischen Lösungsmitteln zur OLED-Bauteilherstellung erhöhen. Gängige organische Lösungsmittel umfassen, neben Alkoholen, Ethern, Alkanen sowie halogenierten aliphatischen und aromatischen Kohlenwasserstoffen und alkylierten aromatischen Kohlenwasserstoffen, insbesondere Toluol, Chlorbenzol, Dichlorbenzol, Mesitylen, Xylol, Tetrahydrofuran, Phenetol, Propiophenon.

Ein erfindungsgemäßer Kupfer(I)komplex besteht bevorzugt aus einem zweibindigen Liganden N*∩E und entweder zwei identischen einzähnigen Liganden DR₃ oder zwei verschiedenen einzähnigen Liganden DR₃, wobei ein Ligand DR₃ gleich oder verschieden zu N*∩E sein kann, oder einem zweizähnigen Liganden R₂D-B-DR₂, wodurch unterschiedliche Funktionalitäten über die Peripherie der verschiedenen Liganden eingeführt werden können (beispielsweise je eine Lochtransport- und Elektrontransport-Einheit, im Folgenden als Loch- bzw. Elektronenleiter bezeichnet) und somit ein optimaler Ladungsträgertransport zu und eine wohldefinierte Rekombination direkt auf dem Kupferkomplex gewährleistet wird. Der große Vorteil bei der Verwendung von Kupfer als Zentralmetall ist dessen niedriger Preis, v. a. im Vergleich zu den sonst bei OLED-Emittern üblichen Metallen wie Re, Os, Ir und Pt. Zusätzlich spricht auch die geringe Toxizität des Kupfers für dessen Verwendung.

Hinsichtlich ihrer Verwendung in optoelektronischen Bauelementen zeichnen sich die erfindungsgemäßen Kupfer(I)komplexe durch einen weiten Bereich von erzielbaren Emissionsfarben aus. Zudem ist die Emissionsquantenausbeute hoch, insbesondere größer als 50 %. Für Emitterkomplexe mit Cu-Zentralion, sind die Emissionsabklingzeiten erstaunlich kurz.

Außerdem sind die erfindungsgemäßen Kupfer(I)komplexe in relativ hohen Emitterkonzentrationen ohne deutliche Quencheffekte verwendbar. Das heißt, im Emitter-Layer können Emitterkonzentrationen von 5 % bis 100 % verwendet werden.

Bevorzugt handelt es sich bei dem Liganden N*∩E um folgende Liganden: 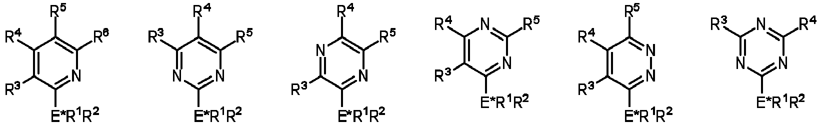 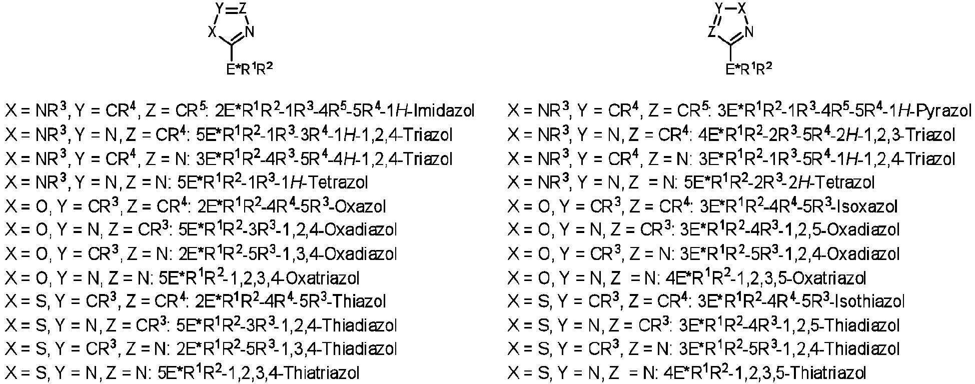 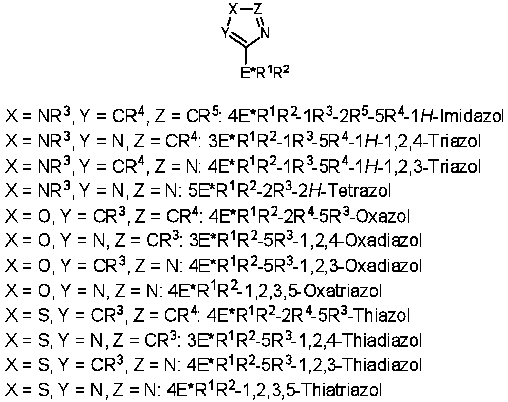 mit
E* = unabhängig voneinander P, As oder Sb,
X = unabhängig voneinander NR³, O oder S,
Y = unabhängig voneinander CR³, CR⁴ oder N,
Z = unabhängig voneinander CR⁴, CR⁵ oder N,
R¹-R⁶ können jeweils unabhängig voneinander Wasserstoff, Halogen sein oder Substituenten, die über Sauerstoff- (-OR), Stickstoff- (-NR₂) oder Siliziumatome (-SiR₃) gebunden sind sowie Alkyl-(auch verzweigt oder zyklisch), Heteroalkyl-, Aryl-, Heteroaryl-, Alkenyl-, Alkinyl-Crruppen bzw. substituierte Alkyl- (auch verzweigt oder zyklisch), Heteroalkyl-, Aryl-, Heteroaryl- und Alkenyl-Gruppen mit Substituenten wie Halogene oder Deuterium, Alkylgruppen (auch verzweigt oder zyklisch), Heteroalkyl-, Aryl-, Heteroaryl- und weitere allgemein bekannte Donor- und Akzeptor-Gruppen, wie beispielsweise Amine, Carboxylate und deren Ester, und CF₃-Gruppen. R³-R⁶ können optional auch zu annelierten Ringsystemen führen.

Bevorzugt handelt es sich bei dem Liganden DR₃ (s. Formel I) um folgende Liganden:
einzähnige Liganden mit
D = unabhängig voneinander P, As oder Sb,
R₃ können jeweils unabhängig voneinander Wasserstoff, Halogen sein oder Substituenten, die über Sauerstoff- (-OR), Stickstoff- (-NR₂) oder Siliziumatome (-SiR₃) gebunden sind sowie Alkyl- (auch verzweigt oder zyklisch), Heteroalkyl-, Aryl-, Heteroaryl-, Alkenyl-, Alkinyl-Crruppen bzw. substituierte Alkyl- (auch verzweigt oder zyklisch), Heteroalkyl-, Aryl-, Heteroaryl- und Alkenyl-Gruppen mit Substituenten wie Halogene oder Deuterium, Alkylgruppen (auch verzweigt oder zyklisch), Heteroalkyl-, Aryl-, Heteroaryl- und weitere allgemein bekannte Donor- und Akzeptor-Gruppen, wie beispielsweise Amine, Carboxylate und deren Ester, und CF₃-Gruppen. Die drei einzelnen Reste R können optional auch zu annelierten Ringsystemen führen.

Bevorzugt handelt es sich bei dem Liganden R₂D-B-DR₂ (s. Formel II) um folgende Liganden: zweizähnige Liganden mit
D = unabhängig voneinander P, As oder Sb,
R₂ können jeweils unabhängig voneinander Wasserstoff, Halogen sein oder Substituenten, die über Sauerstoff- (-OR), Stickstoff- (-NR₂) oder Siliziumatome (-SiR₃) gebunden sind sowie Alkyl- (auch verzweigt oder zyklisch), Heteroalkyl-, Aryl-, Heteroaryl-, Alkenyl-, Alkinyl-Crruppen bzw. substituierte Alkyl- (auch verzweigt oder zyklisch), Heteroalkyl-, Aryl-, Heteroaryl- und Alkenyl-Gruppen mit Substituenten wie Halogene oder Deuterium, Alkylgruppen (auch verzweigt oder zyklisch), Heteroalkyl-, Aryl-, Heteroaryl- und weitere allgemein bekannte Donor- und Akzeptor-Gruppen, wie beispielsweise Amine, Carboxylate und deren Ester, und CF₃-Gruppen, die über eine Brücke B mit einem weiteren Rest D verbunden ist und damit einen zweizähnigen Liganden bildet, wobei die Brücke B eine direkte Bindung oder eine substituierte oder unsubstituierte Alkylen-Alkenylen-, Alkinylen- oder Arylen-Crruppe oder eine Kombination beider, oder -O-, -NR- oder - SiR₂- ist, wobei jedes R unabhängig voneinander ausgewählt ist aus der Gruppe bestehend aus Wasserstoff, Halogen oder Substituenten, die über Sauerstoff- (-OR), Stickstoff- (-NR₂) oder Siliziumatome (-SiR₃) gebunden sind sowie Alkyl- (auch verzweigt oder zyklisch), Heteroalkyl-, Aryl-, Heteroaryl-, Alkenyl-, Alkinyl-Crruppen bzw. substituierte Alkyl- (auch verzweigt oder zyklisch), Heteroalkyl-, Aryl-, Heteroaryl- und Alkenyl-Gruppen mit Substituenten wie Halogene oder Deuterium, Alkylgruppen (auch verzweigt oder zyklisch), Heteroalkyl-, Aryl-, Heteroaryl- und weitere allgemein bekannte Donor- und Akzeptor-Gruppen, wie beispielsweise Amine, Carboxylate und deren Ester, und CF₃-Gruppen. Die zwei einzelnen Reste R können auch zu anellierten Ringsystemen führen.

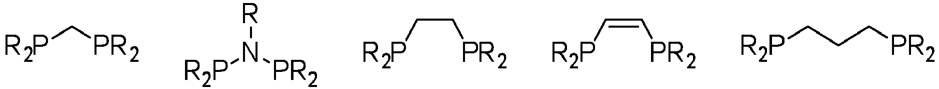

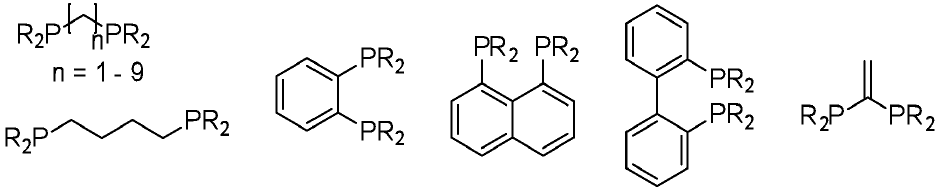

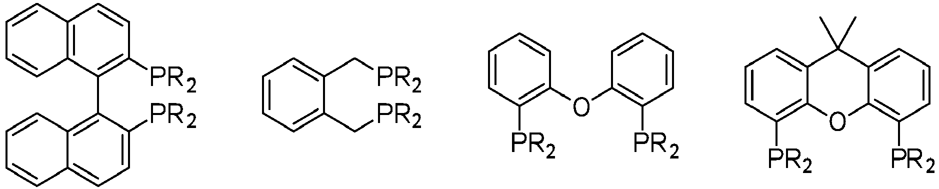

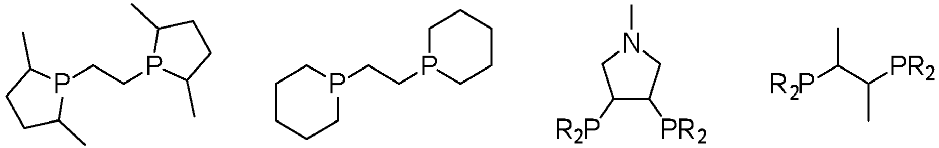

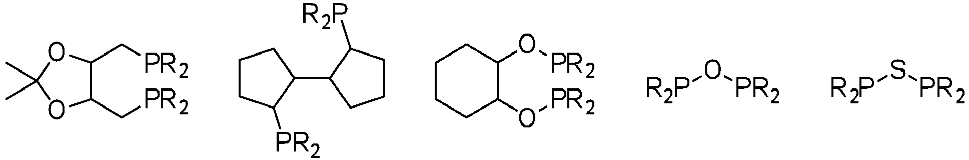

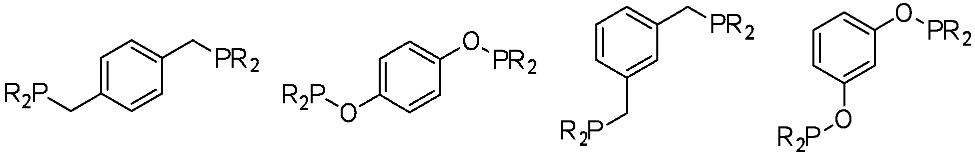

Sowohl der zweibindige Ligand N*∩E als auch die zwei einzähnigen Liganden DR₃ oder der zweizähnige Ligand R₂D-B-DR₂ können an geeigneten Stellen mit mindestens einer Funktions-Gruppe FG substituiert sein. So können sich direkte C_{FG}-C_{N*∩E} Bindungen bilden, wobei _{CN*∩E} ein C-Atom des N*∩E Liganden darstellt und C_{FG} ein C-Atom der Funktions-Gruppe. Ist das anbindende Atom ein Stickstoffatom, so ergeben sich N_{FG-}C_{N*∩E} Bindungen, wobei N_{FG} für das Stickstoffatom steht. Andererseits kann die Funktions-Gruppe über eine Brücke an den N*∩E Liganden angeknüpft werden, wobei sich z. B. Ether-, Thioether-, Ester-, Amid-, Methylen-, Silan-, Ethylen-, Ethin-Brücken anbieten. Damit können sich als Brücken beispielsweise folgende Funktionen ergeben: C_{FG}-O-C_{N*∩E}, C_{FG}-S-C_{N*∩E}, C_{FG}-C(O)-O-C_{N*∩E}, C_{FG}-C(O)-NH-C_{N*∩E}, C_{FG}-CH₂-C_{N}*_{∩E}, C_{FG}-SiR'₂-C_{N*∩E,} C_{FG}-CH=CH-C_{N*∩E}, C_{FG}-C≡C-C_{N*∩E},N_{FG}-CH₂-C_{N*∩E}.

Die Verfahren zur Verknüpfung der Funktionsgruppe an den N*∩E Ligand und/oder an den Ligand L, entweder direkt oder über eine Brücke, sind dem Fachmann bekannt (Suzuki-, Still-, Heck-, Sonogashira-, Kumada-, Ullmann-, Buchwald-Hartwig-Kupplung sowie deren Varianten; (Thio)Veretherung, Veresterung, nucleophile und elektrophile Substitutionen am sp³-Kohlenstoff oder Aromaten, usw.). Beispielsweise illustriert der in der Literatur beschriebene Ligand (4,4'-Bis(5-(hexylthio)-2,2'-bithien-5'-yl)-2,2'-bipyridine) die Möglichkeit einer Anbindung eines elektronenleitenden Substituenten an einen bpy Liganden mittels einer Stille Kupplung (C.-Y. Chen, M. Wang, J.-Y. Li, N. Pootrakulchote, L. Alibabaei, C.-h. Ngoc-le, J.-D. Decoppet, J.-H. Tsai, C. Grätzel, C.-G. Wu, S. M. Zakeeruddin, M. Grätzel, ACS Nano 2009, 3, 3103).

In einer besonderen Ausführungsform kann der Rest R auch ein elektronenleitender, lochleitender oder die Löslichkeit erhöhender Substituent sein.

Die Erfindung betrifft auch ein Verfahren zur Herstellung eines erfindungsgemäßen Kupfer(I)komplexes. Dieses erfindungsgemäße Verfahren weist den Schritt des Durchführens einer Reaktion von N*∩E und L mit Cu(I)X auf,
wobei
X* = Cl, Br, I, CN, OCN, SCN, Alkinyl und/oder N₃ (unabhängig voneinander),
N*∩E = ein zweibindiger Ligand mit
E = Phosphanyl/Arsenyl/Antimonyl-Rest der Form R₂E (mit R = Alkyl, Aryl, Heteroaryl, Alkoxyl, Phenoxyl, oder Amid);
N* = Imin-Funktion, die Bestandteil einer aromatische Gruppe ist, die ausgewählt ist aus Pyridyl, Pyridazinyl, Pyrimidyl, Pyrazinyl, Triazinyl, Tetrazinyl, Oxazolyl, Thiazolyl, Imidazolyl, Pyrazolyl, Isoxazolyl, Isothiazolyl, 1,2,3-Triazolyl, 1,2,4-Triazolyl, 1,2,4-Oxadiazolyl, 1,2,4-Thiadiazolyl, Tetrazolyl, 1,2,3,4-Oxatriazolyl, 1,2,3,4-Thiatriazolyl, Chinolyl, Isochinolyl, Chinoxalyl, Chinazolyl, etc., die optional weiter substituiert und/oder anneliert sind, "∩" = mindestens ein Kohlenstoffatom, das ebenfalls Bestandteil der aromatischen Gruppe ist, wobei sich das Kohlenstoffatom sowohl direkt benachbart zum Imin-Stickstoffatom als auch zum Phosphor-, Arsen- oder Antimonatom befindet,
und L ausgestaltet sein:
entweder als zwei einzähnige Liganden DR₃ mit
   D = Phosphanyl/Arsenyl/Antimonyl-Rest der Form R₃D, wobei die drei Reste R jeweils unabhängig voneinander Wasserstoff, Halogen oder Substituenten sind, die über Sauerstoff- (-OR), Stickstoff- (-NR₂) oder Siliziumatome (-SiR₃) gebunden sind sowie Alkyl- (auch verzweigt oder zyklisch), Heteroalkyl-, Aryl-, Heteroaryl-, Alkenyl-, Alkinyl-Crruppen oder substituierte Alkyl-(auch verzweigt oder zyklisch), Heteroalkyl-, Aryl-, Heteroaryl- und Alkenyl-Gruppen mit Substituenten wie Halogene oder Deuterium, Alkylgruppen (auch verzweigt oder zyklisch), Heteroalkyl-, Aryl-, Heteroaryl- und weitere Donor- und Akzeptor-Gruppen, wie beispielsweise Amine, Carboxylate und deren Ester, und CF₃-Gruppen; die drei einzelnen Reste R führen optional zu annelierten Ringsystemen;
oder als ein zweizähniger Ligand R₂D-B-DR₂ mit
   D = Phosphanyl/Arsenyl/Antimonyl-Rest der Form R₂D, die über eine Brücke B mit einem weiteren Rest D verbunden ist, wobei die Brücke B eine direkte Bindung oder eine substituierte oder unsubstituierte Alkylen-, Alkenylen-, Alkinylen- oder Arylen-Gruppe oder eine Kombination beider, oder -O-, -NR- oder -SiR₂- ist, wobei die Reste R jeweils unabhängig voneinander Wasserstoff, Halogen oder Substituenten sind, die über Sauerstoff- (-OR), Stickstoff- (-NR₂) oder Siliziumatome (-SiR₃) gebunden sind sowie Alkyl- (auch verzweigt oder zyklisch), Heteroalkyl-, Aryl-, Heteroaryl-, Alkenyl-, Alkinyl-Gruppen oder substituierte Alkyl- (auch verzweigt oder zyklisch), Heteroalkyl-, Aryl-, Heteroaryl- und Alkenyl-Gruppen mit Substituenten wie Halogene oder Deuterium, Alkylgruppen (auch verzweigt oder zyklisch), Heteroalkyl-, Aryl-, Heteroaryl- und weitere Donor- und Akzeptor-Gruppen, wie beispielsweise Amine, Carboxylate und deren Ester, und CF₃-Gruppen; die zwei einzelnen Reste R führen optional zu annelierten Ringsystemen;
oder als zwei verschiedene einzähnige Liganden DR₃, wobei ein Ligand DR₃ gleich oder verschieden zu N*∩E sein kann mit
   D = Phosphanyl/Arsenyl/Antimonyl-Rest der Form R₃D (mit R = Alkyl, Aryl, Heteroaryl, Alkoxyl, Phenoxyl, oder Amid), und
   N*∩E = ein zweibindiger Ligand mit
      E = Phosphanyl/Arsenyl/Antimonyl-Rest der Form R₂E (mit R = Alkyl, Aryl, Heteroaryl, Alkoxyl, Phenoxyl, oder Amid);
      N* = Imin-Funktion, die Bestandteil einer aromatische Gruppe ist, die ausgewählt ist aus Pyridyl, Pyridazinyl, Pyrimidyl, Pyrazinyl, Triazinyl, Tetrazinyl, Oxazolyl, Thiazolyl, Imidazolyl, Pyrazolyl, Isoxazolyl, Isothiazolyl, 1,2,3-Triazolyl, 1,2,4-Triazolyl, 1,2,4-Oxadiazolyl, 1,2,4-Thiadiazolyl, Tetrazolyl, 1,2,3,4-Oxatriazolyl, 1,2,3,4-Thiatriazolyl, Chinolyl, Isochinolyl, Chinoxalyl, Chinazolyl, etc., die optional weiter substituiert und/oder anneliert sind,
      "∩" = mindestens ein Kohlenstoffatom, das ebenfalls Bestandteil der aromatischen Gruppe ist, wobei sich das Kohlenstoffatom sowohl direkt benachbart zum Imin-Stickstoffatom als auch zum Phosphor-, Arsen- oder Antimonatom befindet.

Der optional am Liganden N*∩E und/oder L vorhandene mindestens eine Substituent zur Erhöhung der Löslichkeit des Komplexes in organischen Lösungsmitteln und/oder zur Verbesserung des Ladungsträgertransports ist weiter unten beschrieben.

Die Reaktion wird bevorzugter Weise in Dichlormethan (DCM) durchgeführt, wobei auch andere organische Lösungsmittel wie Acetonitril oder Tetrahydrofuran oder Dimethylsulfoxid oder Ethanol verwendet werden können. Durch die Zugabe von Diethylether oder Hexan oder Methyl-tert-butylether oder Pentan oder Methanol oder Ethanol oder Wasser zum gelösten Produkt kann ein Feststoff gewonnen werden. Letzteres kann durch Fällung oder Eindiffusion oder in einem Ultraschall-Bad durchgeführt werden.

Bei der Reaktion von zweizähnigen P∩N*-Liganden (P∩N* = Phosphan-Ligand, Definition s. u.) und L mit Cu(I)X (X = Cl, Br, I), bevorzugt in Dichlormethan (DCM), bevorzugt bei Raumtemperatur, entsteht- überraschend der zweikernige 2:3-Komplex Cu₂X₂(E∩N*)L₂, in dem die Cu-Atome durch einen Phosphanligand sowie die beiden Halogenid-Anionen überbrückt werden (Gl. 1).

Die Struktur der Formel A ist verwandt mit bekannten Komplexen der Form Cu₂X₂L₂L' bzw. Cu₂X₂L₄. Anders als bei Cu₂X₂L₂L' ist der Komplex jedoch in nur einem Schritt durch Umsetzung von Cu(I)X mit dem zweizähnigen P∩N* Liganden und entweder zwei einzähnigen Liganden DR₃ oder einem zweizähnigen Liganden R₂D-B-DR₂ oder einem einzähnigen Liganden DR₃ und einem einzähnigen Liganden P∩N*, der gleich oder verschieden zu dem zweizähnigen Liganden P∩N* sein kann zugänglich. Der Komplex kann durch Fällen mit Et₂O als gelbes oder rotes mikrokristallines Pulver isoliert werden. Einkristalle können durch langsames Eindiffundieren von Et₂O in die Reaktionslösung erhalten werden. Sobald die Komplexe als Pulver oder Kristalle vorliegen, sind sie in gängigen organischen Lösungsmitteln teilweise schwer löslich bis unlöslich. Insbesondere bei niedrigen Löslichkeiten wurden Komplexe nur durch Elementar- und Röntgenstrukturanalysen identifiziert.

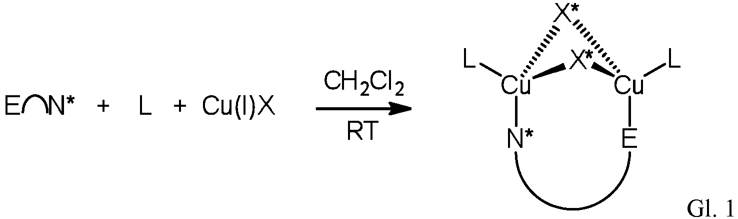

Hierbei handelt es sich um die oben aufgeführte allgemeine Formel A. Die zweizähnigen E∩N*-Liganden und/oder entweder die zwei einzähnigen Liganden DR₃ oder der zweizähnige Ligand R₂D-B-DR₂ oder der einzähnige Ligand DR₃ und der einzähnige Ligand P∩N*, der gleich oder verschieden zu dem zweizähnigen Liganden P∩N* sein kann könne n unabhängig voneinander mindestens einen Substituenten umfassen: Die Substituenten können jeweils unabhängig voneinander Wasserstoff, Halogen sein oder Substituenten, die über Sauerstoff- (-OR), Stickstoff-(-NR₂) oder Siliziumatome (-SiR₃) gebunden sind sowie Alkyl- (auch verzweigt oder zyklisch), Heteroalkyl-, Aryl-, Heteroaryl-, Alkenyl-, Alkinyl-Crruppen bzw. substituierte Alkyl- (auch verzweigt oder zyklisch), Heteroalkyl-, Aryl-, Heteroaryl- und Alkenyl-Gruppen mit Substituenten wie Halogene oder Deuterium, Alkylgruppen (auch verzweigt oder zyklisch), Heteroalkyl-, Aryl-, Heteroaryl- und weitere allgemein bekannte Donor- und Akzeptor-Gruppen, wie beispielsweise Amine, Carboxylate und deren Ester, und CF₃-Gruppen. Die Substituenten können auch zu anellierten Ringsystemen führen.

### Substituenten zur Einführung unterschiedlicher Funktionalitäten

Die oben genannten Substituenten zur Einführung unterschiedlicher Funktionalitäten über die verschiedenen Liganden (beispielsweise Loch- und/oder Elektronenleiter) zur Gewährleistung eines guten Ladungsträgertransports und einer wohldefinierten Rekombination direkt auf dem Kupferkomplex, können entweder einfach oder mehrfach am E∩N*- und /oder L-Liganden gebunden sein. Es können identische oder unterschiedliche Funktions-Gruppen verwendet werden. Die Funktions-Gruppen können symmetrisch oder unsymmetrisch vorhanden sein.

### Elektronenleiter

Da es sich bei den Elektronenleiter-Materialien ausschließlich um aromatische Verbindungen handelt, ist eine Substitution mithilfe einer der gängigen Kupplungsreaktionen möglich. Als Kupplungsreaktionen kommen z. B. die Suzuki-, Still-, Heck-, Sonogashira-, Kumada-, Ullmann-, Buchwald-Hartwig-Kupplung sowie deren Varianten zu Einsatz.

Dabei geht man von einem mit Halogenid (Cl, Br, I), insbesondere Br, substituierten E∩N*- und /oder L-Liganden aus und setzt diesen mit dem entsprechenden, mit einer geeigneten Abgangsgruppe substituierten Elektronenleiter-Material um. Vorteilhaft ist die Durchführung einer Suzuki-Kupplung unter Verwendung der entsprechenden Arylboronsäuren und -estern, sowie die Buchwald-Hartwig-Kupplung für die Knüpfung von Aryl-N-Bindungen. Abhängig von den Funktions-Gruppen können auch weitere, gängige Verknüpfungsreaktionen angewandt werden, z. B. über eine Brücke zwischen Funktions-Crruppe FG und E∩N*- und/oder L-Ligand. Bei Anwesenheit von -OH Gruppen kommen hier z. B. Veresterungen und Etherbildung in Frage, bei - NH₂ Gruppen Imin- und Amidbildung, bei -COOH Gruppen Esterbildung. Entsprechend muss das Subsitutionsmuster des E∩N*- und/oder L-Ligand angepasst werden. Die entsprechenden Verfahren zur Anbringung der Funktions-Gruppen FG sind dem Fachmann bekannt.

Als Elektronentransport-Substituenten können beispielsweise folgende Gruppen verwendet werden (Verknüpfung findet an der mit # gekennzeichneten Stelle statt):

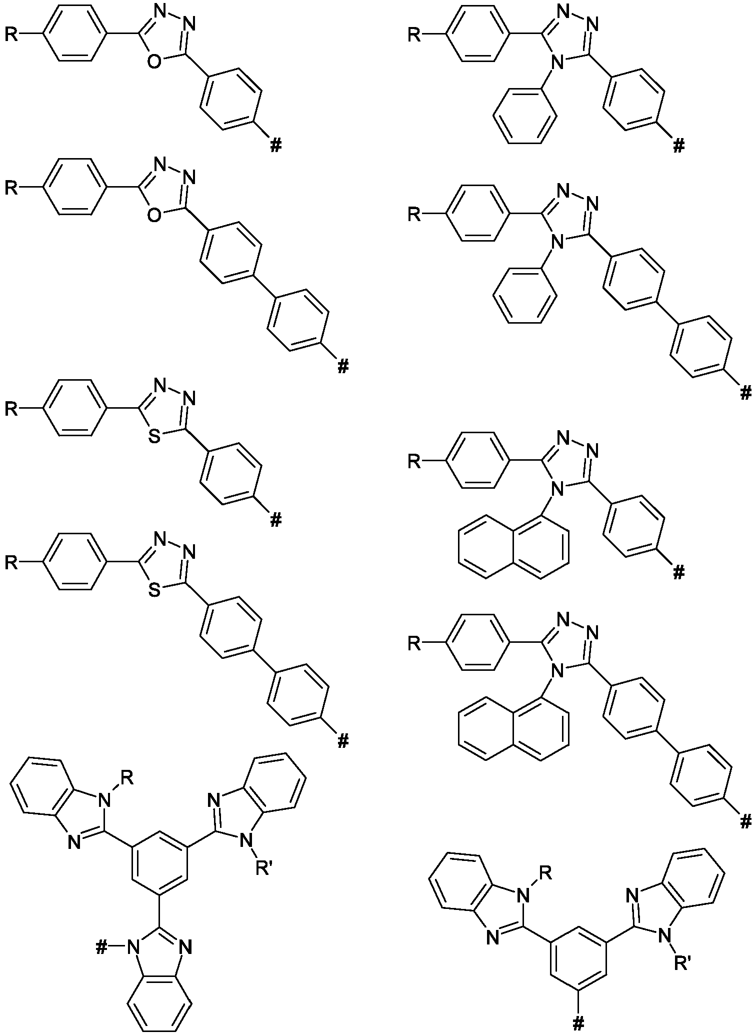

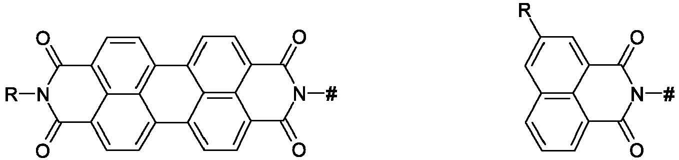

Bei den Substituenten R und R' handelt es sich um einen Alkyl-Rest [CH₃-(CH₂)ₙ-](n = 0 - 20), der auch verzweigt oder mit Halogenen (F, Cl, Br, I) substituiert sein kann, oder um einen Aryl-Rest (insbesondere Phenyl), der mit Alkyl-Gruppen, Halogenen (F, Cl, Br, I), Silan- (-SiR'"₃) oder Ethergruppen -OR'" (R'" definiert wie R; die hier verwendeten Substituenten entsprechen nicht notwendiger Weise den Substituenten R, R', R" der Formel I oder II) substituiert sein kann. Ebenso kann es sich bei R um ungesättigte Gruppen wie Alkenyl- und Alkinyl-Crruppen handeln, die wiederum mit Alkyl-Gruppen, Halogenen (F, Cl, Br, I), Silan- (-SiR"₃) oder Ethergruppen -OR" (R" definiert wie R) substituiert sein können.

### Lochleiter

Für den Lochleiter gelten analog die gleichen Aussagen wie für die Elektronenleiter. Auch hier wird die Verknüpfung des Lochleiters an den E∩N*- und/oder L-Liganden am einfachsten durch Palladium-katalysierte Kupplungsreaktionen verwirklicht; weitere Verknüpfungen, auch über eine Brücke, sind ebenfalls möglich.

Als Lochtransport-Substituenten können beispielsweise folgende Gruppen verwendet werden (Verknüpfung findet an der mit # gekennzeichneten Stelle statt):

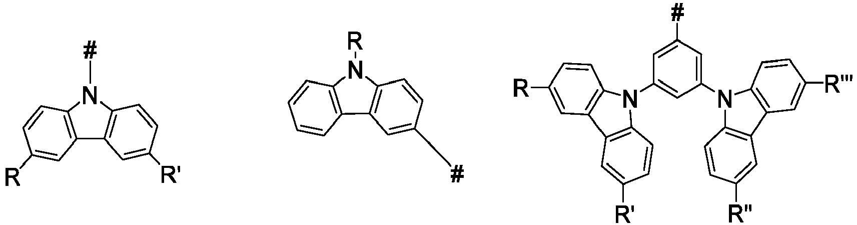

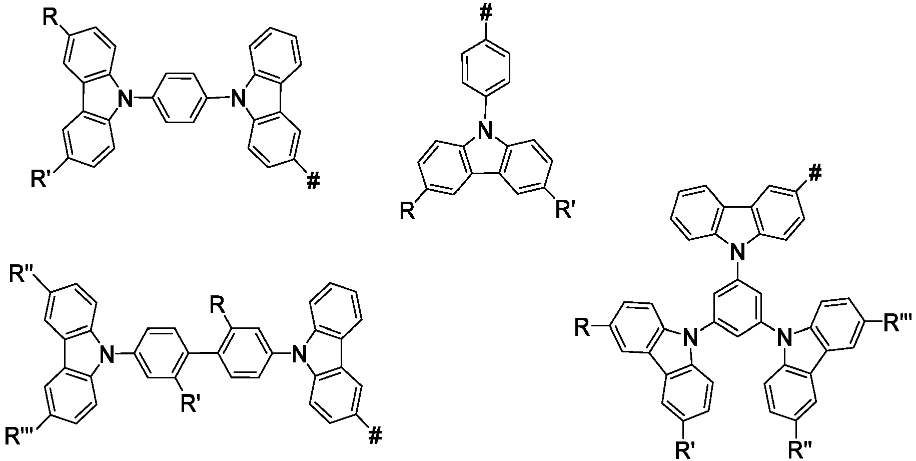

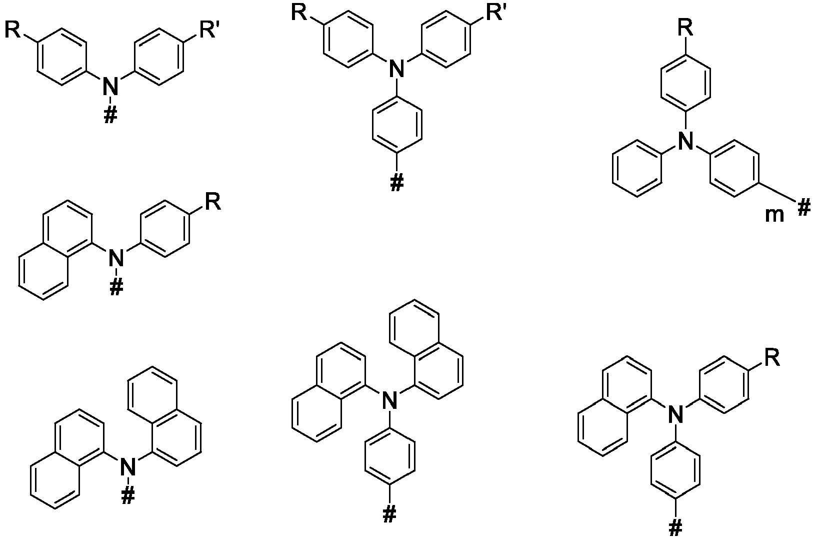

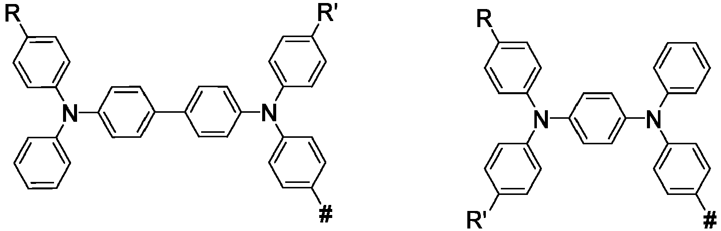

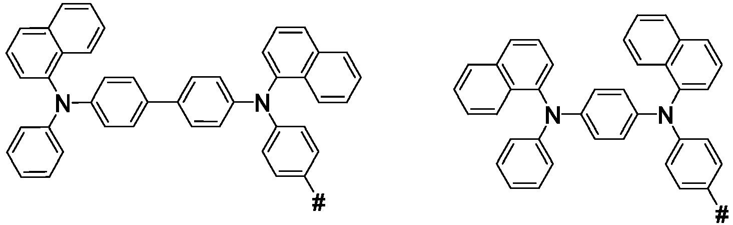

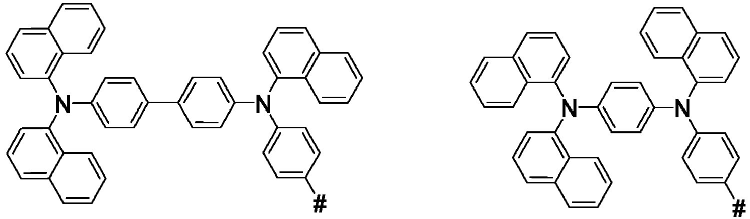

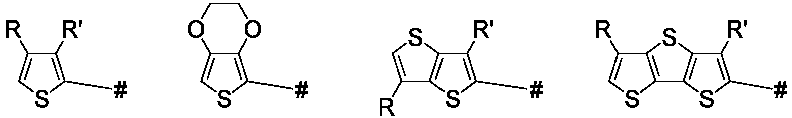

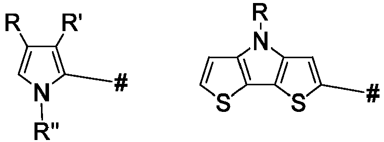

Bei den oben gezeigten Substituenten R, R" und R"' handelt es sich um einen Alkyl-Rest [CH₃-(CH₂)ₙ (n = 0 - 20), der auch verzweigt oder mit Halogenen (F, Cl, Br, I) substituiert sein kann, oder um einen Aryl-Rest (insbesondere Phenyl), der mit Alkyl-Gruppen, Halogenen (F, Cl, Br, I), Silan- (-SiR""₃) oder Ethergruppen -OR"" (R"" definiert wie R; die oben für die Lochtransport-Substituenten verwendeten Substituenten entsprechen nicht notwendiger Weise den Substituenten R, R', R" der Formel I oder II) substituiert sein kann. Ebenso kann es sich bei R um ungesättigte Gruppen wie Alkenyl- und Alkinyl-Crruppen handeln, die wiederum mit Alkyl-Gruppen, Halogenen (F, Cl, Br, I), Silan- (-SiR"₃) oder Ethergruppen -OR" (R" definiert wie R) substituiert sein können.

Zur Verwendung der Kupfer(I)-Komplexe als selbstkatalysierende Emittermaterialien zur Erzielung einer Quervernetzung mit einem zweiten Reaktanden können solche Funktionalitäten in der Peripherie des E∩N*- und/oder L-Liganden angebracht werden, die mit der entsprechend komplementären funktionellen Einheit des zweiten Reaktanden eine durch den Kupfer(I)-Komplex katalysierte Quervernetzung und somit Immobilisierung ermöglichen. Zusätzlich sorgt diese Quervernetzung für eine Stabilisierung und Fixierung der geometrischen Struktur der Metallkomplexe, wodurch eine Bewegung der Liganden und somit eine Strukturänderung der angeregten Moleküle verhindert und eine Effizienzminderung durch strahlungslose Relaxationspfade wirkungsvoll unterbunden wird.
Beispielhaft für eine selbstkatalysierte Quervernetzungsreaktion ist die Kupfer-katalysierte Click-Reaktion zwischen einem terminalen oder aktivierten Alkin als erster Click-Gruppe und einem Azid als zweiter Click-Gruppe. Da der Metallkomplex-Emitter mindestens zwei Alkin-Einheiten tragen muss, sind mindestens zwei der Strukturen N*∩E und/oder L in bevorzugter Weise mit mindestens je einer der oben genannten funktionellen Gruppe zur Erzielung einer Quervernetzung substituiert, während die für die Quervernetzung nicht aktive Struktur N*∩E und/oder L optional mit einer anderen der oben genannten funktionellen Gruppe zur Erhöhung der Löslichkeit des Komplexes in organischen Lösungsmitteln und/oder zur Verbesserung des Ladungsträgertransports substituiert sein kann.
Somit können unterschiedliche Funktionalitäten über die Peripherie der verschiedenen Liganden eingeführt werden (beispielsweise je eine Lochtransport- und Elektrontransport-Einheit zur Erzielung eines optimalen Ladungsträgertransports zu und eine wohldefinierte Rekombination direkt auf dem Kupferkomplex und/oder ein Substituent zur Erhöhung der Löslichkeit des Komplexes in organischen Lösungsmitteln und/oder eine funktionelle Gruppe zur Erzielung einer Quervernetzung), wodurch eine sehr flexible Anpassung und Modifizierung der Kupfer(I)-Komplexe möglich ist.

### Löslichkeit

Bei der Herstellung von opto-elektronischen Bauteilen mittels nass-chemischer Prozesse ist es vorteilhaft, die Löslichkeit gezielt einzustellen. Hierdurch kann das Auf- bzw. Anlösen einer bereits aufgebrachten Schicht vermieden werden. Durch das Einbringen spezieller Substituenten können die Löslichkeitseigenschaften stark beeinflusst werden. Dadurch ist es möglich, orthogonale Lösungsmittel zu verwenden, die jeweils nur die Substanzen des aktuellen Verarbeitungsschrittes lösen, aber nicht die Substanzen der darunter liegenden Schicht(en). Zu diesem Zweck können die Substituenten R¹-R⁶ so gewählt werden, dass sie eine Abstimmung der Löslichkeiten erlauben. Folgende Möglichkeiten zur Auswahl entsprechender Substituenten sind gegeben:

### Löslichkeit in unpolaren Medien

Unpolare Substitutenten R¹-R⁶ erhöhen die Löslichkeit in unpolaren Lösungsmitteln und erniedrigen die Löslichkeit in polaren Lösungsmitteln. Unpolare Gruppen sind z. B. Alkylgruppen [CH₃-(CH₂)ₙ-] (n = 1 - 30), auch verzweigte oder zyklische, substituierte Alkylgruppen, z. B. mit Halogenen. Hierbei sind besonders hervorzuheben: teil- oder perfluorierte Alkylgruppen sowie perfluorierte Oligo- und Polyether, z. B. [-(CF₂)₂-O]ₙ - und (-CF₂-O)ₙ (n = 2 - 500). Weitere unpolare Gruppen sind: Ether -OR*, Thioether -SR*, unterschiedlich substituierte Silane R*₃Si-(R* = Alkyl oder Aryl), Siloxane R*₃Si-O-, Oligosiloxane R**(-R₂Si-O)ₙ-(R** = R*, n = 2 - 20), Polysiloxane R**(-R*₂Si-O)ₙ-(n > 20); Oligo/polyphosphazene R**(-R*₂P=N-)ₙ-(n = 1 - 200).

### Löslichkeit in polaren Medien

Polare Substitutenten R¹-R⁶ erhöhen die Löslichkeit in polaren Lösungsmitteln. Diese können sein:
- Alkohol-Crruppen: -OH
- Carbonsäure-, Phosphonsäure-, Sulfonsäure-Reste sowie deren Salze und Ester (R* = H, Alkyl, Aryl, Halogen; Kationen: Alkalimetalle, Ammonium-Salze):
   -COOH, -P(O)(OH)₂ , -P(S)(OH)₂, -S(O)(OH)₂, -COOR*, -P(O)(OR*)₂ , -P(S)(OR*)₂,-S(O)(OR*)₂, -CONHR*, -P(O)(NR*₂)₂, -P(S)(NR*₂)₂, -S(O)(NR*₂)₂
- Sulfoxide: -S(O)R*, -S(O)₂R*
- Carbonylgruppen: -C(O)R*
- Amine: -NH₂, -NR*₂, -N(CH₂CH₂OH)₂,
- Hydroxylamine =NOR*
- Oligoester, -O(CH₂O-)ₙ, -O(CH₂CH₂O-)ₙ(n = 2 - 200)
- Positiv geladene Substituenten: z. B. Ammonium-Salze -N⁺R*₃X⁻ , Phosphonium-Salze - P⁺R*3X⁻
- Negativ geladene Substituenten, z. B. Borate -(BR*₃)⁻, Aluminate -(AlR*₃)⁻ (als Anion kann ein Alkalimetal oder Ammoniumion fungieren).

Optional kann das Darstellungsverfahren den Schritt umfassen, dass mindestens ein Ligand N*∩E und/oder L mit mindestens einem der oben genannten Substituenten zur Erhöhung der Löslichkeit in einem organischen Lösungsmittel substituiert wird, wobei der Substituent in einer Ausführungsform der Erfindung ausgewählt sein kann aus der Gruppe bestehend aus:
- langkettigen, verzweigten oder unverzweigten oder zyklischen Alkylketten einer Länge von C1 bis C30,
- langkettigen, verzweigten oder unverzweigten oder zyklischen Alkoxyketten einer Länge von C1 bis C30,
- verzweigten oder unverzweigten oder zyklischen Perfluoralkylketten einer Länge von C1 bis C30, und
- kurzkettigen Polyethern.

Optional kann das Darstellungsverfahren den Schritt umfassen, dass mindestens ein Ligand N*∩E und/oder L mit mindestens einer der o. g. funktionellen Gruppe zur Verbesserung des Ladungsträgertransports und zur Erhöhung der Rekombinationswahrscheinlichkeit der Ladungsträger direkt auf den erfindungsgemäßen Kupfer(I)komplexen substituiert wird, wobei die funktionelle Gruppe am Ligand N*∩E gleich oder verschieden sein kann von der funktionellen Gruppe am Ligand L, bevorzugt verschieden, wobei der Substituent in einer Ausführungsform der Erfindung ausgewählt sein kann aus der Gruppe bestehend aus Elektronenleiter und Lochleiter.

Erfindungsgemäß sind auch Kupfer(I)komplexe, die durch ein derartiges Syntheseverfahren herstellbar sind.

Die Kupfer(I)komplexe der Formel A können erfindungsgemäß als Emitter-Materialien in einer Emitterschicht eines Licht-emittierenden optoelektronischen Bauelements eingesetzt werden.

Die Kupfer(I)komplexe der Formel A können erfindungsgemäß auch als Absorber-Materialien in einer Absorberschicht eines optoelektronischen Bauelements eingesetzt werden.

Unter der Bezeichnung "optoelektronische Bauelemente" werden insbesondere verstanden:
- Organische Licht-emittierende Bauteile (organic light emitting diodes, OLEDs)
- Licht-emittierende elektrochemische Zellen (light emitting electrochemical cells, LECs, LEECs),
- OLED-Sensoren, insbesondere in nicht hermetisch nach außen abgeschirmten Gas- und Dampf-Sensoren,
- organische Solarzellen (organic solar cells, OSCs, organic photovoltaics, OPVs),
- Organische Feldeffekttransistoren und
- Organische Laser.

Der Anteil des Kupfer(I)komplexes in der Emitter- oder Absorber-Schicht in einem derartigen optoelektronischen Bauelement beträgt in einer Ausführungsform der Erfindung 100 %. In einer alternativen Ausführungsform beträgt der Anteil des Kupfer(I)komplexes in der Emitter- oder Absorber-Schicht 1 % bis 99 %.

Vorteilhafter Weise beträgt die Konzentration des Kupfer(I)komplexes als Emitter in optischen Licht emittierenden Bauelementen, insbesondere in OLEDs, zwischen 5 % und 80 %.

Gegenstand der vorliegenden Erfindung sind auch optoelektronische Bauelemente, die einen hier beschriebenen Kupfer(I)komplex aufweisen. Dabei kann das optoelektronische Bauelement ausgeformt sein als ein organisch lichtemittierendes Bauelement, eine organische Diode, eine organische Solarzelle, ein organischer Transistor, als eine organische Licht-emittierende Diode, eine Licht-emittierende elektrochemische Zelle, ein organischer Feldeffekttransistor und als ein organischer Laser.

Weiterhin betrifft die vorliegende Erfindung ein Verfahren zur Herstellung eines optoelektronischen Bauelements, wobei ein erfindungsgemäßer Kupfer(I)komplex der hier beschriebenen Art verwendet wird. Bei diesem Verfahren wird insbesondere ein erfindungsgemäßer Kupfer(I)komplex auf einen Träger aufgebracht. Dieses Aufbringen kann nass-chemisch, mittels kolloidaler Suspension oder mittels Sublimation erfolgen, insbesondere nass-chemisch. Das Verfahren kann die folgenden Schritte aufweisen:
Aufbringung eines in einem ersten Lösungsmittel gelösten ersten Emitterkomplexes auf einen Träger, und Aufbringung eines in einem zweiten Lösungsmittel gelösten zweiten Emitterkomplexes auf den Träger;
wobei der erste Emitterkomplexes nicht in dem zweiten Lösungsmittel löslich ist und der zweite Emitterkomplexes nicht in dem ersten Lösungsmittel löslich ist; und wobei der erste Emitterkomplex und/oder der zweite Emitterkomplex ein erfindungsgemäßer Kupfer(I)komplex ist. Das Verfahren kann weiterhin den folgenden Schritt aufweisen: Aufbringung eines in dem ersten Lösungsmittel oder in einem dritten Lösungsmittel gelösten dritten Emitterkomplexes auf den Träger, wobei der dritte Kupfer(I)komplex ein erfindungsgemäßer Kupfer(I)komplex ist. Erstes und zweites Lösungsmittel sind dabei nicht identisch.

Die vorliegende Erfindung betrifft auch ein Verfahren zur Veränderung der Emissions- und/oder Absorptionseigenschaften eines elektronischen Bauelements. Dabei wird ein erfindungsgemäßer Kupfer(I)komplex in ein Matrixmaterial zur Leitung von Elektronen oder Löchern in ein optoelektronisches Bauelement eingebracht.

Die vorliegende Erfindung betrifft auch die Verwendung eines erfindungsgemäßen Kupfer(I)komplexes, insbesondere in einem optoelektronischen Bauelement, zur Umwandlung von UV-Strahlung oder von blauem Licht in sichtbares Licht, insbesondere in grünes (490-575 nm), gelbes (575-585 nm), oranges (585-650 nm) oder rotes Licht (650-750 nm) (Down-Konversion).

In einer bevorzugten Ausführungsform ist die optoelektronische Vorrichtung eine Weißlicht-OLED, wobei der erste Emitterkomplex ein Rotlichtemitter ist, der zweite Emitterkomplex ein Grünlichtemitter ist und der dritte Emitterkomplex ein Blaulichtemitter ist. Der erste, zweite und/oder dritte Emitterkomplex ist bevorzugt ein erfindungsgemäßer Kupfer(I)komplex.

Da die erfindungsgemäßen Kupfer(I)komplexe mit unsubstituierten Liganden N*∩E in einigen organischen Lösungsmitteln z. T. schwer löslich sind, können sie ggf. nicht direkt aus Lösung verarbeitet werden. Bei Lösungsmitteln, die ihrerseits gute Liganden darstellen (Acetonitril, Pyridin) ist zwar eine gewisse Löslichkeit gegeben, jedoch kann eine Änderung der Struktur der Komplexe oder eine Verdrängung der Phosphan-, Arsan- oder Antimon-Liganden unter diesen Bedingungen nicht ausgeschlossen werden. Daher ist nicht klar, ob die Substanzen bei einer Abscheidung auf dem Substrat als Cu₂X₂(E∩N*)(L)₂ kristallisieren bzw. ob sie in der Matrix in dieser Form molekular vorliegen werden. Aus diesem Grund sollten die Substanzen in einer für die Anwendung in optoelektronischen Bautelementen geeigneten Größe hergestellt bzw. auf diese zerkleinert werden (< 20 nm bis 30 nm, Nanopartikel) oder mittels geeigneter Substituenten löslich gemacht werden.

Die erfindungsgemäßen Kupfer(I)komplexe werden bevorzugt aus Lösung prozessiert, da das hohe Molekulargewicht eine Abscheidung aus dem Vakuum durch Sublimation erschwert. Somit erfolgt die Herstellung der photoaktiven Schichten bevorzugt aus Lösung durch Spincoating oder Schlitzgießverfahren oder mit einem beliebigen Druckverfahren wie Siebdruck, Flexodruck, Offsetdruck oder Ink-Jet-Druck.

Die hier beschriebenen unsubstituierten Kupfer(I)komplexe (Definition weiter unten, siehe Beispiele) sind jedoch in den gängigen organischen Lösungsmitteln, außer in Dichlormethan, welches zur OLED-Bauteilherstellung in einer Glovebox nicht verwendet werden sollte, schwer löslich. Das Aufbringen als kolloidale Suspension ist in vielen Fällen sinnvoll (siehe weiter unten), allerdings ist eine technische Verarbeitung der Emittermaterialien in gelöster Form meist technisch einfacher. Daher ist ein weiteres Ziel dieser Erfindung, die Emitter chemisch so zu verändern, dass diese löslich sind. Geeignete Lösungsmittel für die OLED-Bauteilherstellung sind neben Alkoholen, Ethern, Alkanen sowie halogenierten aromatischen und aliphatischen Kohlenwasserstoffen und alkylierten aromatischen Kohlenwasserstoffen, insbesondere Toluol, Chlorbenzol, Dichlorbenzol, Mesitylen, Xylol, Tetrahydrofuran, Phenetol, Propiophenon.

Um die Löslichkeit der erfindungsgemäßen Kupfer(I)komplexe in organischen Lösungsmitteln zu verbessern, ist mindestens eine der Strukturen N*∩E und/oder L in bevorzugter Weise mit mindestens einem der oben genannten Substituenten substituiert. Der Substituent kann ausgewählt sein aus der Gruppe bestehend aus:
- langkettigen, verzweigten oder unverzweigten oder zyklischen Alkylketten mit einer Länge von C1 bis C30, bevorzugt mit einer Länge von C3 bis C20, besonders bevorzugt mit einer Länge von C5 bis C15,
- langkettigen, verzweigten oder unverzweigten oder zyklischen, Alkoxyketten einer Länge von C1 bis C30, bevorzugt mit einer Länge von C3 bis C20, besonders bevorzugt mit einer Länge von C5 bis C15,
- verzweigten oder unverzweigten oder zyklischen Perfluoralkylketten einer Länge von C1 bis C30, bevorzugt mit einer Länge von C3 bis C20, besonders bevorzugt mit einer Länge von C5 bis C15 und
- kurzkettigen Polyethern, wie z. B. Polymere der Form (-OCH₂CH₂O-)ₙ, mit n < 500. Beispiele hierfür sind Polyethylenglykole (PEG), die als chemisch inerte, wasserlösliche und nicht-toxische Polymere mit einer Kettenlänge von 3-50 Wiederholungseinheiten eingesetzt werden können.

Die Alkylketten oder Alkoxylketten oder Perfluoralkylketten sind in einer bevorzugten Ausführungsform der Erfindung mit polaren Gruppen modifiziert, z. B. mit Alkoholen, Aldehyden, Acetale, Aminen, Amidine, Carbonsäuren, Carbonsäureestern, Carbonsäureamide, Imide, Carbonsäurehalogenide, Carbonsäureanhydride, Ethern, Halogenen, Hydroxamsäuren, Hydrazine, Hydrazone, Hydroxylamine, Laktone, Laktame, Nitrilen, Isocyanide, Isocyanate, Isothiocyanate, Oxime, Nitrosoaryle, Nitroalkyle, Nitroaryle, Phenole, Phosphorsäureestern und/oder Phosphonsäuren, Thiolen, Thioethern, Thioaldehyde, Thioketone, Thioacetale, Thiocarbonsäuren, Thioester, Dithiosäure, Dithiosäureester, Sulfoxide, Sulfone, Sulfonsäure, Sulfonsäureester, Sulfinsäure, Sulfinsäureester, Sulfensäure, Sulfensäureester, Thiosulfinsäure, Thiosulfinsäureester, Thiosulfonsäure, Thiosulfonsäureester, Sulfonamide, Thiosulfonamide, Sulfinamide, Sulfenamide, Sulfate, Thiosulfate, Sultone, Sultame, Trialkylsilyl- und Triarylsilyl-Gruppen sowie Trialkoxysilyl-Gruppen, die eine weitere Erhöhung der Löslichkeit zur Folge haben.

Eine sehr ausgeprägte Erhöhung der Löslichkeit wird ab mindestens einer C6-Einheit, verzweigt oder unverzweigt oder zyklisch, erreicht.

Um den Ladungsträgertransport und die Rekombinationswahrscheinlichkeit der Ladungsträger direkt auf den erfindungsgemäßen Kupfer(I)komplexen zu verbessern, ist mindestens eine der Strukturen N*∩E und/oder L in bevorzugter Weise mit mindestens einer der oben genannten funktionellen Gruppe zur Verbesserung des Ladungsträgertransports substituiert, wobei die funktionelle Gruppe am Ligand N*∩E gleich oder verschieden sein kann von der funktionellen Gruppe am Ligand L, bevorzugt verschieden. Der Substituent kann ausgewählt sein aus der Gruppe bestehend aus Elektronenleiter und Lochleiter.

Die Substituenten der Strukturen N*∩E und/oder L der Kupfer(I)komplexe können an jeder Stelle der Struktur angeordnet sein. Insbesondere ist eine Stellung des Substituenten in ortho-, meta-und/oder para-Stellung zu dem die Koordination zum Cu-Ion ausbildenden Heteroatom möglich. Bevorzugt ist eine Substitution in meta- und/oder para-Stellung.

Ein weiterer Aspekt der Erfindung betriff die Veränderung der Emissionsfarben der Kupfer(I)komplexe mittels elektronenschiebender oder -ziehender Substituenten oder mittels kondensierter N-Heteroaromaten. Die Begriffe elektronenschiebend und elektronenziehend sind dem Fachmann bekannt.

Beispiele für elektronenschiebende Substituenten sind insbesondere:
-Alkyl, -Phenyl, -CO₂(-), -O(-), -NH-Alkylgruppe, -N-(Alkylgruppe)₂, -NH₂, -OH, -O-Alkylgruppe, -NH(CO)-Alkylgruppe, -O(CO)-Alkylgruppe, -O(CO)-Arylgruppe, -O(CO)-Phenylgruppe, -(CH)=C-(Alkylgruppe)₂, -S-Alkylgruppe

Beispiele für elektronenziehende Substituenten sind insbesondere:
-Halogen, -(CO)H, -(CO)-Alkylgruppe, -(CO)O-Alkylgruppe, -(CO)OH, -(CO)Halogenid, -CF₃, -CN, -SO₃H, -NH₃(+), -N(Alkylgruppe)₃(+), -NO₂

Vorteilhafter Weise sind die elektronenschiebenden und -ziehenden Substituenten möglichst weit von der Koordinationsstelle des Liganden entfernt, insbesondere in meta- oder para-Stellung.

Somit kann durch geeignete Substitutionswahl innerhalb der Grundstruktur eines Pyridinliganden ein sehr breiter Emissionsfarbbereich eingestellt werden.

Die Veränderung der Emissionsfarben der hier beschriebenen Kupfer(I)komplexe kann auch durch weitere Heteroatome wie N, O, S, sowie mittels kondensierter N-, O- und S-Heteroaromaten erfolgen.

Die Verwendung kondensierter N-Heteroaromaten wie beispielsweise Isoquinolin, Benzothiazol, Chinoxalin, ermöglicht Farbverschiebungen, zum Beispiel in den gelben bis tiefroten Spektralbereich. Die Erhöhung der Löslichkeit von Kupfer(I)komplexen mit kondensierten N-Heteroaromaten kann ebenfalls durch Substitution(en) mit den oben beschriebenen Substituenten, langkettigen (verzweigten oder unverzweigten oder zyklischen) Alkylketten einer Länge von C1 bis C30, bevorzugt mit einer Länge von C3 bis C20, besonders bevorzugt mit einer Länge von C5 bis C15, langkettigen (verzweigten oder unverzweigten oder zyklischen) Alkoxyketten einer Länge von C1 bis C30, bevorzugt mit einer Länge von C3 bis C20, besonders bevorzugt mit einer Länge von C5 bis C15, langkettigen (verzweigten oder unverzweigten oder zyklischen) Perfluoralkylketten einer Länge von C1 bis C30, bevorzugt mit einer Länge von C3 bis C20, besonders bevorzugt mit einer Länge von C5 bis C15 und kurzkettigen Polyethern (Kettenlänge: 3-50 Wiederholungseinheiten) erfolgen.

In einer bevorzugten Ausführungsform weist der erfindungsgemäße Kupfer(I)komplex mindestens einen Substituenten zur Erhöhung der Löslichkeit in einem organischen Lösungsmittel auf und/oder mindestens einen elektronenschiebenden und/oder mindestens einen elektronenziehenden Substituenten. Es ist auch möglich, dass ein die Löslichkeit verbessernder Substituent gleichzeitig entweder ein elektronenschiebender oder -ziehender Substituent ist. Ein Beispiel für einen derartigen Substituenten ist ein dialkyliertes Amin mit elektronenschiebender Wirkung über das Stickstoffatom und löslichkeits-erhöhender Wirkung durch die langkettigen Alkylgruppen.

Mittels einer modularen Synthesestrategie, in der die Einzelbausteine zur Darstellung dieser Liganden in einer Matrix miteinander kombiniert werden, ist die Einführung von unterschiedlich langen, linearen und verzweigten und zyklischen Alkylketten, Alkoxyketten oder Perfluoralkylketten an verschiedenen Positionen der Moleküle möglich. Bevorzugt sind Substitutionen, die weit entfernt sind von der Koordinationsstelle des oder der Liganden N*∩E und/oder L.

Ausgehend von einem geeigneten Synthesebaustein A werden in analogen Reaktionen unterschiedliche Reaktanden B, C und D unter analogen Reaktionsbedingungen zu chemisch diversen Zielmolekülen AB, AC und AD verknüpft. Hierdurch lassen sich beispielsweise unterschiedlich lange Alkylketten durch Verwendung nukleophiler Substitutionsreaktionen modular an einen geeigneten Pyridinliganden anbringen

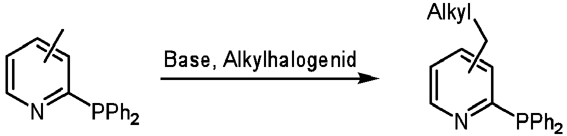

Für die Herstellung der oben genannten Nanopartikel kleiner als 30 nm können mehrere Techniken angewandt werden:^{[xxii]}
*Bottom-Up*-Prozesse zur Synthese von Nanopartikeln:
   - schnelle Injektion der Reaktionslösung in einen großen Überschuss eines geeigneten Fällungsmittel (z. B. Pentan, Diethylether).^{[xxiii]}
   - Feine Zerstäubung der Reaktionslösung in einer Vakuumkammer, eventuell unter erhöhter Temperatur (Sprühtrocknung). Dabei verdampft das Lösungsmittel und der Komplex bleibt in feinverteilter Form zurück.
   - Im Gefriertrocknungsverfahren werden die Tropfen der Reaktionslösung in einem Kühlmittel (z. B. flüssiger Stickstoff) dispergiert, wobei das Material gefriert. Anschließend wird es im festen Zustand getrocknet.
   - Co-Abscheidung der Komplexe und des Matrixmaterials auf dem Substrat direkt aus der Reaktionslösung.
   - Synthese im Ultraschall-Bad.
*Top-Down*-Prozesse zur Zerkleinerung der Substanzen:
   - Zerkleinerung durch Hochenergiekugelmühlen.^{[xxiv]}
   - Zerkleinerung durch hochintensiven Ultraschall.

Eine Isolierung der benötigten Partikelgröße kann durch Filtration mit geeigneten Filtern oder durch Zentrifugation erreicht werden.

Um eine homogene Verteilung der Nanopartikel in der Matrix (z. B. des im Emitter-Layer verwendeten Matrixmaterials) zu erreichen, wird eine Suspension in einem Lösungsmittel zubereitet, in der sich das Matrixmaterial löst. Durch die üblichen Verfahren (z. B. Spin-Coating, Tintenstrahldruck, etc.) kann mit dieser Suspension das Matrixmaterial und die Nanopartikel auf ein Substrat aufgebracht werden. Um eine Aggregation der Nanopartikel zu vermeiden, kann unter Umständen eine Stabilisierung der Teilchen durch oberflächenaktive Substanzen notwendig sein. Diese sind jedoch so zu wählen, dass die Komplexe nicht aufgelöst werden. Eine homogene Verteilung kann auch durch die oben erwähnte Co-Abscheidung der Komplexe zusammen mit dem Matrixmaterial direkt aus der Reaktionslösung erreicht werden.

Da die beschriebenen Substanzen sogar als Feststoffe eine hohe Emissionsquantenausbeute besitzen, können sie ausgehend von der Reaktionslösung auch direkt als dünne Schicht (100 % Emitterschicht) auf dem Substrat abgeschieden werden.

### Beispiele

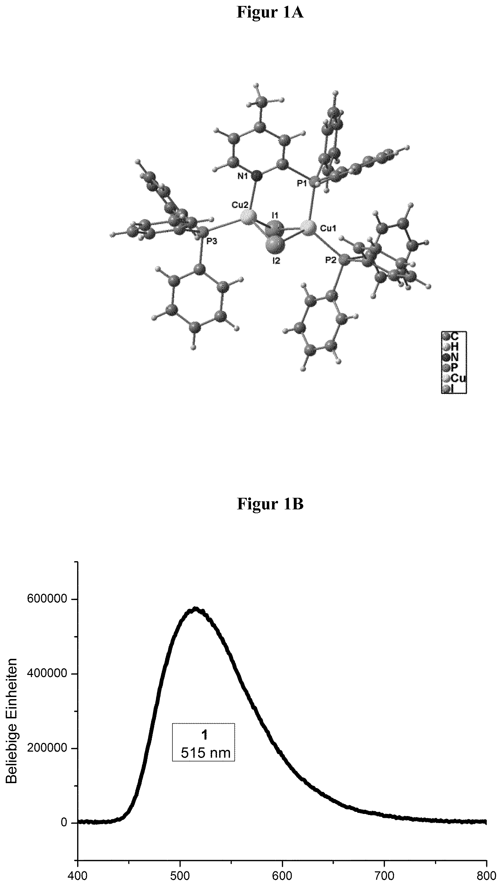

In den hier gezeigten Beispielen ist der Ligand E∩N* der allgemeinen Formel A ein Ligand P∩N* (mit E = Ph₂P). Die Identitäten und Strukturen der Komplexe 1 bis 51 wurden eindeutig durch NMR-Spektroskopie, Massenspektrometrie, Elementaranalysen und/oder Kristallstrukturanalysen (s. Figur 1A) belegt.

### Beispiele für Komplexe der Form Cu₂X₂(P∩N*)L₂

### I. P∩N* = Ph₂Ppic, L = PPh₃: Ci₂I₂(Ph₂Ppic)(PPh₃)₂ (1)

Bei der Verbindung **1** handelt es sich um einen gelben, feinkristallinen Feststoff. 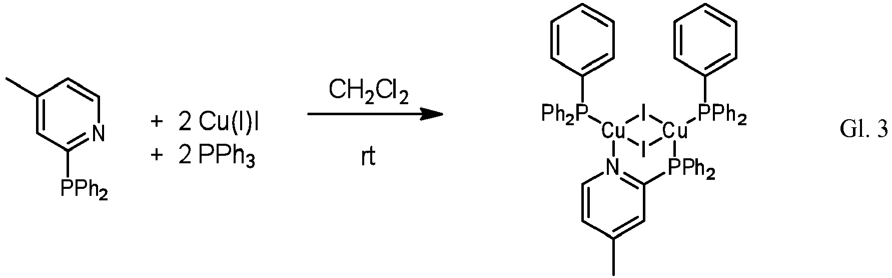 Charakterisierung:
Elementaranalyse:
   gef.: C 54.45; H 4.04; N 0.79
   ber.: C 54.84; H 3.92; N 1.18
Die Kristallstruktur ist in Fig. 1A gezeigt
Das Emissionsspektrum ist in Fig. 1B gezeigt

### II. P∩N* = Ph₂Ppic, L = P(p-Tol)₃: Cu₂l₂(Ph₂Ppic)(P(p-Tol)₃)₂ (2)

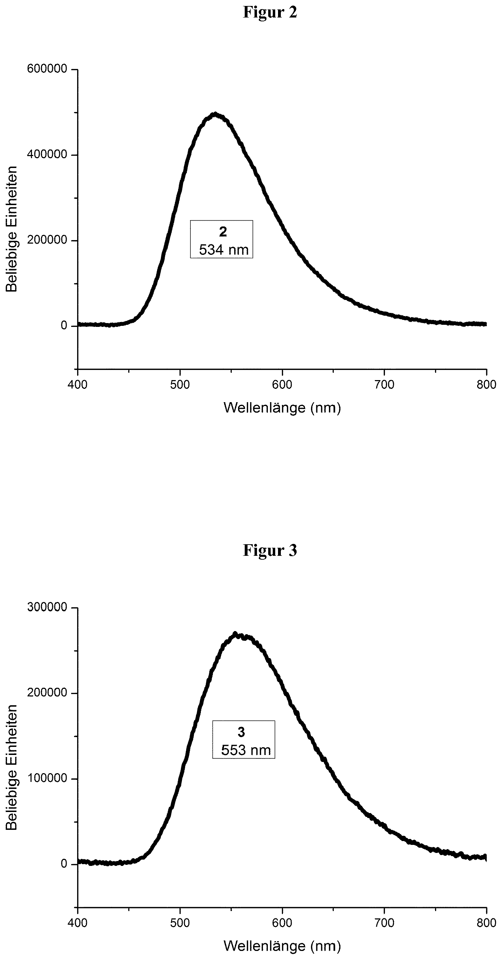

Bei **2** handelt es sich um einen gelben, feinkristallinen Feststoff. 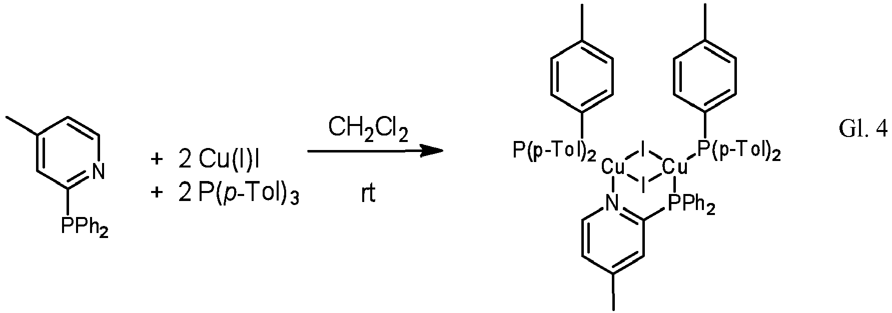 Charakterisierung:
Elementaranalyse:
   gef: C 53.88; H 4.44; N 0.86
   ber.: C 54.20; H 4.47; N 1.04
Das Emissionsspektrum ist in Fig. 2 gezeigt

### III. P∩N* = Ph₂Pic, L = EtPPh₂: Cu₂I₂(Ph₂Pic)(EtPPh₂)₂ (3)

Bei der Verbindung **3** handelt es sich um einen gelben, feinkristallinen Feststoff. 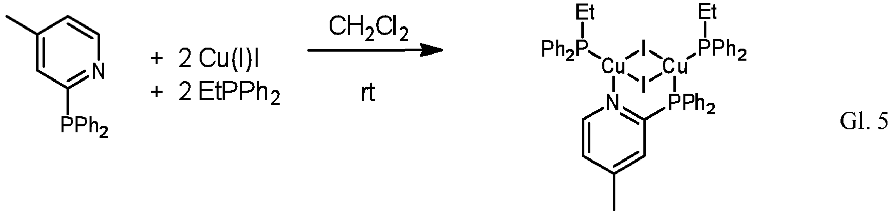 Charakterisierung:
Elementaranalyse:
   gef.: C 50.70; H 4.28; N 1.20
   ber.: C 50.84; H 4.27; N 1.29
Das Emissionsspektrum ist in Fig. 3 gezeigt

### IV. P∩N* = Ph₂P(2-Mepy), L = PPh₃: Cu₂I₂(Ph₂P(2-Mepy))(PPh₃)₂ (4)

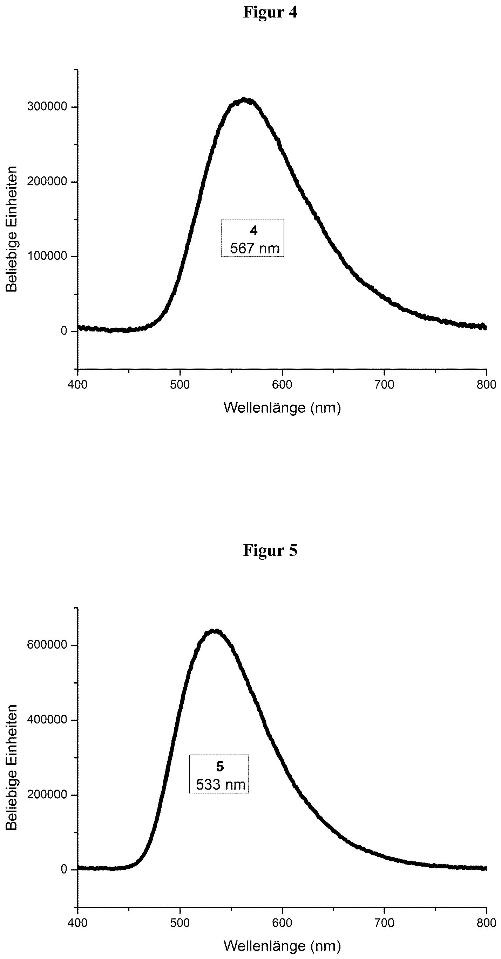

Bei der Verbindung **4** handelt es sich um einen gelben, feinkristallinen Feststoff. 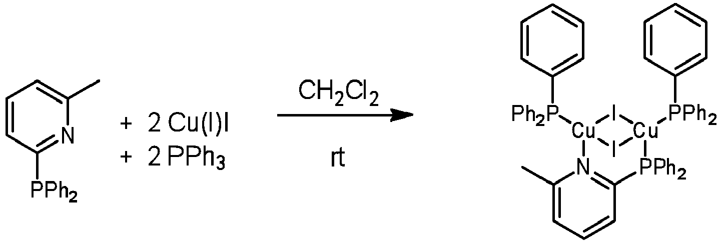 Charakterisierung:
Elementaranalyse:
   gef.: C 48.06; H 3.68; N 0.91
   ges.: C 47.62; H 3.65; N 0.97
Das Emissionsspektrum ist in Fig. 4 gezeigt

### V. P∩N* = Ph₂P(iBupy), L = PPh₃: Cu₂I₂(Ph₂P(iBupy))(PPh₃)₂ (5)

Bei der Verbindung **5** handelt es sich um einen gelben, feinkristallinen Feststoff. 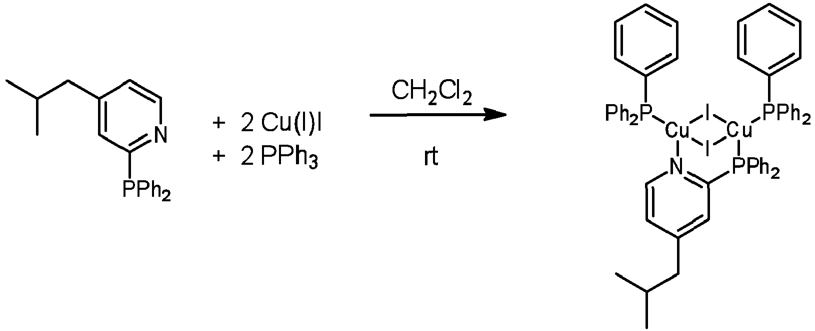 Charakterisierung:
Elementaranalyse:
   gef.: C 56.55; H 4.80; N 0.75
   (mit ½ Molekül n-Hexan)
   ber.: C 56.84; H 4.69; N 1.10
Das Emissionsspektrum ist in Fig. 5 gezeigt

### VI. P∩N* = Ph₂P(cyPentpy), L = PPh₃: Cu₂I₂(Ph₂P(cyPentpy))(PPh₃)₂ (6)

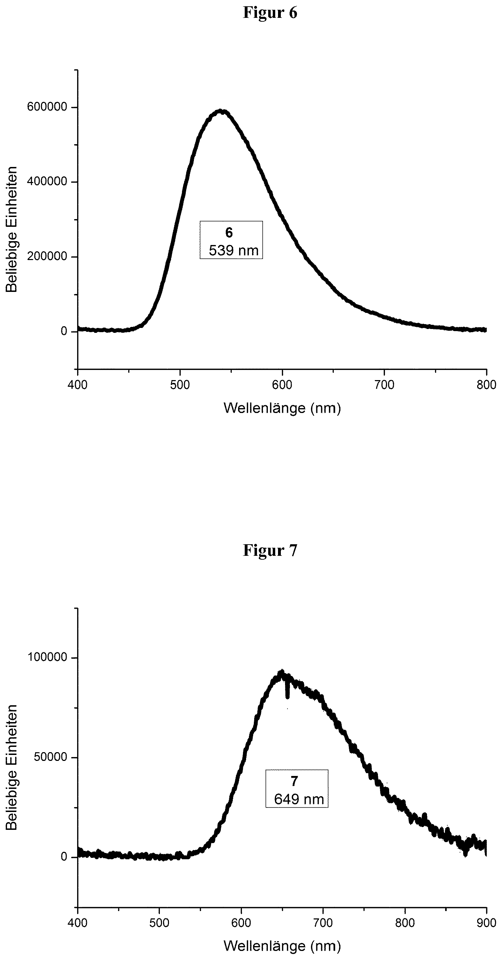

Bei der Verbindung **6** handelt es sich um einen gelben, feinkristallinen Feststoff. 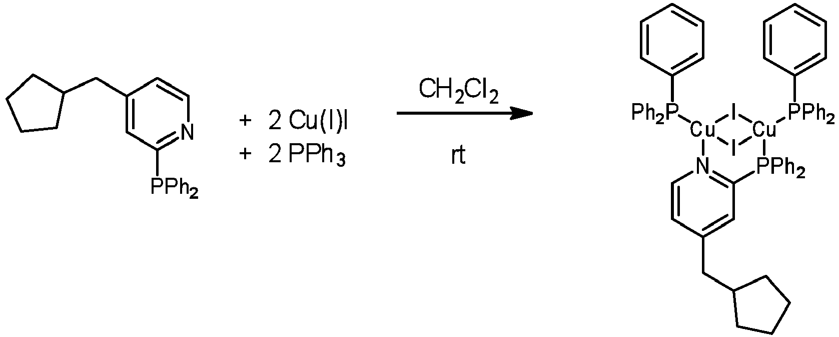 Charakterisierung:
Elementaranalyse:
   gef.: C 57.19; H 5.08; N 0.69
   (mit ¼ Molekül n-Hexan)
   ber.: C 57.11; H 4.55; N 1.10
Das Emissionsspektrum ist in Fig. 6 gezeigt.

### VII. P∩N* = Ph₂Piqn, L = PPh₃: Cn₂I₂(Ph₂Piqn)(PPh₃)₂ (7)

Bei der Verbindung **7** handelt es sich um einen orangefarbenen, kristallinen Feststoff. 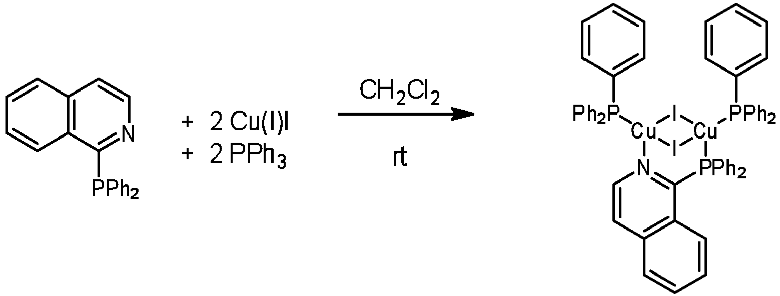 Charakterisierung:
Elementaranalyse:
   gef.: C 57.15; H 3.92; N 1.29
   (mit ½ Molekül n-Hexan)
   ber.: C 57.11; H 4.23; N 1.11
Das Emissionsspektrum ist in Fig. 7 gezeigt

### VIII. P∩N* = Ph₂P(Oxadiazol), L = PPh₃: Cu₂I₂(Ph₂P(Oxadiazol))(PPh₃)₂ (8)

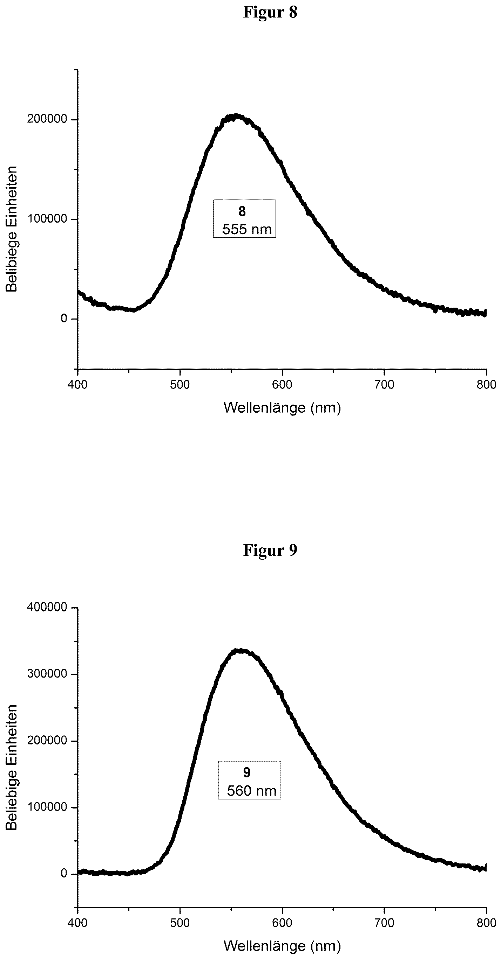

Bei der Verbindung **8** handelt es sich um einen gelben, feinkristallinen Feststoff. 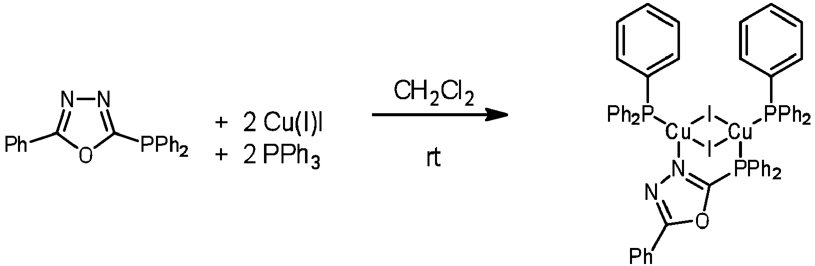 Charakterisierung:
Elementaranalyse:
   gef.: C 54.45; H 4.07; N 1.97
   ber.: C 54.43; H 3.67; N 2.27
Das Emissionsspektrum ist in Fig. 8 gezeigt.

### IX. P∩N* = Ph₂P(Oxadiazol), L = P(p-Tol)₃: Cu₂I₂(Ph₂P(Oxadiazol))(P(p-Tol)₃)₂ (9)

Bei der Verbindung **9** handelt es sich um einen gelben, feinkristallinen Feststoff.

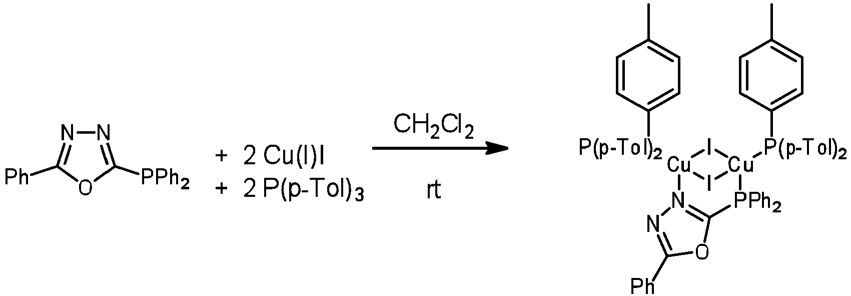

### Charakterisierung:

Elementaranalyse:
   gef.: C 55.80; H 4.16; N 2.54
   ber.: C 56.42; H 4.35; N 2.12
Das Emissionsspektrum ist in Fig. 9 gezeigt.

### X. P∩N* = Ph₂P(Oxadiazol), L = EtPPh₂: Cu₂I₂(Ph₂P(Oxadiazol))(EtPPh₂)₂ (10)

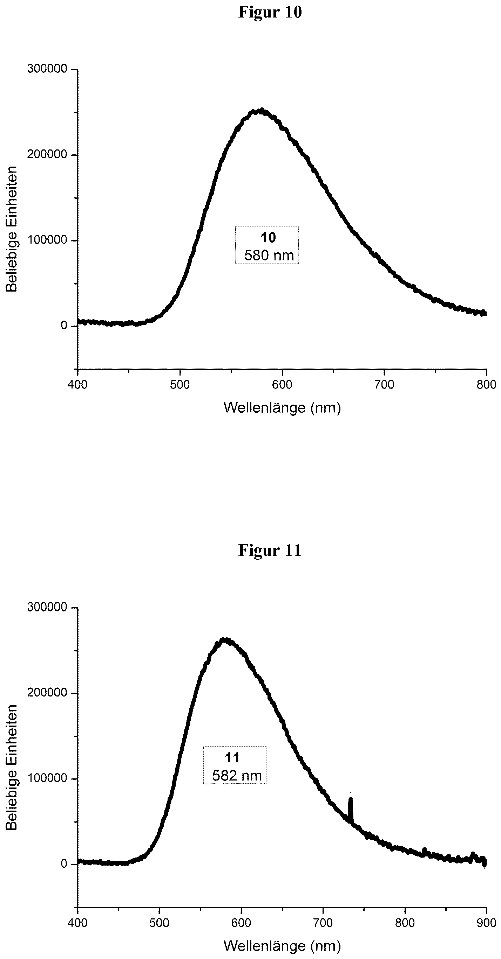

Bei der Verbindung **10** handelt es sich um einen gelben, feinkristallinen Feststoff. 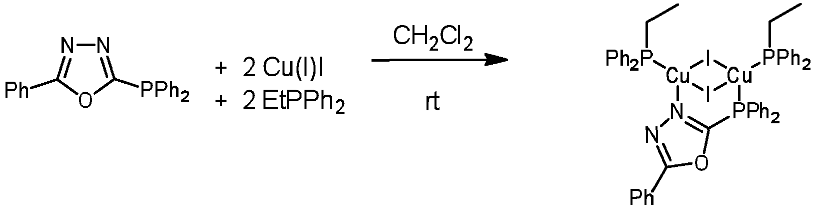 Charakterisierung:
Elementaranalyse:
   gef.: C 50.05; H 3.83; N 2.70
   ber.: C 49.92; H 3.95; N 2.41
Das Emissionsspektrum ist in Fig. 10 gezeigt.

### XI. P∩N* = Ph₂P(Oxadiazol), L = MePPh₂: Cu₂I₂(Ph₂P(Oxadiazol))(MePPh₂)₂ (11)

Bei der Verbindung **11** handelt es sich um einen gelben, feinkristallinen Feststoff. 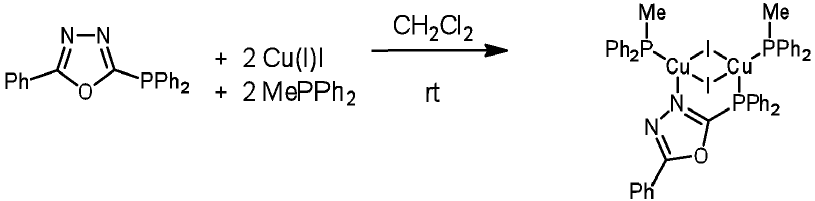 Charakterisierung:
Elementaranalyse:
   gef.: C 50.18; H 3.98; N 2.25
   ber.: C 49.70; H 3.72; N 2.52
Das Emissionsspektrum ist in Fig. 11 gezeigt.

### XII. P∩N* = Ph₂P(Oxadiazol), L = PhP(CH₂CH₂PPh₂)₂: Cu₂I₂(Ph₂P(Oxadiazol))(PhP(CH₂CH₂PPh₂)₂)₂ (12)

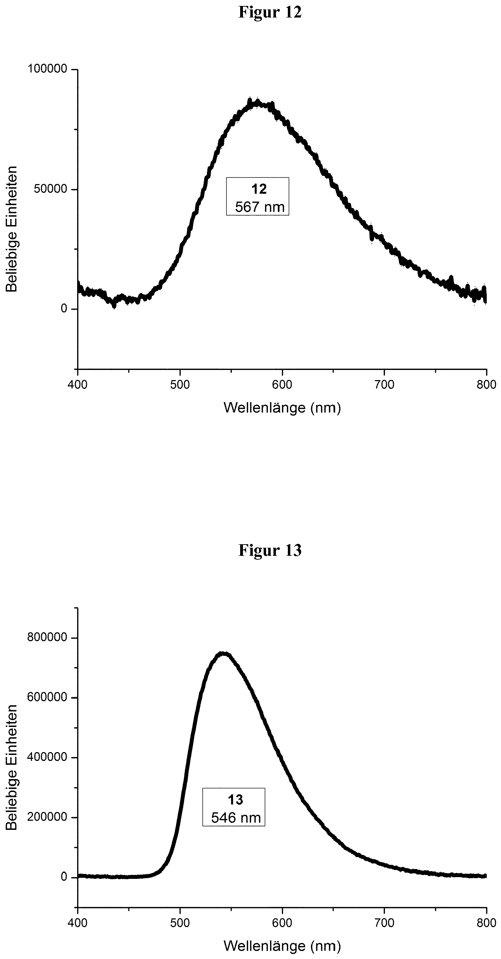

Bei der Verbindung **12** handelt es sich um einen gelben, feinkristallinen Feststoff. 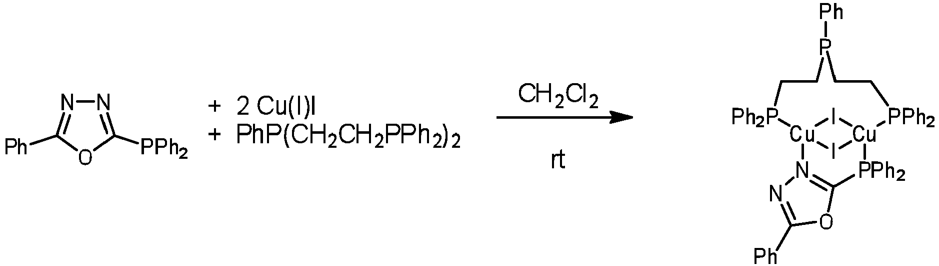 Charakterisierung:
Elementaranalyse:
   gef.: C 49.84; H 3.76 N 1.67
   (mit einem Molekül DCM)
   ber.: C 49.64; H 3.79; N 2.11
Das Emissionsspektrum ist in Fig. 12 gezeigt.

### XIII. P∩N* = Ph₂PMe₂Thiaz, L = PPh₃: Cu₂I₂(Ph₂PMe₂Thiaz)(PPh₃)₂ (13)

Bei der Verbindung **13** handelt es sich um einen gelben, feinkristallinen Feststoff. 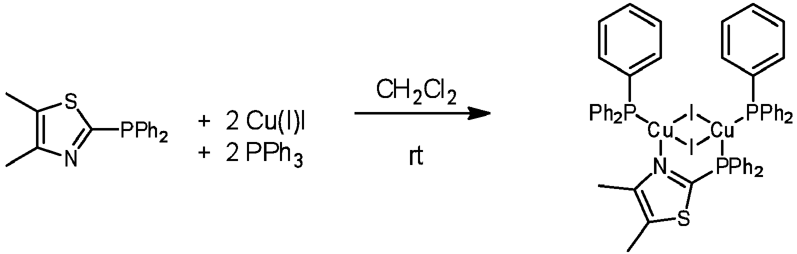 Charakterisierung:
Elementaranalyse:
   gef.: C 52.54; H 4.07; N 1.86; S 2.19
   ges.: C 52.92; H 3.85; N 1.16; S 2.67
Das Emissionsspektrum ist in Fig. 13 gezeigt.

### XIV. P∩N* = Ph₂PThiaz, L = PPh₃: Cu₂I₂(Ph₂PThiaz)(PPh₃)₂ (14)

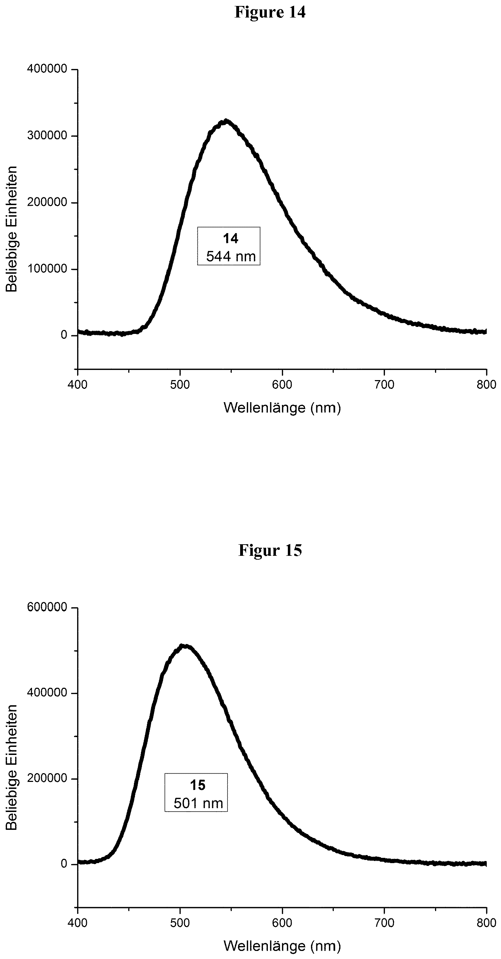

Bei der Verbindung **14** handelt es sich um einen gelben, feinkristallinen Feststoff. 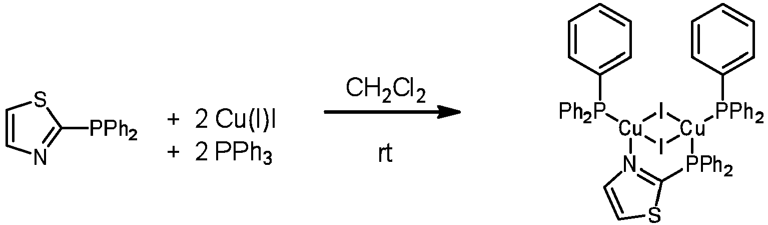 Charakterisierung:
Elementaranalyse:
   gef.: C 52.14; H 3.65; N 1.01; S 2.43
   ges.: C 52.14; H 3.60; N 1.19; S 2.73
Das Emissionsspektrum ist in Fig. 14 gezeigt.

### XV. P∩N* = Ph₂P(Ph₂Triaz), L = PPh₃: Cu₂I₂(Ph₂P(Ph₂Triaz))(PPh₃)₂ (15)

Bei der Verbindung **15** handelt es sich um einen weißen, feinkristallinen Feststoff. 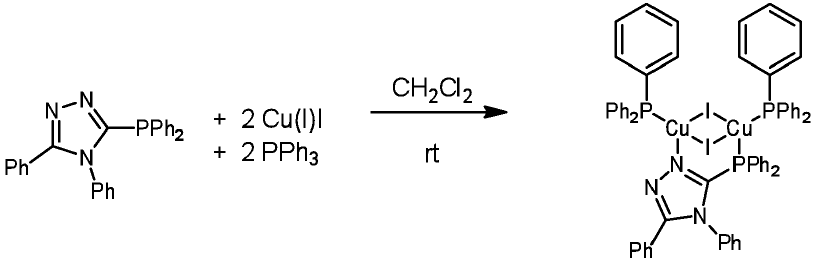 Charakterisierung:
Elementaranalyse:
   gef.: C 55.89; H 3.74; N 2.70
   ges.: C 56.13; H 3.82; N 3.15
Das Emissionsspektrum ist in Fig. 15 gezeigt.

### XVI. P∩N* = Ph₂PTolTriaz, L = PPh₃: Cu₂I₂(Ph₂PTolTriaz)(PPh₃)₂ (16)

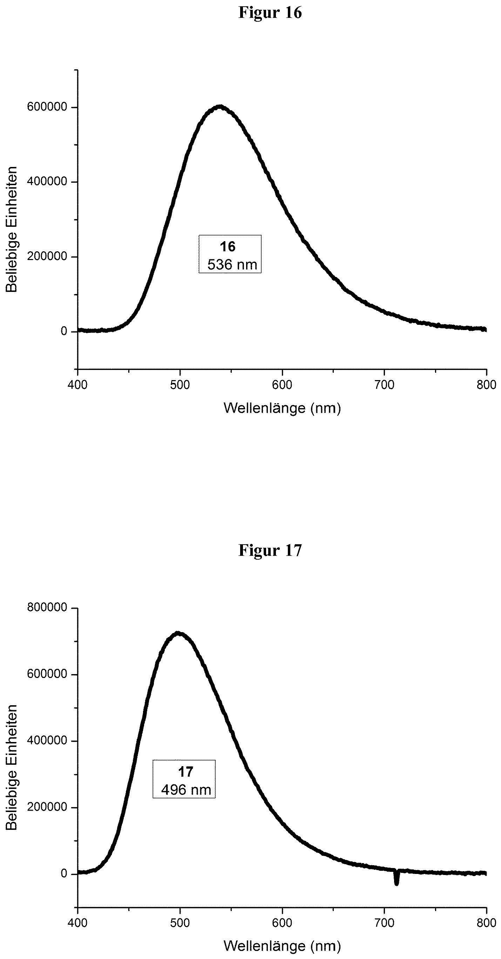

Bei der Verbindung **16** handelt es sich um einen weißen, feinkristallinen Feststoff. 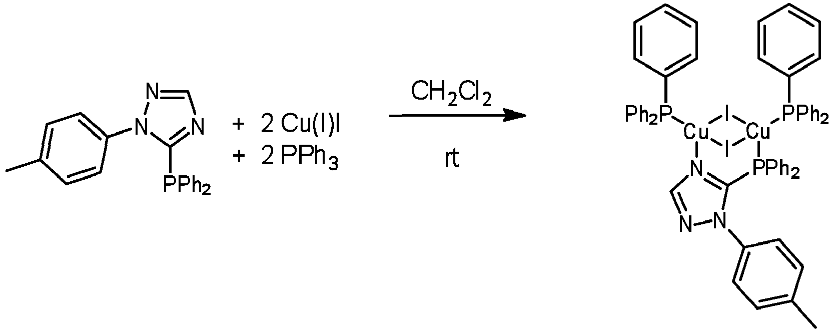 Charakterisierung:
Elementaranalyse:
   gef.: C 54.26; H 4.05; N 3.36
   ges.: C 54.14; H 3.85; N 3.31
Das Emissionsspektrum ist in Fig. 16 gezeigt.

### XVII. P∩N* = Ph₂PPrTriaz, L = PPh₃: Cu₂I₂(Ph₂PPrTriaz)(PPh₃)₂ (17)

Bei der Verbindung **17** handelt es sich um einen weißen, feinkristallinen Feststoff. 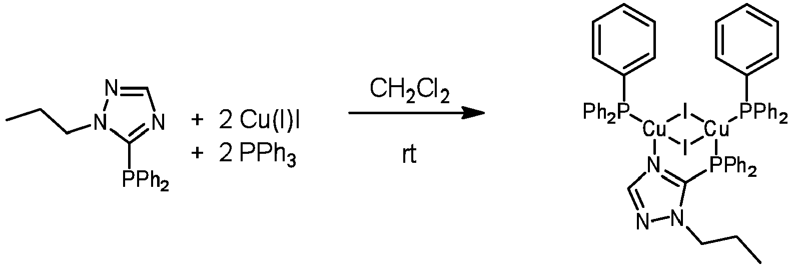 Charakterisierung:
Elementaranalyse:
   gef.: C 52.77; H 4.05; N 3.11
   ges.: C 53.01; H 4.03; N 3.50
Das Emissionsspektrum ist in Fig. 17 gezeigt.

### XVIII. P∩N* = Ph₂PPentTriaz, L = PPh₃: Cu₂I₂(Ph₂PPentTriaz)(PPh₃)₂ (18)

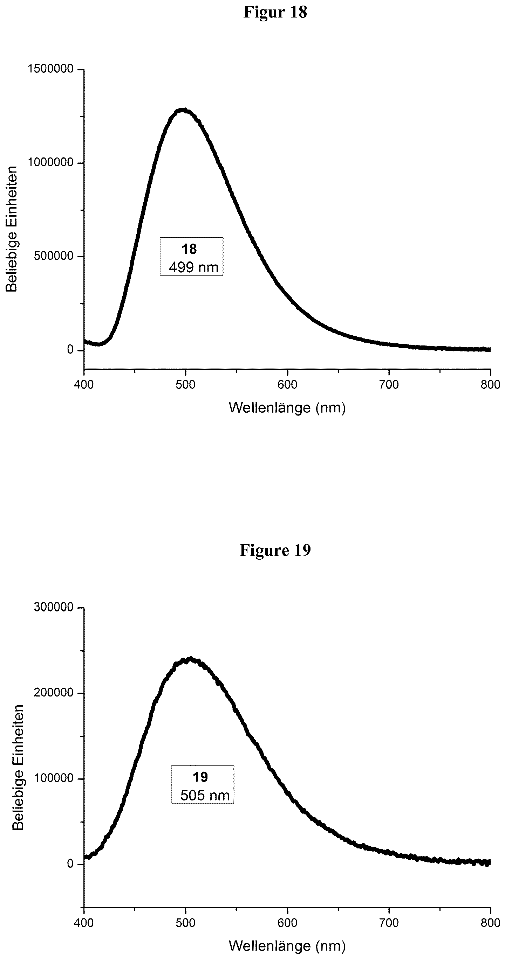

Bei der Verbindung **18** handelt es sich um einen weißen, feinkristallinen Feststoff. 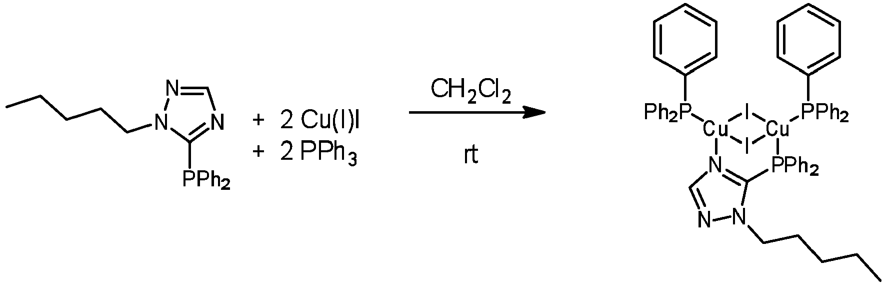 Charakterisierung:
Elementaranalyse:
   gef.: C 53.55; H 4.34; N 3.65
   ges.: C 53.76; H 4.27; N 3.42
Das Emissionsspektrum ist in Fig. 18 gezeigt.

### XIX. P∩N* = Ph₂PEtHexTriaz, L = PPh₃: Cu₂I₂(Ph₂PEtHexTriaz)(PPh₃)₂ (19)

Bei der Verbindung **19** handelt es sich um einen weißen, feinkristallinen Feststoff. 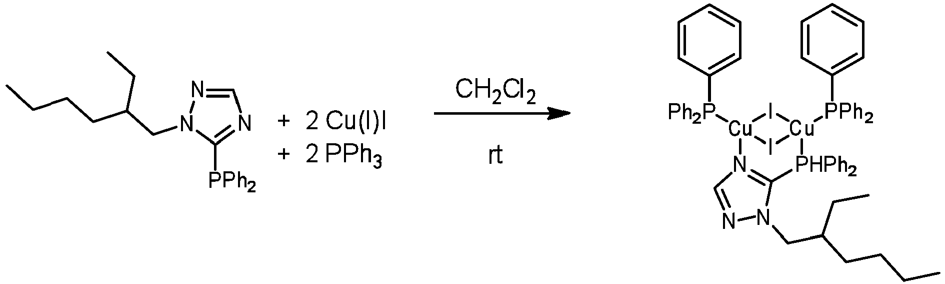 Charakterisierung:
Elementaranalyse:
   gef.: C 53.70; H 4.36; N 2.63
   ges.: C 53.50; H 4.53; N 3.20
Das Emissionsspektrum ist in Fig. 19 gezeigt.

### XX. P∩N* = Ph₂PBnTriaz, L = PPh₃: Cu₂I₂(Ph₂PBnTriaz)(PPh₃)₂ (20)

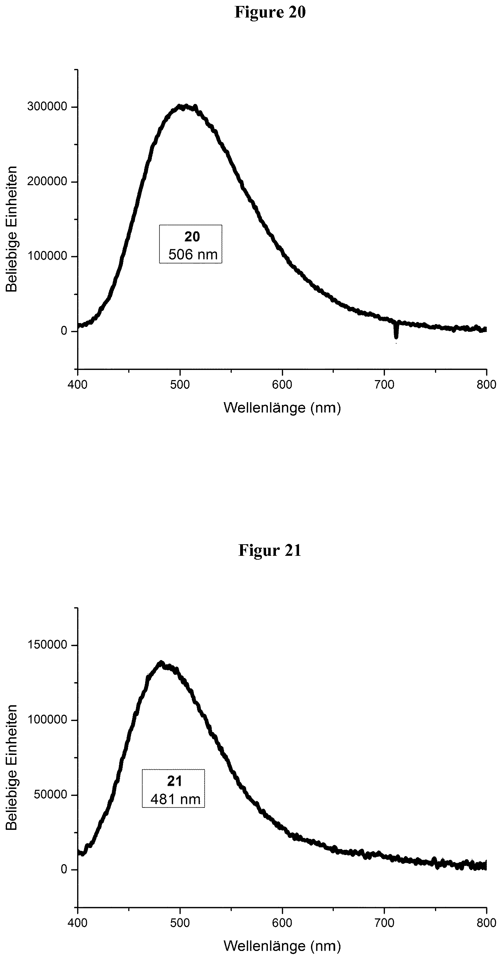

Bei der Verbindung **20** handelt es sich um einen weißen, feinkristallinen Feststoff. 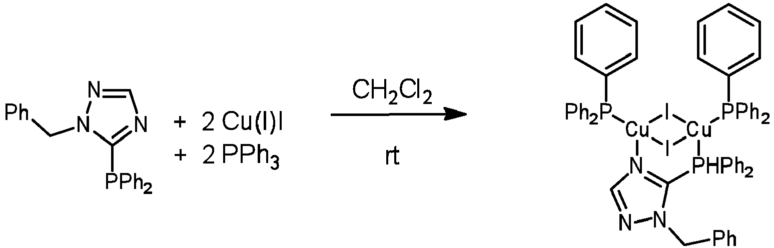 Charakterisierung:
Elementaranalyse:
   gef.: C 54.67; H 3.78; N 3.28
   ges.: C 54.82; H 3.87; N 3.36
Das Emissionsspektrum ist in Fig. 20 gezeigt.

### XXI. P∩N* = Ph₂P(MeImid), L = PPh₃: Cn₂I₂(Ph₂P(MeImld))(PPh₃)₂ (21)

Bei der Verbindung **21** handelt es sich um einen weißen, feinkristallinen Feststoff. 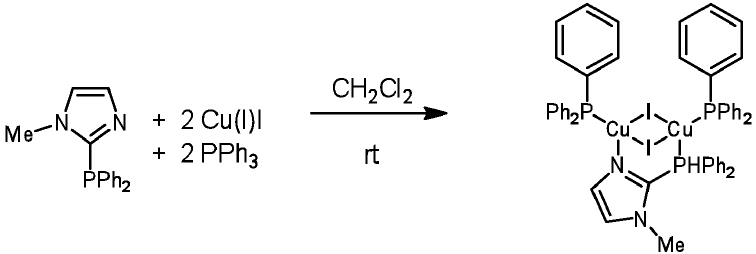 Charakterisierung:
Elementaranalyse:
   gef.: C 52.38; H 3.84; N 2.33
   (mit 1/3 Molekül DCM)
   ges.: C 52.39; H 3.90; N 2.28
Das Emissionsspektrum ist in Fig. 21 gezeigt.

### XXII. P∩N* = Ph₂P(MeTolImid), L = PPh₃: Cu₂I₂(Ph₂P(MeTolImid))(PPh₃)₂ (22)

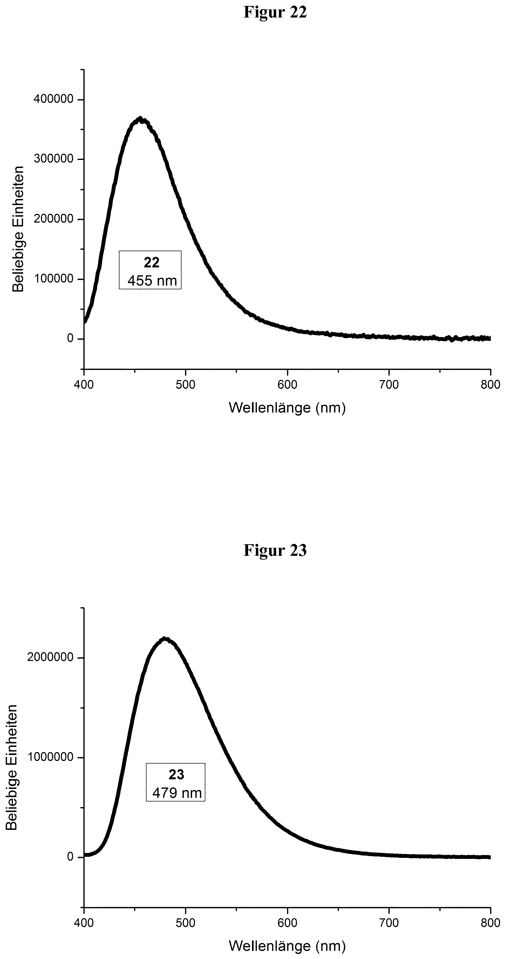

Bei der Verbindung **22** handelt es sich um einen weißen, feinkristallinen Feststoff. 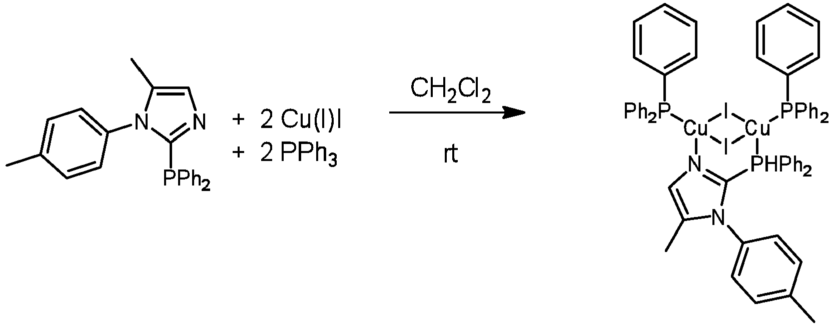 Charakterisierung:
Elementaranalyse:
   gef.: C 55.58; H 4.05; N 1.74
   (mit 1/4 Molekül DCM)
   ges.: C 55.46; H 4.05; N 2.18
Das Emissionsspektrum ist in Fig. 22 gezeigt.

### XXIII. P∩N* = Ph₂P(iBuBenzimid), L = PPh₃: Cu₂I₂(Ph₂P(iBuBenzimid)(PPh₃)₂ (23)

Bei der Verbindung **23** handelt es sich um einen weißen, feinkristallinen Feststoff. 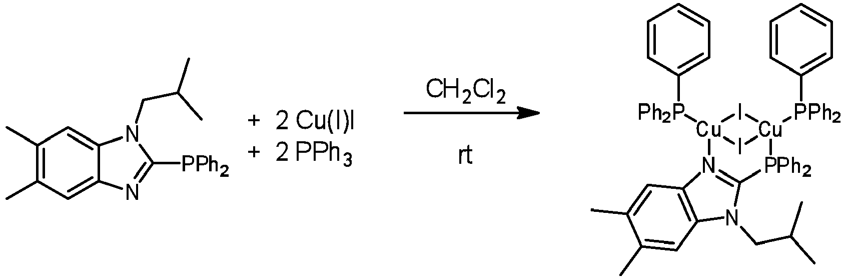 Charakterisierung:
Elementaranalyse:
   gef.: C 56.20; H 4.55; N 1.69
   (mit 1/4 Molekül DCM)
   ges.: C 56.02; H 4.41; N 2.13
Das Emissionsspektrum ist in Fig. 23 gezeigt.

### XXIV. P∩N* = Ph₂P(OctBenzimid), L = PPh₃: Cu₂I₂(Ph₂P(OctBenzimid)(PPh₃)₂ (24)

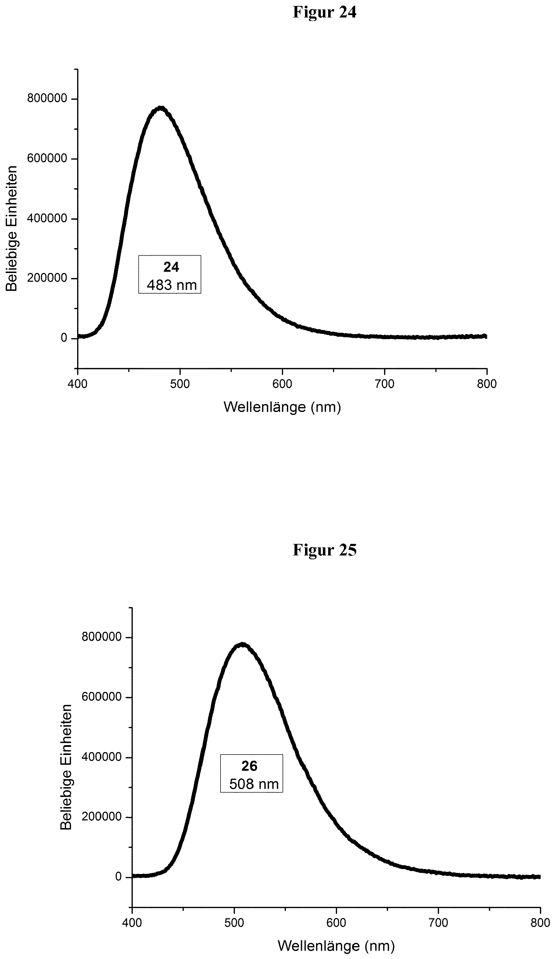

Bei der Verbindung **24** handelt es sich um einen weißen, feinkristallinen Feststoff. 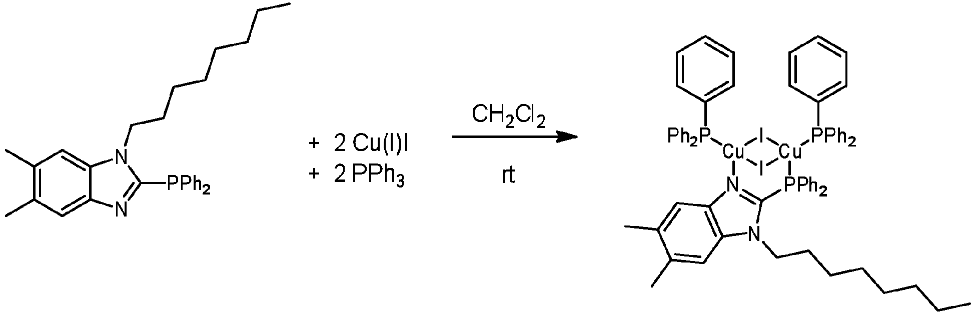 Charakterisierung:
Elementaranalyse:
   gef.: C 57.60; H 4.79; N 1.93
   ges.: C 57.91; H 4.86; N 2.08
Das Emissionsspektrum ist in Fig. 24 gezeigt.

### XXV. P∩N* = Ph₂P(PhenanthroImid), L = PPh₃: Cu₂I₂(Ph₂P(PhenanthroImid)(PPh₃)₂ (25)

Bei der Verbindung **25** handelt es sich um einen weißen, feinkristallinen Feststoff. 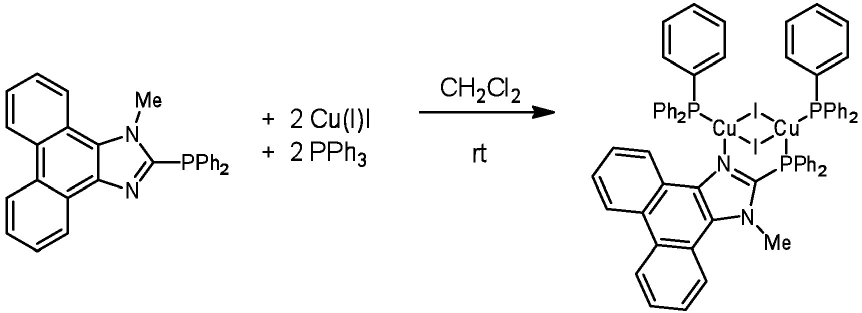 Charakterisierung:
Elementaranalyse:
   gef.: C 57.66; H 3.88; N 1.91
   (mit 1/8 Molekül DCM)
   ges.: C 57.45; H 3.86; N 2.09

### XXVI. P∩N* = Ph₂P(Ph₂Triaz), L = PPh₃: Cu₂I₂(Ph₂P(Ph₂Triaz)(PPh₃)₂ (26)

Bei der Verbindung **26** handelt es sich um einen weißen, feinkristallinen Feststoff. 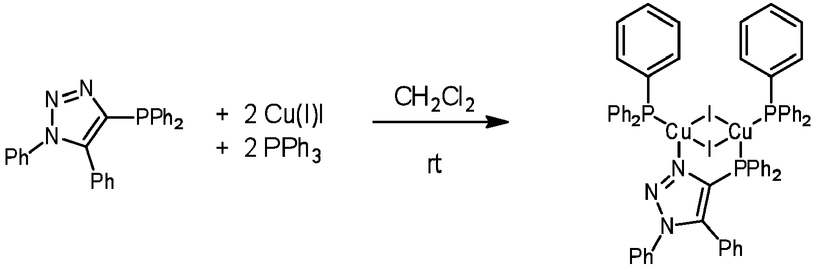 Charakterisierung:
Das Emissionsspektrum ist in Fig. 25 gezeigt.

### XXVII. P∩N* = Ph₂Ppic, L = P(p-OMePh)₃ : Cu₂I₂(Ph₂Ppic)(P(p-OMePh)₃)₂ (27)

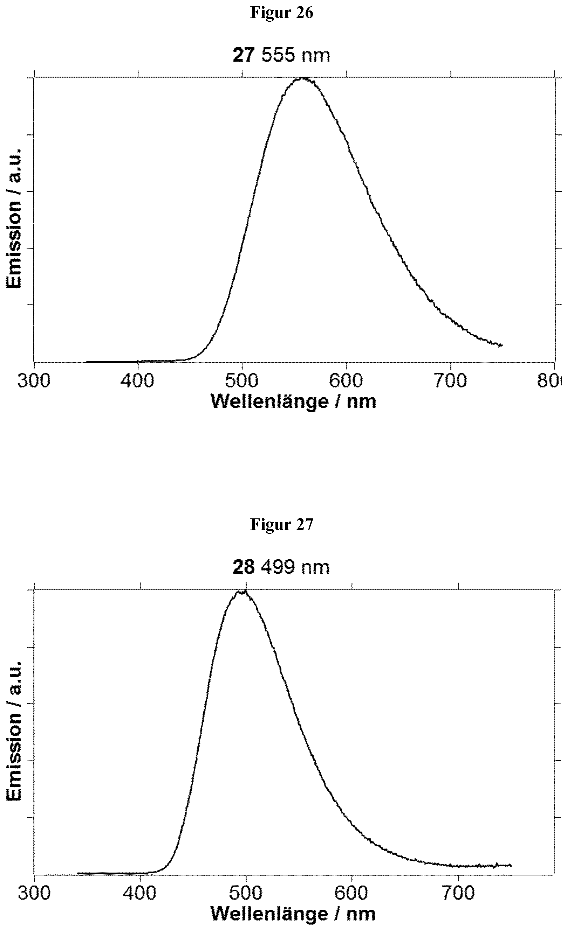

Bei der Verbindung **27** handelt es sich um einen gelblichen, feinkristallinen Feststoff. 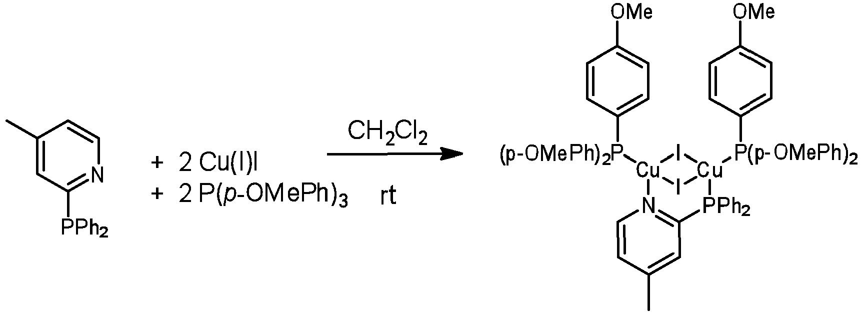 Charakterisierung:
Elementaranalyse:
   gef.: C 51.89; H 4.33; N 0.61
   (mit 1/2 Molekül DCM)
   ges.: C 51.70; H 4.23; N 1.00
Das Emissionsspektrum ist in Fig. 26 gezeigt.

### XXVIII. P∩N* = Ph₂Ppic, L = P(2-Furyl)₃: Cu₂I₂(Ph₂Ppic)(P(2-Furyl)₃)₂ (28)

Bei der Verbindung **28** handelt es sich um einen weißen, feinkristallinen Feststoff. 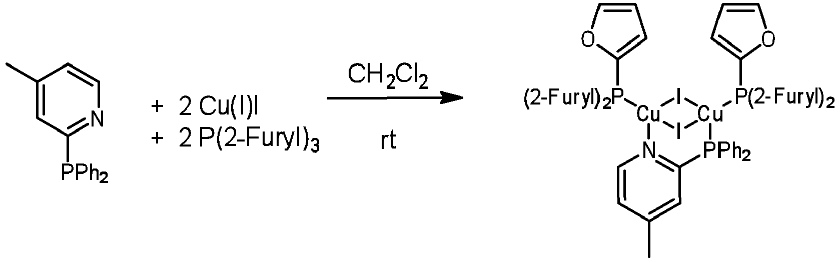 Charakterisierung:
Elementaranalyse:
   gef.: C 44.56; H 3.60; N 0.91
   ges.: C 44.94; H 3.05; N 1.25
Das Emissionsspektrum ist in Fig. 27 gezeigt.

### XXIX. P∩N* = Ph₂Ppic, L = P(n-Octyl)₃: Cu₂I₂(Ph₂Ppic)(P(n-Octyl)₃)₂ (29)

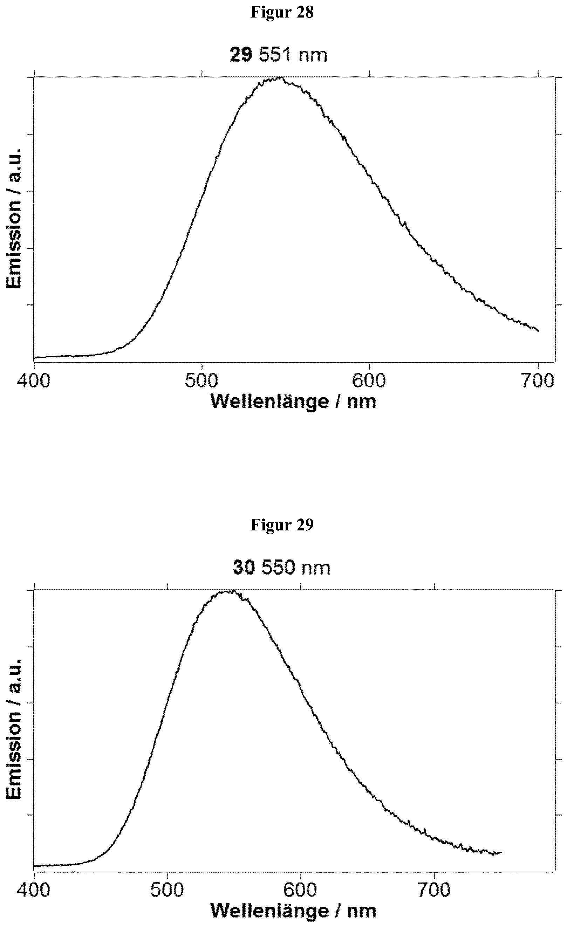

Bei der Verbindung **29** handelt es sich um einen gelblichen, feinkristallinen Feststoff. 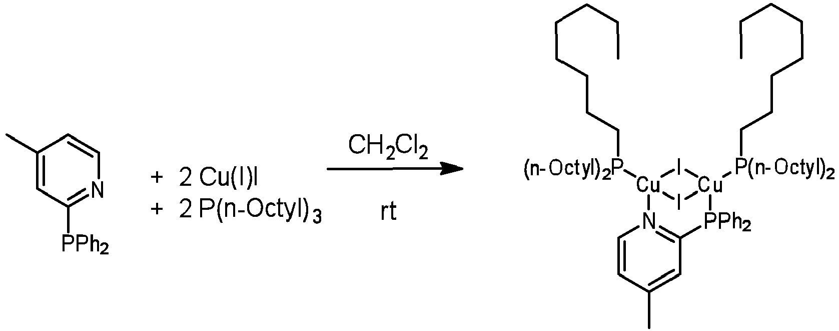 Charakterisierung:
Elementaranalyse:
   gef.: C 56.76; H 8.85; N 0.60
   ges.: C 56.64; H 8.85; N 1.00
Das Emissionsspektrum ist in Fig. 28 gezeigt.

### XXX. P∩N* = Ph₂Ppic, L = P(c-Hexyl)₃: Cu₂I₂(Ph₂Ppic)(P(c-Hexyl)₃)₂ (30)

Bei der Verbindung **30** handelt es sich um einen gelblichen, feinkristallinen Feststoff. 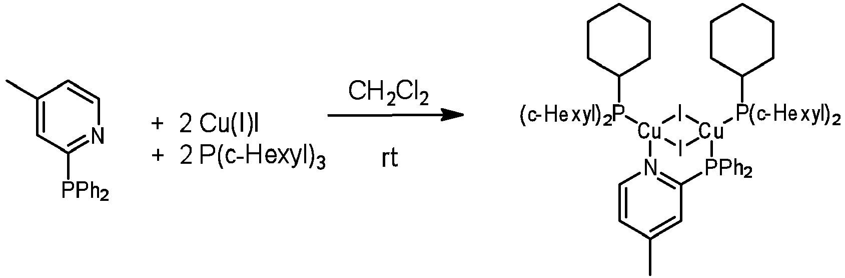 Charakterisierung:
Das Emissionsspektrum ist in Fig. 29 gezeigt.

### XXXI. P∩N* = Ph₂Ppic, L = P(OEt)₃: Cu₂I₂(Ph₂Ppic)(P(OEt)₃)₂ (31)

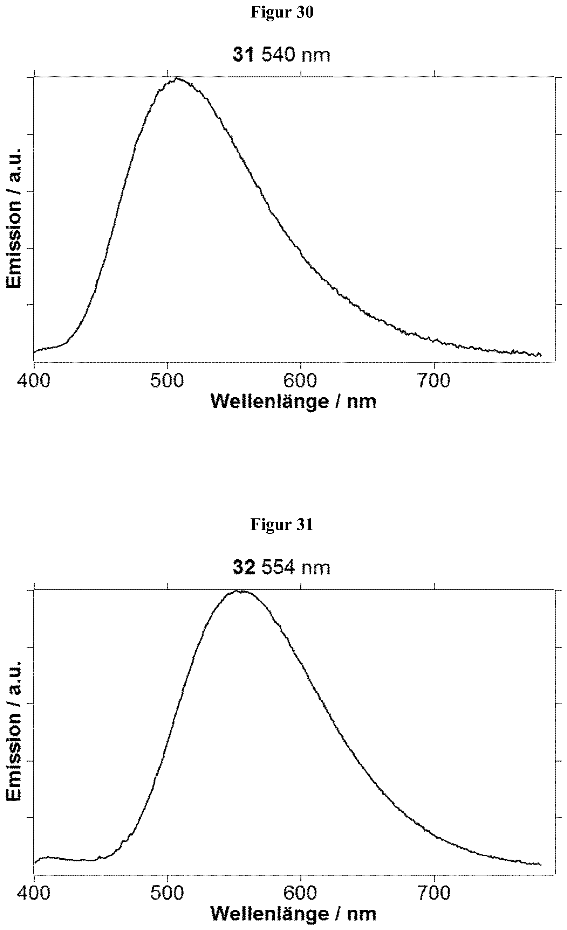

Bei der Verbindung **31** handelt es sich um einen grünlichen, feinkristallinen Feststoff. 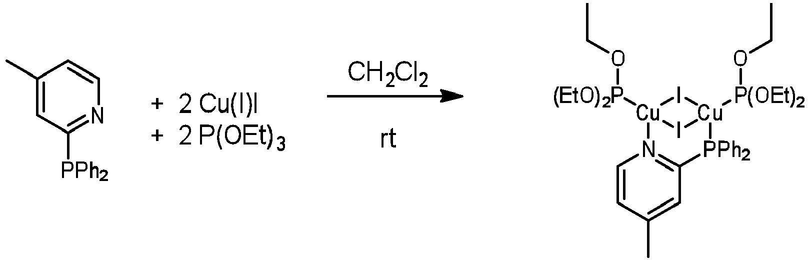 Charakterisierung:
Elementaranalyse:
   gef.: C 35.73; H 4.78; N 1.01
   (mit 1/3 Molekül DCM)
   ges.: C 35.76; H 4.62; N 1.37
Das Emissionsspektrum ist in Fig. 30 gezeigt.

### XXXII. P∩N* = Ph₂PPyButin, L = P(OEt)₃: Cu₂I₂(Ph₂PyButin)(P(OEt)₃)₂ (32)

Bei der Verbindung **32** handelt es sich um einen gelblichen, feinkristallinen Feststoff. 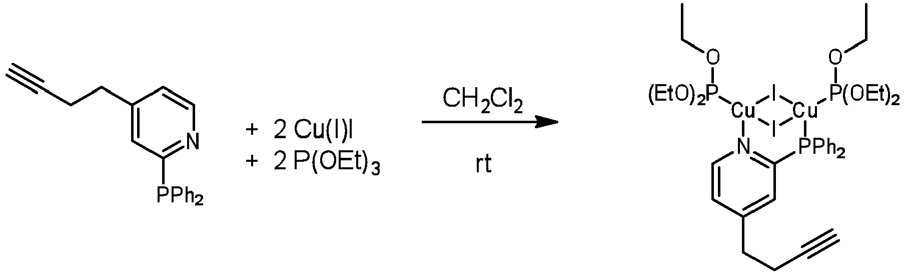 Charakterisierung:
Elementaranalyse:
   gef.: C 37.25; H 4.90; N 0.90
   (mit 1/2 Molekül DCM)
   ges.: C 37.57; H 4.61; N 1.30
Das Emissionsspektrum ist in Fig. 31 gezeigt.

### XXXIII. P∩N* = Ph₂Ppic, L = P(OiPr)₃: Cu₂I₂(Ph₂Ppic)(P(OiPr)₃)₂ (33)

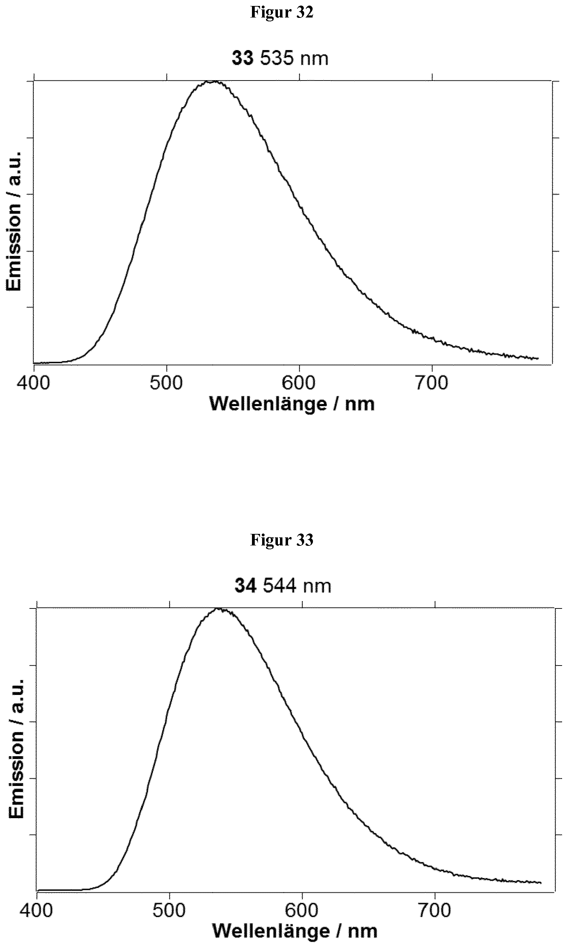

Bei der Verbindung **33** handelt es sich um einen grünlichen, feinkristallinen Feststoff. 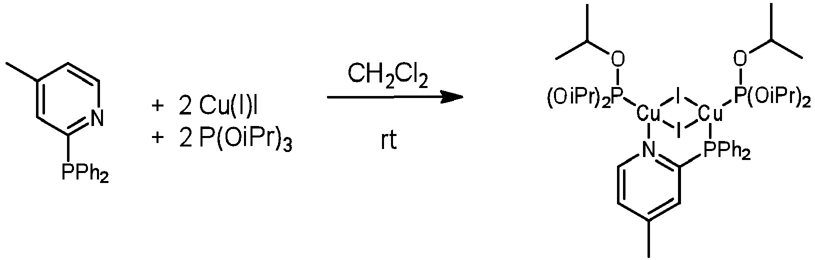 Charakterisierung:
Elementaranalyse:
   gef.: C 40.53; H 5.41; N 1.03
   ges.: C 40.23; H 5.44; N 1.30
Das Emissionsspektrum ist in Fig. 32 gezeigt.

### XXXIV. P∩N* = Ph₂Ppic, L = PPh₂OEt: Cu₂I₂(Ph₂Ppic)(PPh₂OEt)₂ (34)

Bei der Verbindung **34** handelt es sich um einen gelblichen, feinkristallinen Feststoff. 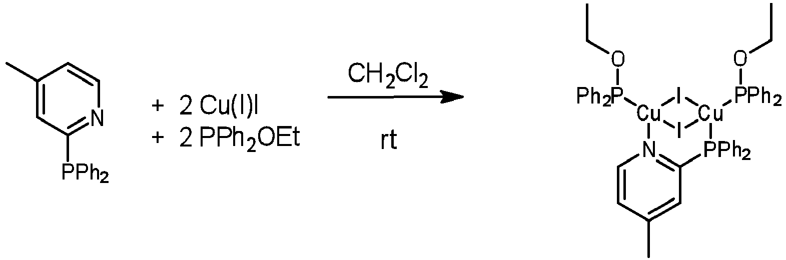 Charakterisierung:
Elementaranalyse:
   gef.: C 50.10; H 4.41; N 1.23
   (mit 1/3 Molekül DCM)
   ges.: C 50.43; H 4.29; N 1.00
Das Emissionsspektrum ist in Fig. 33 gezeigt.

### XXXV. P∩N* = Ph₂Ppic, L = PPhOEt₂: Cn₂I₂(Ph₂Ppic)(PPhOEt₂)₂ (35)

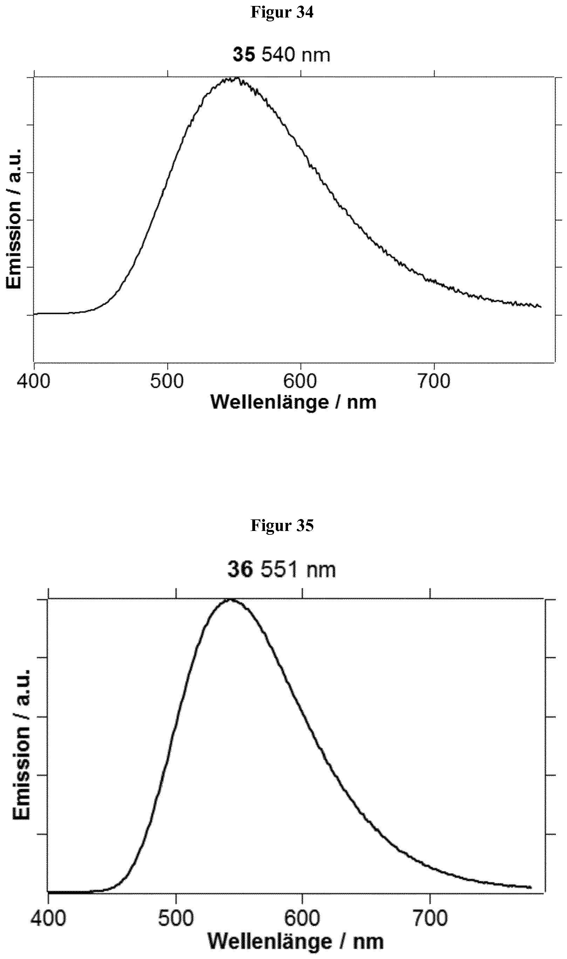

Bei der Verbindung **35** handelt es sich um einen leicht grünlichen, feinkristallinen Feststoff. 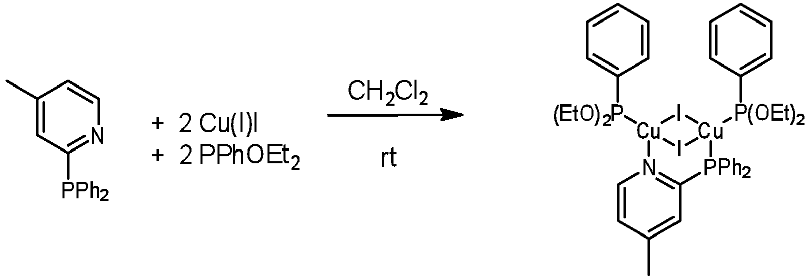 Charakterisierung:
Elementaranalyse:
   gef.: C 43.18; H 4.10; N 1.55
   ges.: C 43.28; H 4.40; N 1.33
Das Emissionsspektrum ist in Fig. 34 gezeigt.

### XXXVI. P∩N* = Ph₂Ppic, L = PPh₂Bu: Cu₂I₂(Ph₂Ppic)(PPh₂Bu)₂ (36)

Bei der Verbindung **36** handelt es sich um einen leicht grünlichen, feinkristallinen Feststoff. 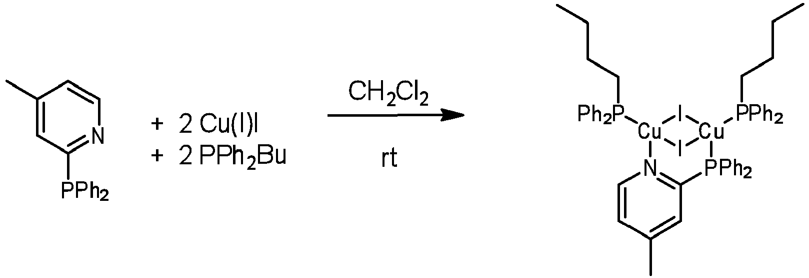 Charakterisierung:
Elementaranalyse:
   gef.: C 52.55; H 4.70; N 0.97
   ges.: C 52.55; H 4.76; N 1.23
Das Emissionsspektrum ist in Fig. 35 gezeigt.

### XXXVII. P∩N* = Ph₂P(MeTolImid), L = DPEphos: Cu₂I₂(Ph₂P(MeTolImid)(PPEphos) (37)

Bei der Verbindung **37** handelt es sich um einen weißen, feinkristallinen Feststoff. 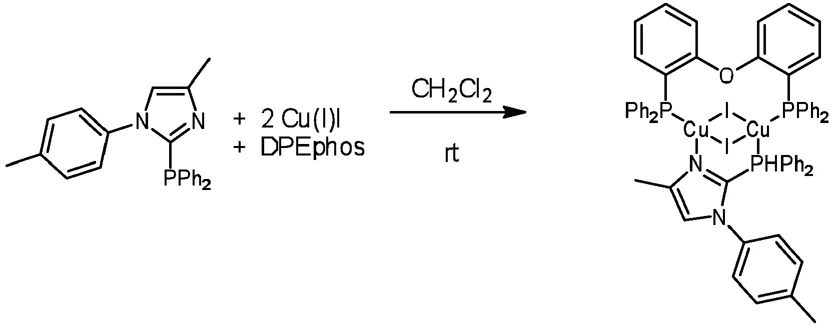 Charakterisierung:
Elementaranalyse:
   gef.: C 48.62; H 3.38; N 3.01
   (mit 1 Molekül DCM)
   ges.: C 48.50; H 3.44; N 3.26

### XXXVIII. P∩N* = Ph₂P(TolOxadiazol), L = DPEphos: Cu₂I₂(Ph₂P(Oxadiazol)(DPEphos) (38)

Bei der Verbindung **38** handelt es sich um einen weißen, feinkristallinen Feststoff. 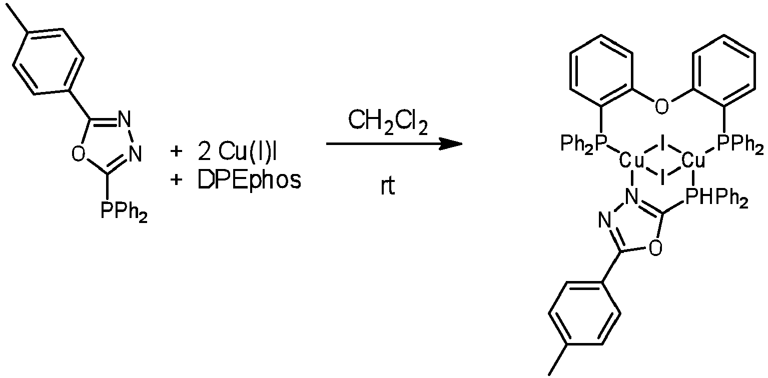 Charakterisierung:
Elementaranalyse:
   gef.: C 51.00; H 3.46; N 2.22 ges.: C 50.89; H 3.43; N 2.33

### XXXIX. P∩N* = Ph₂P(Ph₂PThiaz), L = DPEphos: Cu₂I₂(Ph₂P(Ph₂PThiaz)(DPEphos) (39)

Bei der Verbindung **39** handelt es sich um einen weißen, feinkristallinen Feststoff. 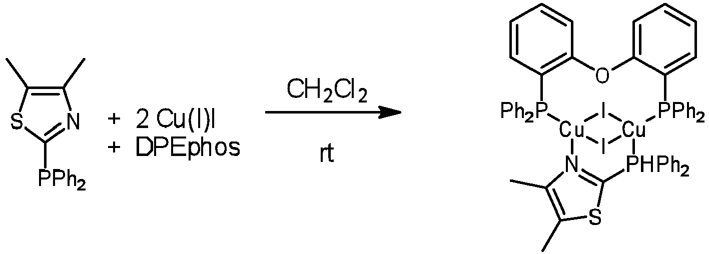 Charakterisierung:
Elementaranalyse:
   gef.: C 48.57; H 3.43; N 1.03; S 2.74
   ges.: C 48.80; H 3.49; N 1.21; S 2.77

### XXXX. P∩N* = Ph₂P(TolOxadiazol), L = 4-EthynylPhPPh₂: Cu₂I₂(Ph₂P(TolOxadiazol)(4-EthynylPhPPh₂)₂ (40)

Bei der Verbindung **40** handelt es sich um einen gelben, feinkristallinen Feststoff. 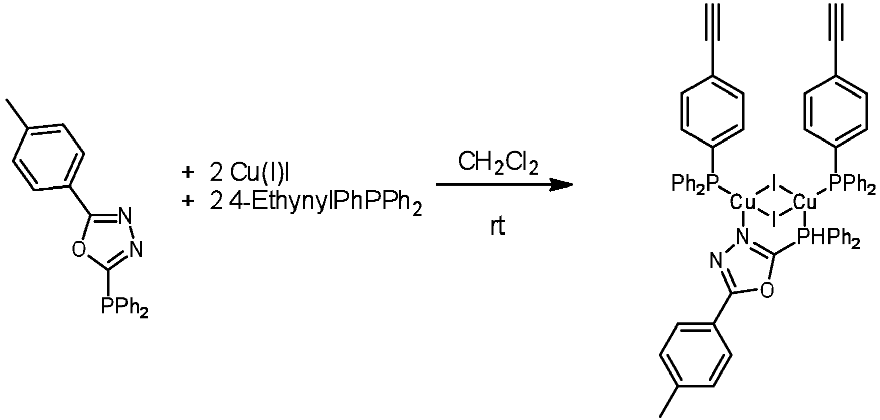 Charakterisierung:
Elementaranalyse:
   gef.: C 55.47; H 3.70; N 2.08
   (mit 1/4 Molekül DCM)
   ges.: C 55.77; H 3.63; N 2.12

### XXXXI. P∩N* = Ph₂P(Ph₂PThiaz), L = 4-EthynylPhPPh₂: Cu₂I₂(Ph₂P(Ph₂PThiaz)(4-EthynylPhPPh₂)₂ (41)

Bei der Verbindung **41** handelt es sich um einen gelben, feinkristallinen Feststoff. 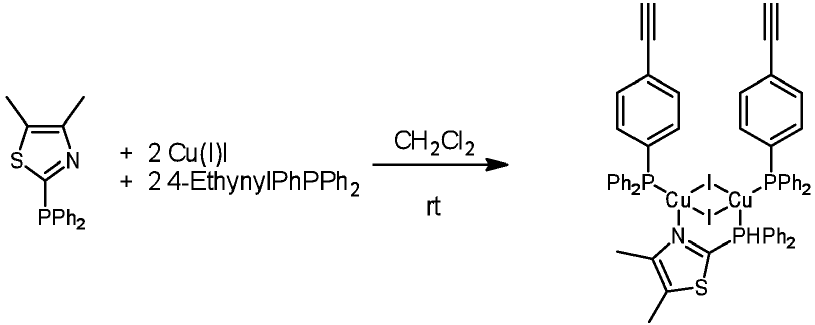 Charakterisierung:
Elementaranalyse:
   gef.: C 53.40; H 3.84; N 0.84; S 2.60
   (mit 1/2 Molekül DCM)
   ges.: C 53.40; H 3.66; N 1.08; S 2.48

### XXXXII. P∩N* = Ph₂P(Ph₂PPyrim), L = PPh₃: Cu₂I₂(Ph₂P(Ph₂PPyrim)(PPh₃)₂ (42)

Bei der Verbindung **42** handelt es sich um einen orangefarbenen, feinkristallinen Feststoff. 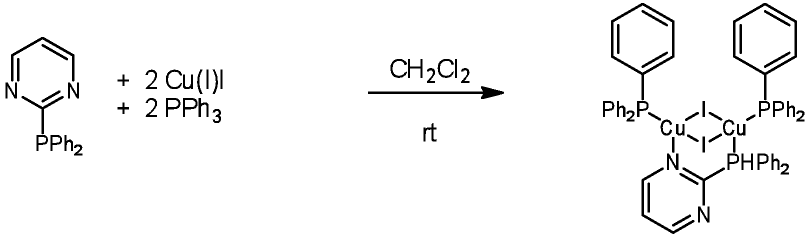 Charakterisierung:
Elementaranalyse:
   gef.: C 53.92; H 4.31; N 2.11
   (mit 1/2 Molekül MTBE)
   ges.: C 53.93; H 4.07; N 2.31

### XXXXIII-XXXV. P∩N* = Ph₂P(Ph₂PPyr), L = PPh₃, X = Cl, Br, I: Cu₂X₂(Ph₂P(Ph₂PPyr)(PPh₃)₂ (43-45)

Bei den Verbindungen **43-45** handelt es sich um gelbe, feinkristalline Feststoffe. 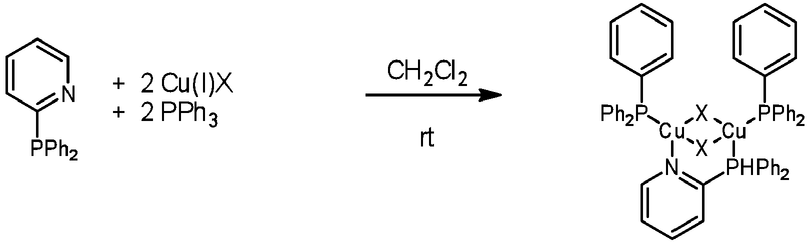 Charakterisierung:
Elementaranalyse:
   **43** X = Cl:
      gef.: C 64.22; H 4.51; N 1.16
      ges.: C 64.57; H 4.50; N 1.42
   **44** X = Br:
      gef.: C 58.91; H 4.28; N 1.03
      ges.: C 58.88; H 4.25; N 1.20
   **45** X=I:
      gef.: C 54.39; H 3.85; N 0.93
      ges.: C 54.47; H 3.79; N 1.20

### XXXVI. P∩N* = Ph₂P(Ph₂P(iBupy), L = PPh₃: Cu₂I₂(Ph₂P(Ph₂P(iBupy)₂(PPh₃) (46)

Bei der Verbindung **46** handelt es sich um einen gelben, feinkristallinen Feststoff. 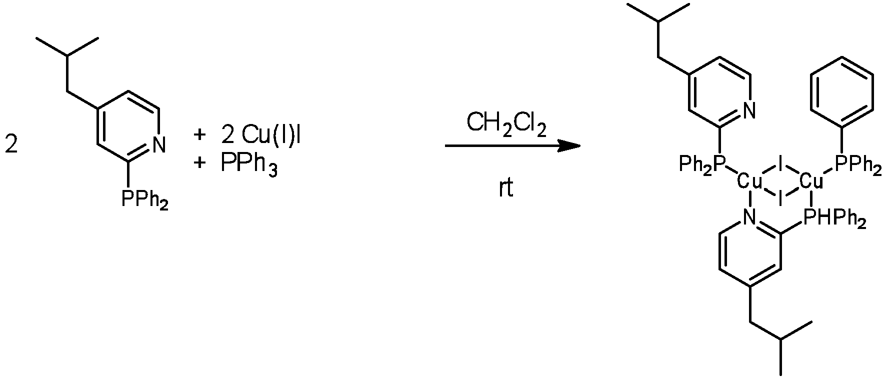 Charakterisierung:
Elementaranalyse:
   gef.: C 54.55; H 4.52; N 1.89
   (mit 1/2 Molekül DCM)
   ges.: C 54.87; H 4.57; N 2.12

### XXXVII. P∩N* = Ph₂P(Ph₂PPyraz), L = PPh₃: Cn₂I₂(Ph₂P(Ph₂PPyraz)(PPh₃)₂ (47)

Bei der Verbindung **47** handelt es sich um einen orangefarbenen, feinkristallinen Feststoff. 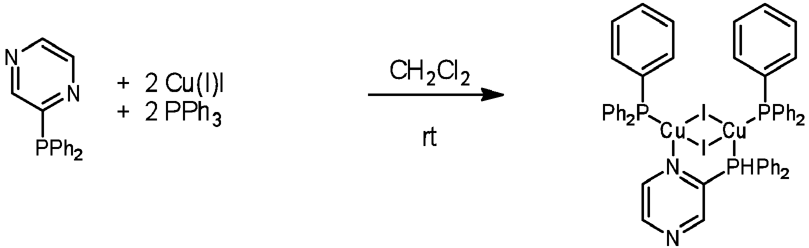 Charakterisierung:
Elementaranalyse:
   gef.: C 52.63; H 3.72; N 2.15
   (mit 1/4 Molekül DCM)
   ges.: C 52.69; H 3.68; N 2.35

### XXXVIII. P∩N* = Ph₂P(Ph₂PAlkoxyPy), L = PPh₃: Cn₂I₂(Ph₂P(Ph₂PAlkoxyPy)(PPh₃)₂ (48)

Bei der Verbindung **48** handelt es sich um einen gelben, feinkristallinen Feststoff. 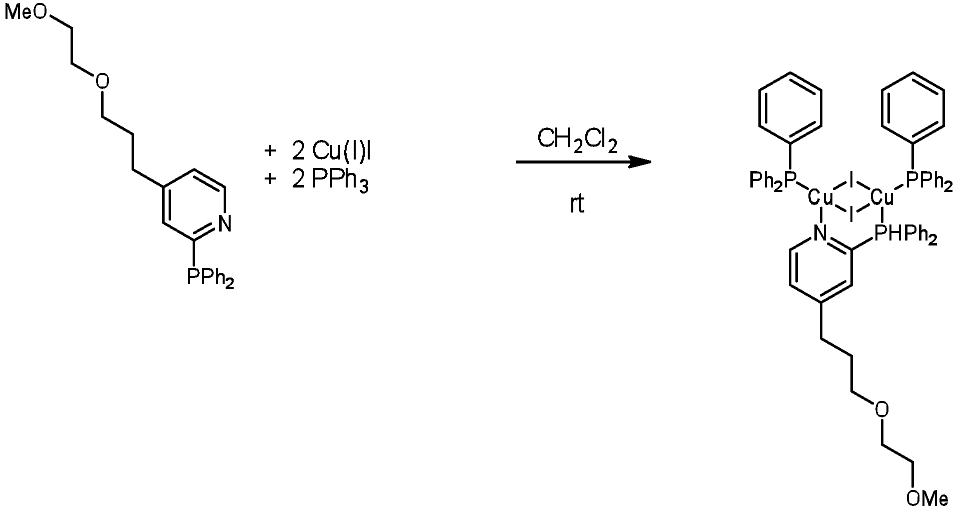 Charakterisierung:
Elementaranalyse:
   gef.: C 54.75; H 4.34; N 0.74
   ges.: C 55.15; H 4.39; N 1.09

### XXXIX. P∩N* = Ph₂P(Ph₂PAlkoxyPy), L = Ph₂PPAlkoxy: Cn₂I₂(Ph₂P(Ph₂PAlkoxyPy)(Ph₂PPAlkoxy)₂ (49)

Bei der Verbindung **49** handelt es sich um einen gelben Feststoff. 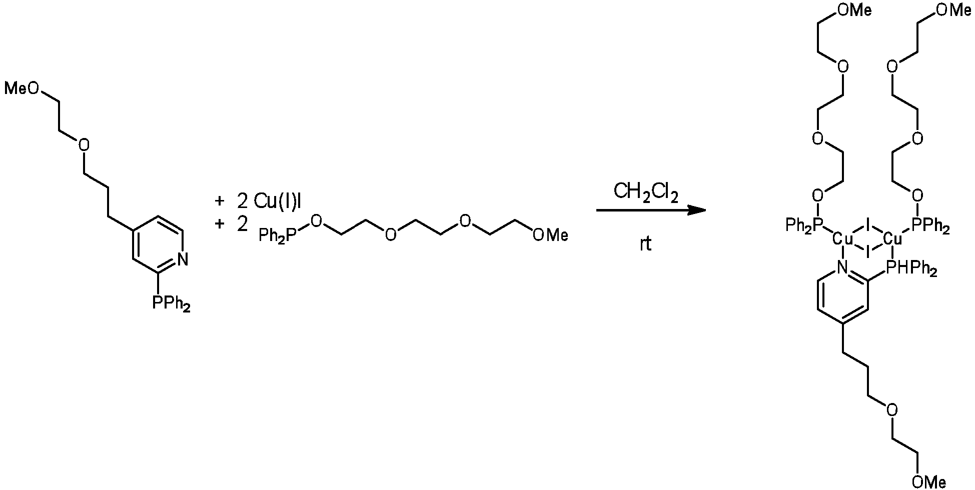 Charakterisierung:
Elementaranalyse:
   gef.: C 48.14; H 4.85; N 0.88
   (mit 1 Molekül DCM)
   ges.: C 48.29; H 5.10; N 0.91

### L. P∩N* = Ph₂P(TolMeBenzimid), L = PPh₃: Cu₂I₂(Ph₂P(TolMeBenzimid)(PPh₃)₂ (50)

Bei der Verbindung **50** handelt es sich um einen weißen, feinkristallinen Feststoff. 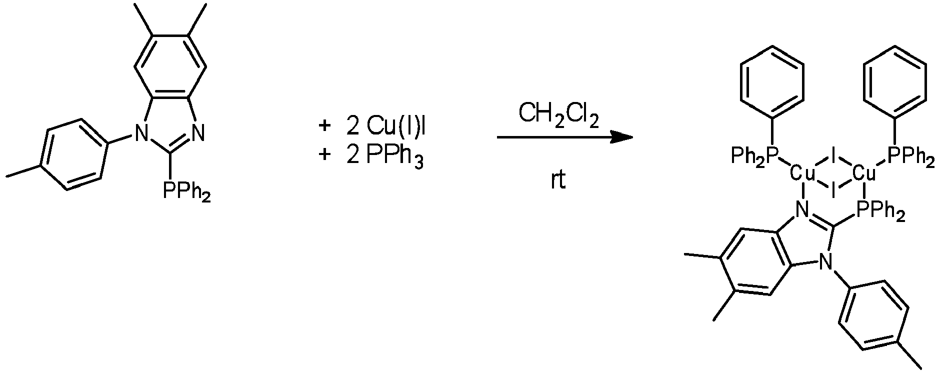 Charakterisierung:
Elementaranalyse:
   gef.: C 57.96; H 4.32; N 1.80
   ges.: C 57.97; H 4.18; N 2.11

### LI. P∩N* = Ph₂P(TolImid), L = PPh₃: Cn₂I₂(Ph₂P(TolImld)(PPh₃)₂ (51)

Bei der Verbindung **51** handelt es sich um einen weißen, feinkristallinen Feststoff. 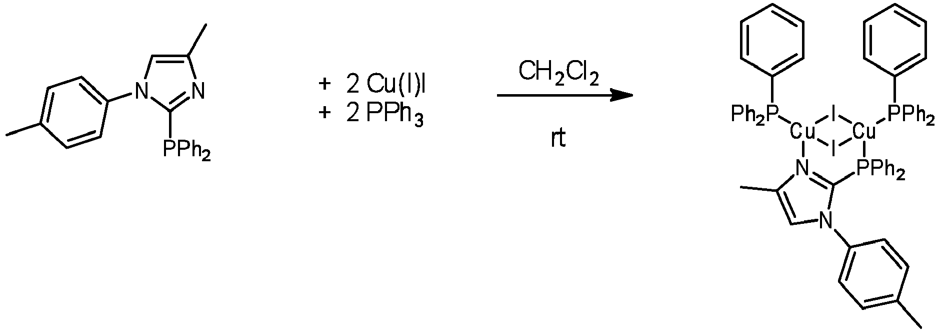 Charakterisierung:
Elementaranalyse:
   gef.: C 55.13; H 4.05; N 1.81
   (mit 1/4 Molekül DCM)
   ges.: C 55.13; H 3.93; N 2.21

### Referenzen

[i] C. Adachi, M. A. Baldo, S. R. Forrest, S. Lamansky, M. E. Thompson, R. C. Kwong, Appl. Phys. Lett. 2001, 78, 1622.
[ii] X. H. Yang, D. C. Müller, D. Neher, K. Meerholz, Adv. Mater. 2006, 18, 948; X. H. Yang, D. Neher, Appl. Phys. Lett. 2004, 84, 2476.
[iii] J. Shinar (Hrsg.), Organic light-emitting devices - A survey, AIP-Press, Springer, New York, 2004.
[iv] H. Yersin, Top. Curr. Chem. 2004, 241, 1.
[v] H. Yersin, Highly Efficient OLEDs with Phosphorescent Materials, Wiley-VCH, Weinheim 2008.
[vi] Z. H. Kafafi, Organic Electroluminescence, Taylor & Francis, Boca Raton, 2005.
[vii] M. E. Thompson, P. I. Djurovich, J. Li (University of Southern California, Los Angeles, CA), WO 2004/017043 A2, 2004.
[viii] M. E. Thompson, P. I. Djurovich, R. Kwong (University of Southern California, Los Angeles, CA, Universal Display Corp, Ewing, NY), WO 2004/016711 A1, 2004.
[ix] A. Tsuboyama, S. Okada, T. Takiguchi, K. Ueno, S. Igawa, J. Kamatani, M. Furugori, H. Iwawaki (Canon KK, Tokyo), WO 03/095587 A1, 2003.
[x] C.-M. Che, US 2003/0205707 A1, 2003.
[xi] C.-M. Che, W. Lu, M. C.-W. Chan, US 2002/0179885 A1, 2002.
[xii] J. Kamatani, S. Okada, A. Tsuboyama, T. Takiguchi, S. Igawa, US 2003/186080 A1, 2003.
[xiii] P. Stößel, I. Bach, A. Büsing (Covion Organic Semiconductors GmbH), DE 10350606 A1, 2005.
[xiv] M. Bold, C. Lennartz, M. Egen, H.-W. Schmidt, M. Thelakkat, M. Bäte, C. Neuber, W. Kowalsky, C. Schildknecht (BASF AG), DE 10338550 A1, 2005.
[xv] C. Lennartz, A. Vogler, V. Pawlowski (BASF AG), DE 10358665 A1, 2005.
[xvi] B. Hsieh, T. P. S. Thoms, J. P. Chen (Canon KK, Tokyo), US 2006/989273 B2, 2006.
[xvii]N. Schulte, S. Heun, I. Bach, P. Stoessel, K. Treacher (Covion Organic Semiconductors), WO 2006/003000 A1, 2006.
[xviii] A. Vogler, V. Pawlowski, H.-W. Schmidt, M. Thelakkat (BASF AG), WO 2006/032449 A1, 2006.
[xix] T. K. Hatwar, J. P. Spindler, R. H. Young (Eastman Kodak Co), WO 2006/028546 A1, 2006.
[xx] P. C. Ford, E. Cariati, J. Bourassa, Chem. Rev. 1999, 99, 3625.
[xxi] H. Araki, K. Tsuge, Y. Sasaki, S. Ishizaka, N. Kitamura, Inorg. Chem. 2007, 46, 10032.
[xxii] A. Rössler, G. Skillas, S. E. Pratsinis, Chemie in unserer Zeit 2001, 35, 32.
[xxiii] Y. Sun, K. Ye, H. Zhang, J. Zhang, L. Zhao, B. Li, G. Yang, B. Yang, Y. Wang, S.-W. Lai, C.-M. Che, Angew. Chem. 2006, 118, 5738.
[xxiv] Y. Chen, J. F. Gerald, L. T. Chadderton, L. Chaffron, Appl. Phys. Lett. 1999, 74, 2782.

## Patentansprüche

1. Kupfer(I)komplex aufweisend eine Struktur der Formel A 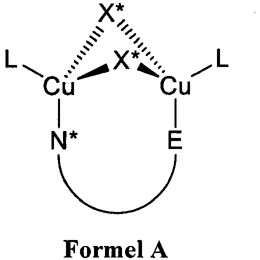 mit
X* = Cl, Br, I, CN, OCN, SCN, Alkinyl und/oder N₃ (unabhängig voneinander),
N*∩E = unabhängig voneinander ein zweibindiger Ligand mit
E = Phosphanyl/Arsenyl/Antimonyl-Rest der Form R₂E (mit R = Alkyl, Aryl, Heteroaryl, Alkoxyl, Phenoxyl, oder Amid);
N* = Imin-Funktion, die Bestandteil einer aromatische Gruppe ist, die bevorzugt ausgewählt ist aus Pyridyl, Pyridazinyl, Pyrimidyl, Pyrazinyl, Triazinyl, Tetrazinyl, Oxazolyl, Thiazolyl, Imidazolyl, Pyrazolyl, Isoxazolyl, Isothiazolyl, 1,2,3-Triazolyl, 1,2,4-Triazolyl, 1,2,4-Oxadiazolyl, 1,2,4-Thiadiazolyl, Tetrazolyl, 1,2,3,4-Oxatriazolyl, 1,2,3,4-Thiatriazole, Chinolyl, Isochinolyl, Chinoxalyl, Chinazolyl, die optional weiter substituiert und/oder anneliert sind;
"∩" = mindestens ein Kohlenstoffatom, das ebenfalls Bestandteil der aromatischen Gruppe ist, wobei sich das Kohlenstoffatom sowohl direkt benachbart zum Imin-Stickstoffatom als auch zum Phosphor-, Arsen- oder Antimonatom befindet;
L = entweder ein einzähniger Liganden DR₃ mit
D = Phosphanyl/Arsenyl/Antimonyl-Rest der Form R₃D, wobei die drei Reste R jeweils unabhängig voneinander Wasserstoff, Halogen oder Substituenten sind, die über Sauerstoff- (-OR), Stickstoff- (-NR₂) oder Siliziumatome (-SiR₃) gebunden sind sowie Alkyl-(auch verzweigt oder zyklisch), Heteroalkyl-, Aryl-, Heteroaryl-, Alkenyl-, Alkinyl-Gruppen oder substituierte Alkyl- (auch verzweigt oder zyklisch), Heteroalkyl-, Aryl-, Heteroaryl- und Alkenyl-Gruppen mit Substituenten wie Halogene oder Deuterium, Alkylgruppen (auch verzweigt oder zyklisch), Heteroalkyl-, Aryl-, Heteroaryl- und weitere Donor- und Akzeptor-Gruppen, wie beispielsweise Amine, Carboxylate und deren Ester, und CF₃-Gruppen; die drei einzelnen Reste R führen optional zu annelierten Ringsystemen; oder
ein zweizähniger Liganden R₂D-B-DR₂ mit
D = Phosphanyl/Arsenyl/Antimonyl-Rest der Form R₂D, der über eine Brücke B mit einem weiteren Rest D verbunden ist, wobei die Brücke B eine direkte Bindung oder eine substituierte oder unsubstituierte Alkylen- Alkenylen-, Alkinylen- oder Arylen-Gruppe oder eine Kombination beider, oder -O-, -NR- oder -SiR₂- ist, wobei die Reste R jeweils unabhängig voneinander Wasserstoff, Halogen oder Substituenten sind, die über Sauerstoff- (-OR), Stickstoff- (-NR₂) oder Siliziumatome (-SiR₃) gebunden sind sowie Alkyl- (auch verzweigt oder zyklisch), Heteroalkyl-, Aryl-, Heteroaryl-, Alkenyl-, Alkinyl-Gruppen oder substituierte Alkyl- (auch verzweigt oder zyklisch), Heteroalkyl-, Aryl-, Heteroaryl- und Alkenyl-Gruppen mit Substituenten wie Halogene oder Deuterium, Alkylgruppen (auch verzweigt oder zyklisch), Heteroalkyl-, Aryl-, Heteroaryl- und weitere Donor- und Akzeptor-Gruppen, wie beispielsweise Amine, Carboxylate und deren Ester, und CF₃-Gruppen; die zwei einzelnen Reste R führen optional zu annelierten Ringsystemen;
wobei mindestens ein L ungleich zu E∩N* ist;
wobei optional N*∩E und/oder L mindestens einen Substituenten zur Verbesserung des Ladungsträgertransports und/oder zur Erhöhung der Löslichkeit des Kupfer(I)komplexes in einem organischen Lösungsmittel aufweist.

2. Kupfer(I)komplex nach Anspruch 1, wobei N*∩E ausgewählt ist aus der Gruppe bestehend aus 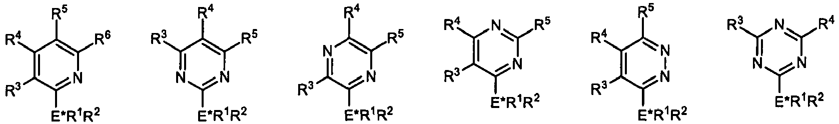 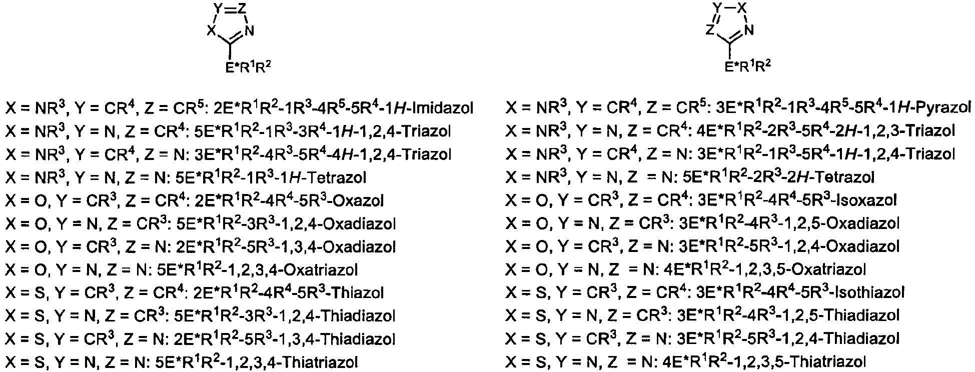 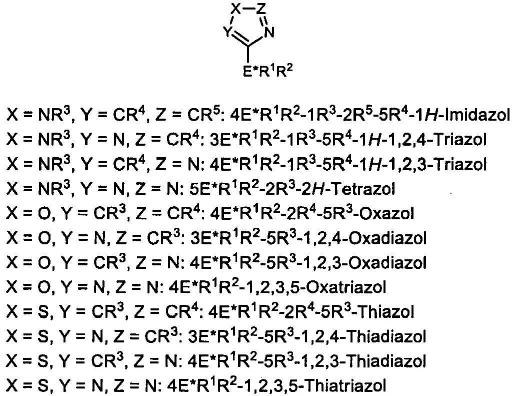 mit
E* = unabhängig voneinander P, As oder Sb
X = unabhängig voneinander NR³, O oder S
Y = unabhängig voneinander CR³, CR⁴ oder N
Z = unabhängig voneinander CR⁴, CR⁵ oder N
R¹-R⁶ sind jeweils unabhängig voneinander Wasserstoff, Halogen oder Substituenten, die über Sauerstoff- (-OR), Stickstoff (-NR₂) oder Siliziumatome (-SiR₃) gebunden sind sowie Alkyl- (auch verzweigt oder zyklisch), Heteroalkyl-, Aryl-, Heteroaryl-, Alkenyl-, Alkinyl-Gruppen oder substituierte Alkyl- (auch verzweigt oder zyklisch), Heteroalkyl-, Aryl-, Heteroaryl- und Alkenyl-Gruppen mit Substituenten wie Halogene oder Deuterium, Alkylgruppen (auch verzweigt oder zyklisch), Heteroalkyl-, Aryl-, Heteroaryl- und weitere Donor- und Akzeptor-Gruppen, wie beispielsweise Amine, Carboxylate und deren Ester, und CF₃-Gruppen; R³-R⁶ führen optional zu annelierten Ringsystemen;
und Ligand L aufweist oder besteht aus:
entweder zwei, optional unterschiedlichen, einzähnigen Liganden DR₃ mit D = unabhängig voneinander P, As oder Sb
R in DR₃ ist jeweils unabhängig voneinander Wasserstoff, Halogen oder Substituenten, die über Sauerstoff- (-OR), Stickstoff- (-NR₂) oder Siliziumatome (-SiR₃) gebunden sind sowie Alkyl- (auch verzweigt oder zyklisch), Heteroalkyl-, Aryl-, Heteroaryl-, Alkenyl-, Alkinyl-Gruppen oder substituierte Alkyl- (auch verzweigt oder zyklisch), Heteroalkyl-, Aryl-, Heteroaryl- und Alkenyl-Gruppen mit Substituenten wie Halogene oder Deuterium, Alkylgruppen (auch verzweigt oder zyklisch), Heteroalkyl-, Aryl-, Heteroaryl- und weitere Donor- und Akzeptor-Gruppen, wie beispielsweise Amine, Carboxylate und deren Ester, und CF₃-Gruppen; die drei einzelnen Reste R führen optional zu annelierten Ringsystemen;
oder einem zweizähnigen Liganden R₂D-B-DR₂ mit:
D = unabhängig voneinander P, As oder Sb
R in R₂D ist jeweils unabhängig voneinander Wasserstoff, Halogen oder Substituenten, die über Sauerstoff- (-OR), Stickstoff- (-NR₂) oder Siliziumatome (-SiR₃) gebunden sind sowie Alkyl- (auch verzweigt oder zyklisch), Heteroalkyl-, Aryl-, Heteroaryl-, Alkenyl-, Alkinyl-Gruppen oder substituierte Alkyl- (auch verzweigt oder zyklisch), Heteroalkyl-, Aryl-, Heteroaryl- und Alkenyl-Gruppen mit Substituenten wie Halogene oder Deuterium, Alkylgruppen (auch verzweigt oder zyklisch), Heteroalkyl-, Aryl-, Heteroaryl- und weitere Donor- und Akzeptor-Gruppen, wie beispielsweise Amine, Carboxylate und deren Ester, und CF₃-Gruppen, die über eine Brücke B mit einem weiteren Rest D verbunden ist und damit einen zweizähnigen Liganden bildet, wobei die Brücke B eine direkte Bindung oder eine substituierte oder unsubstituierte Alkylen-, Alkenylen-, Alkinylen- oder Arylen-Gruppe oder eine Kombination beider, oder -O-, -NR- oder -SiR₂- ist; die zwei einzelnen Reste R führen optional zu anellierten Ringsystemen; wobei R₂D-B-DR₂ bevorzugt ausgewählt ist aus:

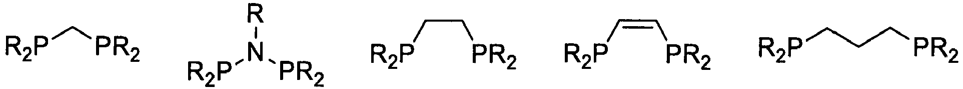

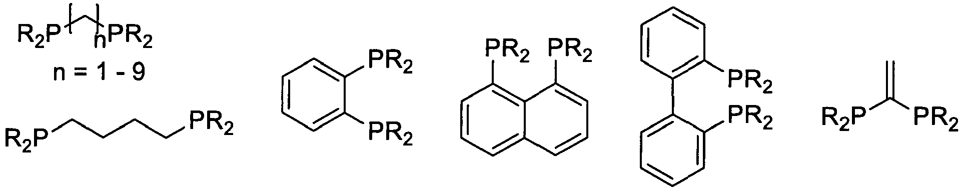

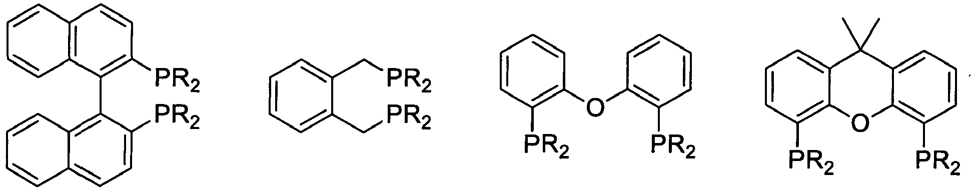

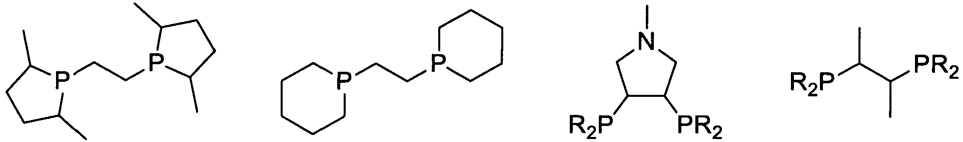

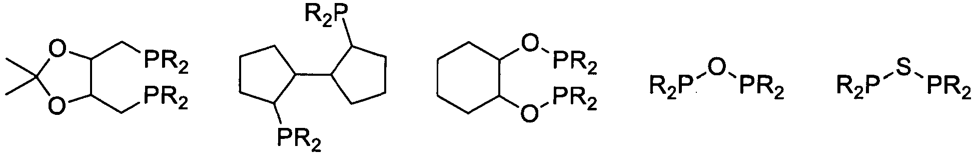

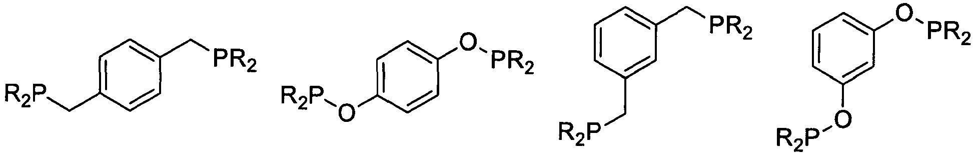

3. Kupfer(I)komplex nach Anspruch 1 oder 2, wobei der Substituent zur Erhöhung der Löslichkeit ausgewählt ist aus der Gruppe bestehend aus:
- verzweigten oder unverzweigten oder zyklischen langkettigen Alkylketten einer Länge von C1 bis C30,
- verzweigten oder unverzweigten oder zyklischen langkettigen Alkoxyketten einer Länge von C1 bis C30,
verzweigten oder unverzweigten oder zyklischen langkettigen Perfluoralkylketten einer Länge von C1 bis C30, und
- kurzkettigen Polyethern mit einer Kettenlänge von 3-50 Wiederholungseinheiten und/oder wobei der Substituent zur Verbesserung des Ladungsträgertransports ausgewählt ist aus der Gruppe bestehend aus Elektronenleiter und Lochleiter.

4. Verfahren zur Herstellung eines Kupfer(I)komplexes nach Anspruch 1 bis 3, aufweisend den Schritt:
Durchführen einer Reaktion von N*∩E und L mit Cu(I)X,
wobei
X* = Cl, Br, I, CN, OCN, SCN, Alkinyl und/oder N₃ (unabhängig voneinander),
N*∩E = ein zweibindiger Ligand mit
E = Phosphanyl/Arsenyl/Antimonyl-Rest der Form R₂E (mit R = Alkyl, Aryl, Heteroaryl, Alkoxyl, Phenoxyl, oder Amid);
N* = Imin-Funktion, die Bestandteil einer aromatische Gruppe ist, die bevorzugt ausgewählt ist aus Pyridyl, Pyridazinyl, Pyrimidyl, Pyrazinyl, Triazinyl, Tetrazinyl, Oxazolyl, Thiazolyl, Imidazolyl, Pyrazolyl, Isoxazolyl, Isothiazolyl, 1,2,3-Triazolyl, 1,2,4-Triazolyl, 1,2,4-Oxadiazolyl, 1,2,4-Thiadiazolyl, Tetrazolyl, 1,2,3,4-Oxatriazolyl, 1,2,3,4-Thiatriazolyl, Chinolyl, Isochinolyl, Chinoxalyl, Chinazolyl, die optional weiter substituiert und/oder anneliert sind;
"∩" = mindestens ein Kohlenstoffatom, das ebenfalls Bestandteil der aromatischen Gruppe ist, wobei sich das Kohlenstoffatom sowohl direkt benachbart zum Imin-Stickstoffatom als auch zum Phosphor-, Arsen- oder Antimonatom befindet; und
L in Form entweder unabhängig voneinander zweier einzähnigen Liganden DR₃ mit
D = Phosphanyl/Arsenyl/Antimonyl-Rest der Form R₃D, wobei die drei Reste R jeweils unabhängig voneinander Wasserstoff, Halogen oder Substituenten sind, die über Sauerstoff- (-OR), Stickstoff (-NR₂) oder Siliziumatome (-SiR₃) gebunden sind sowie Alkyl-(auch verzweigt oder zyklisch), Heteroalkyl-, Aryl-, Heteroaryl-, Alkenyl-, Alkinyl-Gruppen oder substituierte Alkyl- (auch verzweigt oder zyklisch), Heteroalkyl-, Aryl-, Heteroaryl- und Alkenyl-Gruppen mit Substituenten wie Halogene oder Deuterium, Alkylgruppen (auch verzweigt oder zyklisch), Heteroalkyl-, Aryl-, Heteroaryl- und weitere Donor- und Akzeptor-Gruppen, wie beispielsweise Amine, Carboxylate und deren Ester, und CF₃-Gruppen; die drei einzelnen Reste R führen optional zu annelierten Ringsystemen; oder
in Form eines zweizähnigen Liganden R₂D-B-DR₂ mit
D = Phosphanyl/Arsenyl/Antimonyl-Rest der Form R₂D, die über eine Brücke B mit einem weiteren Rest D verbunden ist, wobei die Brücke B eine direkte Bindung oder eine substituierte oder unsubstituierte Alkylen-, Alkenylen-, Alkinylen- oder Arylen-Gruppe oder eine Kombination beider, oder -O-, -NR- oder -SiR₂- ist, wobei die Reste R jeweils unabhängig voneinander Wasserstoff, Halogen oder Substituenten sind, die über Sauerstoff- (-OR), Stickstoff- (-NR₂) oder Siliziumatome (-SiR₃) gebunden sind sowie Alkyl- (auch verzweigt oder zyklisch), Heteroalkyl-, Aryl-, Heteroaryl-, Alkenyl-, Alkinyl-Gruppen oder substituierte Alkyl- (auch verzweigt oder zyklisch), Heteroalkyl-, Aryl-, Heteroaryl- und Alkenyl-Gruppen mit Substituenten wie Halogene oder Deuterium, Alkylgruppen (auch verzweigt oder zyklisch), Heteroalkyl-, Aryl-, Heteroaryl- und weitere Donor- und Akzeptor-Gruppen, wie beispielsweise Amine, Carboxylate und deren Ester, und CF₃-Gruppen; die zwei Reste R führen optional zu annelierten Ringsystemen.

5. Verfahren nach Anspruch 4, wobei die Reaktion in Dichlormethan, Acetonitril, Tetrahydrofuran, Dimethylsulfoxid und/oder Ethanol durchgeführt wird.

6. Verfahren nach Anspruch 4 oder 5, weiterhin aufweisend den Schritt der Zugabe von Diethylether, Pentan, Hexan, Methyl-tert-butylether, Methanol, Ethanol und/oder Wasser zur Gewinnung des Kupfer(I)komplexes in Form eines Feststoffs.

7. Verfahren nach Anspruch 4 bis 6, weiterhin aufweisend den Schritt der Substitution mindestens eines Liganden N*∩E und/oder mindestens eines Liganden L mit mindestens einem Substituenten zur Erhöhung der Löslichkeit, der ausgewählt sein kann aus der Gruppe bestehend aus:
- langkettigen, verzweigten oder unverzweigten oder zyklischen Alkylketten einer Länge von C1 bis C30,
- langkettigen, verzweigten oder unverzweigten oder zyklischen Alkoxyketten einer Länge von C1 bis C30,
- verzweigten oder unverzweigten oder zyklischen Perfluoralkylketten einer Länge von C1 bis C30, und
- kurzkettigen Polyethern.

8. Verfahren nach Anspruch 4 bis 7, weiterhin aufweisend den Schritt der Substitution mindestens eines Liganden N*∩E und/oder L mit mindestens einer funktionellen Gruppe zur Verbesserung des Ladungsträgertransports, die ausgewählt ist aus Elektronenleiter und Lochleiter.

9. Verwendung eines Kupfer(I)komplexes nach Anspruch 1 bis 3 als Emitter oder Absorber in einem optoelektronischen Bauelement.

10. Verwendung nach Anspruch 9, wobei das optoelektronische Bauelement ausgewählt ist aus der Gruppe bestehend aus:
- Organischen Licht-emittierenden Bauteilen (OLEDs),
- Licht-emittierenden elektrochemischen Zellen,
- OLED-Sensoren, insbesondere in nicht hermetisch nach außen abgeschirmten Gas- und Dampf-Sensoren,
- organischen Solarzellen,
- Organischen Feldeffekttransistoren,
- Organischen Lasern und
- Down-Konversions-Elementen.

11. Verwendung nach Anspruch 9 oder 10, **dadurch gekennzeichnet, dass** der Anteil des Kupfer(I)komplexes am Emitter oder Absorber 100 % beträgt.

12. Verwendung nach Anspruch 9 oder 10, **dadurch gekennzeichnet, dass** der Anteil des Kupfer(I)komplexes am Emitter oder Absorber 1 % bis 99 % beträgt.

13. Verwendung nach Anspruch 9, 10 oder 12, **dadurch gekennzeichnet, dass** die Konzentration des Kupfer(I)komplexes als Emitter in optischen Licht emittierenden Bauelementen, insbesondere in OLEDs, zwischen 5 % und 80 % beträgt.

14. Optoelektronisches Bauelement, aufweisend einen Kupfer(I)komplex nach Anspruch 1 bis 3.

15. Optoelektronisches Bauelement nach Anspruch 14, ausgeformt als ein Bauelement ausgewählt aus der Gruppe bestehend aus organischem lichtemittierendem Bauelement, organischer Diode, organischer Solarzelle, organischem Transistor, organischer lichtemittierender Diode, Licht-emittierender elektrochemischer Zelle, organischem Feldeffekttransistor und organischem Laser.

16. Verfahren zur Herstellung eines optoelektronischen Bauelements, wobei ein Kupfer(I)komplex nach Anspruch 1 bis 3 verwendet wird.

17. Verfahren nach Anspruch 16, **gekennzeichnet durch**
Aufbringen eines Kupfer(I)komplexes nach Anspruch 1 bis 3 auf einen Träger, wobei das Aufbringen insbesondere nass-chemisch, mittels kolloidaler Suspension oder mittels Sublimation erfolgt.

18. Verfahren zur Veränderung der Emissions- und/oder Absorptionseigenschaften eines elektronischen Bauelements, **gekennzeichnet durch**
Einbringen eines Kupfer(I)komplexes nach Anspruch 1 bis 3 in ein Matrixmaterial zur Leitung von Elektronen oder Löchern in einem optoelektronischen Bauelement.

19. Verwendung eines Kupfer(I)komplexes nach Anspruch 1 bis 3, insbesondere in einem optoelektronischen Bauelement, zur Umwandlung von UV-Strahlung oder von blauem Licht in sichtbares Licht, insbesondere in grünes, gelbes oder rotes Licht (Down-Konversion).

## Claims

1. Copper(I) complex comprising a structure of formula A 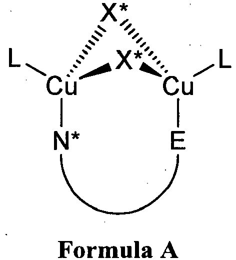 with
X* = Cl, Br, I, CN, OCN, SCN, alkynyl and/or N₃ (independently from each other),
N*∩E = independently from each other a bidentate ligand with
E = phosphanyl/arsanyl/antimonyl group of the form R₂E (with R = alkyl, aryl, heteroaryl, alkoxyl, phenoxyl, or amide);
N* = imine function which is part of an aromatic group, which is preferably selected from pyridyl, pyridazinyl, pyrimidyl, pyrazinyl, triazinyl, tetrazinyl, oxazolyl, thiazolyl, imidazolyl, pyrazolyl, isoxazolyl, isothiazolyl, 1,2,3-triazolyl, 1,2,4-triazolyl, 1,2,4-oxadiazolyl, 1,2,4-thiadiazolyl, tetrazolyl, 1,2,3,4-oxatriazolyl, 1,2,3,4-thiatriazole, chinolyl, isochinolyl, chinoxalyl, chinazolyl which are optionally further substituted and/or annulated;
"∩" = at least one carbon atom which is likewise part of the aromatic group, wherein the carbon atom is directly adjacent both to the imine nitrogen atom and to the phosphorus, arsenic or antimony atom;
L = either a monodentate ligand DR₃ with
D = phosphanyl/arsanyl/antimonyl group of the form R₃D, wherein the three groups R are each independently from each other hydrogen, halogen or substituents, which are bound via oxygen (-OR), nitrogen (-NR₂) or silicon atoms (-SiR₃) as well as alkyl (also branched or cyclic), heteroalkyl, aryl, heteroaryl, alkenyl, alkynyl groups or substituted alkyl (also branched or cyclic), heteroalkyl, aryl, heteroaryl and alkenyl groups with substituents such as halogens or deuterium, alkyl groups (also branched or cyclic), heteroalkyl, aryl, heteroaryl and further donor and acceptor groups such as for example amines, carboxylates and their esters and CF₃ groups; the three individual groups R optionally lead to annulated ring systems;
or
a bidentate ligand R₂D-B-DR₂ with
D = phosphanyl/arsanyl/antimonyl group of the form R₂D, that is bound to another group D via a bridge B, wherein the bridge B is a direct bond or a substituted or unsubstituted alkylene, alkenylene, alkynylene or arylene group or a combination of both, or -O-, -NR- or - SiR₂-, wherein the groups R are each independently from each other hydrogen, halogen or substituents, which are bound via oxygen (-OR), nitrogen (-NR₂) or silicon atoms (-SiR₃) as well as alkyl (also branched or cyclic), heteroalkyl, aryl, heteroaryl, alkenyl, alkynyl groups or substituted alkyl (also branched or cyclic), heteroalkyl, aryl, heteroaryl and alkenyl groups with substituents such as halogens or deuterium, alkyl groups (also branched or cyclic), heteroalkyl, aryl, heteroaryl and further donor and acceptor groups such as for example amines, carboxylates and their esters and CF₃ groups; the two individual groups R optionally lead to annulated ring systems;
wherein at least one L is dissimilar to E∩N*;
wherein N*∩E and/or L optionally comprise at least one substituent for improving the charge carrier transport and/or increasing the solubility of the copper(I) complex in an organic solvent.

2. Copper(I) complex according to claim 1, wherein N*∩E is selected from the group consisting of 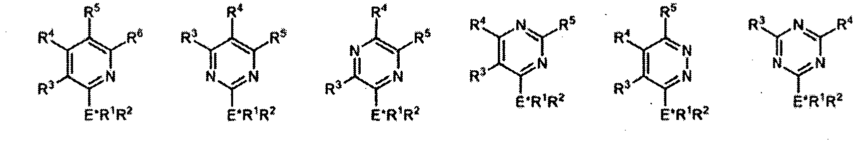 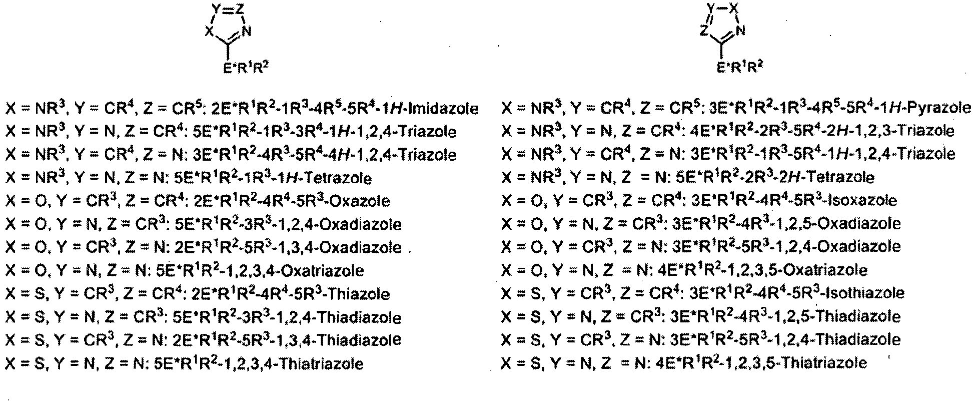 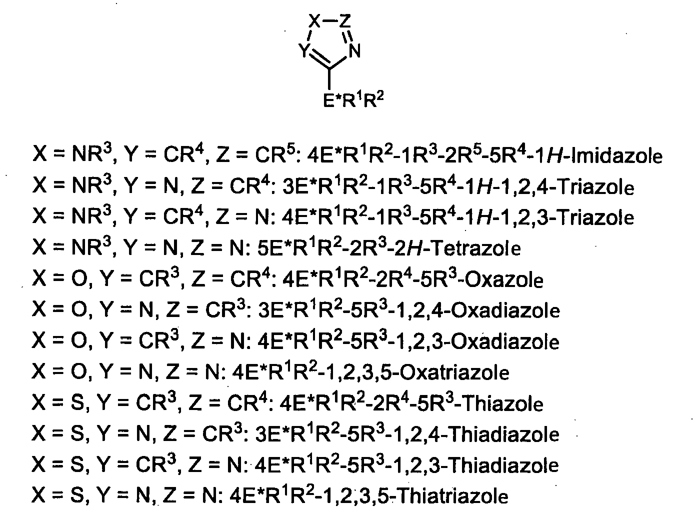 with
E* = independently from each other P, As or Sb
X = independently from each other NR³, O or S
Y = independently from each other CR³, CR⁴ or N
Z = independently from each other CR⁴, CR⁵ or N
R¹-R⁶ are each independently from each other hydrogen, halogen or substituents, which are bound via oxygen (-OR), nitrogen (-NR₂) or silicon atoms (-SiR₃) as well as alkyl (also branched or cyclic), heteroalkyl, aryl, heteroaryl, alkenyl, alkynyl groups or substituted alkyl (also branched or cyclic), heteroalkyl, aryl, heteroaryl and alkenyl groups with substituents such as halogens or deuterium, alkyl groups (also branched or cyclic), heteroalkyl, aryl, heteroaryl and further donor and acceptor groups such as for example amines, carboxylates and their esters and CF₃ groups; R³-R⁶ optionally lead to annulated ring systems;
and ligand L comprises or consists of:
either two, optionally different, monodentate ligands DR₃ with
D = independently from each other P, As or Sb
R in DR₃ is each independently from each other hydrogen, halogen or substituents, which are bound via oxygen (-OR), nitrogen (-NR₂) or silicon atoms (-SiR₃) as well as alkyl (also branched or cyclic), heteroalkyl, aryl, heteroaryl, alkenyl, alkynyl groups or substituted alkyl (also branched or cyclic), heteroalkyl, aryl, heteroaryl and alkenyl groups with substituents such as halogens or deuterium, alkyl groups (also branched or cyclic), heteroalkyl, aryl, heteroaryl and further donor and acceptor groups such as for example amines, carboxylates and their esters and CF₃ groups; the three individual groups R optionally lead to annulated ring systems;
or a bidentate ligand R₂D-B-DR₂ with:
D = independently from each other P, As or Sb
R in R₂D is each independently from each other hydrogen, halogen or substituents, which are bound via oxygen (-OR), nitrogen (-NR₂) or silicon atoms (-SiR₃) as well as alkyl (also branched or cyclic), heteroalkyl, aryl, heteroaryl, alkenyl, alkynyl groups or substituted alkyl (also branched or cyclic), heteroalkyl, aryl, heteroaryl and alkenyl groups with substituents such as halogens or deuterium, alkyl groups (also branched or cyclic), heteroalkyl, aryl, heteroaryl and further donor and acceptor groups such as for example amines, carboxylates and their esters and CF₃ groups, which are bound to another group D via a bridge B and thus form a bidentate ligand, wherein the bridge B is a direct bond or a substituted or unsubstituted alkylene, alkenylene, alkynylene or arylene group or a combination of both, or -O-, -NR- or -SiR₂-; the two individual groups R optionally lead to annulated ring systems, wherein R₂D-B-DR₂ is preferably selected from:

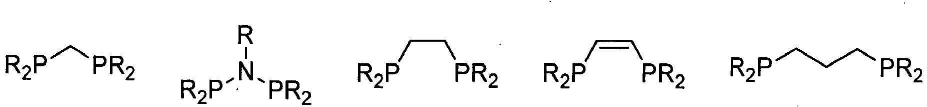

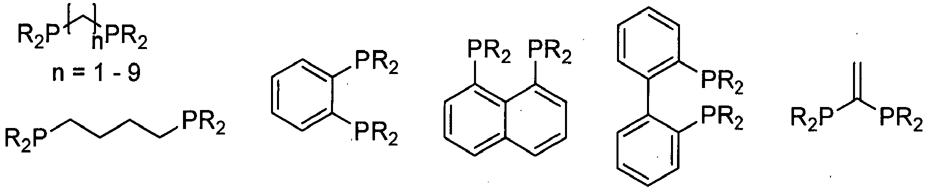

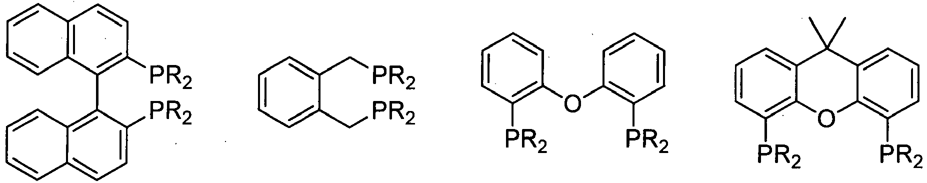

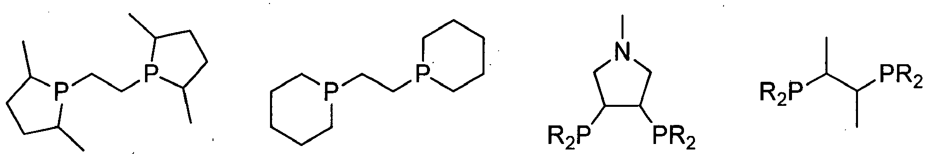

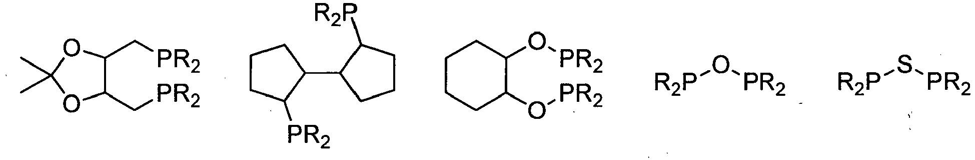

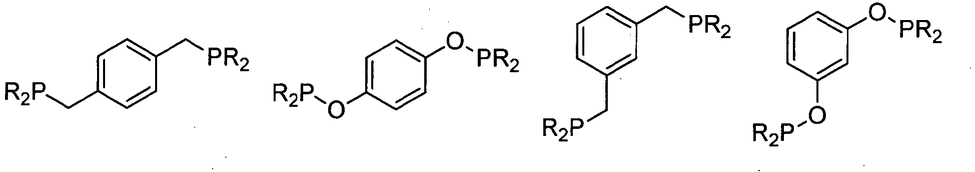

3. Copper(I) complex according to claim 1 or 2, wherein the substituent for increasing the solubility is selected from the group consisting of:
- branched or unbranched or cyclic long-chain alkyl chains with a length of C1 to C30,
- branched or unbranched or cyclic long-chain alkoxy chains with a length of C1 to C30, branched or unbranched or cyclic long-chain perfluoroalkyl chains with a length of C1 to C30, and
- short-chain polyethers with a chain length of 3-50 repeat units and/or wherein the substituent for improving the charge carrier transport is selected from the group consisting of electron conductor and hole conductor.

4. Method for the production of a copper(I) complex according to claims 1 to 3, comprising the step:
Conducting a reaction of N*∩E and L with Cu(I)X,
wherein
X* = Cl, Br, I, CN, OCN, SCN, alkynyl and/or N₃ (independently from each other),
N*∩E = a bidentate ligand with
E = phosphanyl/arsanyl/antimonyl group of the form R₂E (with R = alkyl, aryl, heteroaryl, alkoxyl, phenoxyl, or amide);
N* = imine function, which is part of an aromatic group, which is preferably selected from pyridyl, pyridazinyl, pyrimidyl, pyrazinyl, triazinyl, tetrazinyl, oxazolyl, thiazolyl, imidazolyl, pyrazolyl, isoxazolyl, isothiazolyl, 1,2,3-triazolyl, 1,2,4-triazolyl, 1,2,4-oxadiazolyl, 1,2,4-thiadiazolyl, tetrazolyl, 1,2,3,4-oxatriazolyl, 1,2,3,4-thiatriazolyl, chinolyl, isochinolyl, chinoxalyl, chinazolyl, which are optionally further substituted and/or annulated; "∩" = at least one carbon atom which is likewise part of the aromatic group, wherein the carbon atom is directly adjacent both to the imine nitrogen atom and to the phosphorus, arsenic or antimony atom; and
L in form of either independently from each other two monodentate ligands DR₃ with
D = phosphanyl/arsanyl/antimonyl group of the form R₃D, wherein the three groups R are each independently from each other hydrogen, halogen or substituents, which are bound via oxygen (-OR), nitrogen (-NR₂) or silicon atoms (-SiR₃) as well as alkyl (also branched or cyclic), heteroalkyl, aryl, heteroaryl, alkenyl, alkynyl groups or substituted alkyl (also branched or cyclic), heteroalkyl, aryl, heteroaryl and alkenyl groups with substituents such as halogens or deuterium, alkyl groups (also branched or cyclic), heteroalkyl, aryl, heteroaryl and further donor and acceptor groups such as for example amines, carboxylates and their esters and CF₃ groups; the three individual groups R optionally lead to annulated ring systems; or
in form of a bidentate ligand R₂D-B-DR₂ with
D = phosphanyl/arsanyl/antimonyl group of the form R₂D, that is bound to another group D via a bridge B, wherein the bridge B is a direct bond or a substituted or unsubstituted alkylene, alkenylene, alkynylene or arylene group or a combination of both, or -O-, -NR- or - SiR₂-, wherein the groups R are each independently from each other hydrogen, halogen or substituents, which are bound via oxygen (-OR), nitrogen (-NR₂) or silicon atoms (-SiR₃) as well as alkyl (also branched or cyclic), heteroalkyl, aryl, heteroaryl, alkenyl, alkynyl groups or substituted alkyl (also branched or cyclic), heteroalkyl, aryl, heteroaryl and alkenyl groups with substituents such as halogens or deuterium, alkyl groups (also branched or cyclic), heteroalkyl, aryl, heteroaryl and further donor and acceptor groups such as for example amines, carboxylates and their esters and CF₃ groups; the two groups R optionally lead to annulated ring systems;

5. Method according to claim 4, wherein the reaction is conducted in dichloromethane, acetonitrile, tetrahydrofuran, dimethylsulfoxide and/or ethanol.

6. Method according to claim 4 or 5, further comprising the step of addition of diethyl ether, pentane, hexane, methyl-tert-butyl ether, methanol, ethanol and/or water for obtaining the copper(I) complex in form of a solid.

7. Method according to claims 4 to 6, further comprising the step of the substitution of at least one ligand N*∩E and/or at least one ligand L with at least one substituent for increasing solubility, which can be selected from the group consisting of:
- long-chain, branched or unbranched or cyclic alkyl chains with a length of C1 to C30,
- long-chain, branched or unbranched or cyclic alkoxy chains with a length of C1 to C30,
- branched or unbranched or cyclic perfluoralkyl chains with a length of C1 to C30, and
- short-chain polyethers.

8. Method according to claims 4 to 7, further comprising the step of the substitution of at least one ligand N*∩E and/or L with at least one functional group for improving charge carrier transport, which is selected from electron conductor and hole conductor.

9. Use of a copper(I) complex according to claims 1 to 3 as emitter or absorber in an optoelectronic component.

10. Use according to claim 9, wherein the optoelectronic component is selected from the group consisting of:
- Organic light emitting components (OLEDs),
- Light emitting electrochemical cells,
- OLED sensors, especially in gas and vapor sensors without hermetic shielding on the outside,
- Organic solar cells,
- Organic field-effect transistors,
- Organic lasers, and
- Down-conversion elements.

11. Use according to claim 9 or 10, **characterized in that** the percentage of the copper(I) complex on the emitter or absorber is 100 %.

12. Use according to claim 9 or 10, **characterized in that** the percentage of the copper(I) complex on the emitter or absorber is 1 % to 99 %.

13. Use according to claim 9, 10 or 12, **characterized in that** the concentration of the copper(I) complex as emitter in optical light emitting components, in particular in OLEDs, is between 5 % and 80 %.

14. Optoelectronic component comprising a copper(I) complex according to claims 1 to 3.

15. Optoelectronic component according to claim 14, in the form of a component selected from the group consisting of organic light emitting component, organic diode, organic solar cell, organic transistor, organic light emitting diode, light emitting electrochemical cell, organic field-effect transistor and organic laser.

16. Method for the production of an optoelectronic component, wherein a copper(I) complex according to claim 1 to 3 is used.

17. Method according to claim 16, **characterized by**
application of a copper(I) complex according to claims 1 to 3 to a carrier, wherein the application is in particular effected by wet-chemical means, by means of colloidal suspension or by means of sublimation.

18. A process for altering the emission and/or absorption properties of an electronic component, **characterized by**
introduction of a copper(I) complex according to claims 1 to 3 into a matrix material for conduction of electrons or holes in an optoelectronic component.

19. The use of a copper(I) complex according to claims 1 to 3, in particular in an optoelectronic component, for conversion of UV radiation or of blue light to visible light, in particular to green, yellow or red light (down-conversion).

## Revendications

1. Complexe de cuivre (I) présentant une structure de formule A 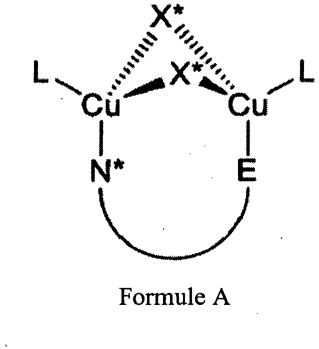 avec
X* = Cl, Br, I, CN, OCN, SCN, alcynyle et/ou N₃ (indépendamment l'un de l'autre),
N*∩E = indépendamment l'un de l'autre un ligand bivalent avec
E = radical phosphanyle/arsenyle/antimonyle de la forme R₂E (avec R = alkyle, aryle, hétéroaryle, alcoxyle, phénoxyle ou amide) ;
N* = fonction imine, qui fait partie d'un groupe aromatique, qui est de préférence choisi parmi pyridyle, pyridazinyle, pyrimidyle, pyrazinyle, triazinyle, tétrazinyle, oxazolyle, thiazolyle, imidazolyle, pyrazolyle, isoxazolyle, isothiazolyle, 1,2,3-triazolyle, 1,2,4-triazolyle, 1,2,4-oxadiazolyle, 1,2,4-thiadiazolyle, tétrazolyle, 1,2,3,4-oxatriazolyle, 1,2,3,4-thiatriazole, quinolyle, isoquinolyle, quinoxalyle, quinazolyle, qui sont éventuellement davantage substitués et/ou annelés ;
« ∩ » = au moins un atome de carbone, qui fait également partie du groupe aromatique, l'atome de carbone étant aussi bien directement voisin de l'atome d'azote de l'imine que de l'atome de phosphore, d'arsenic ou d'antimoine ;
L = un ligand monodentate DR₃ avec
D = radical phosphanyle/arsenyle/antimonyle de la forme R₃D, les trois radicaux R étant chacun indépendamment les uns des autres hydrogène, halogène ou des substituants qui sont reliés par des atomes d'oxygène (-OR), d'azote (-NR₂) ou de silicium (-SiR₃), ainsi que des groupes alkyle (également ramifiés ou cycliques), hétéroalkyle, aryle, hétéroaryle, alcényle, alcynyle, ou des groupes alkyle (également ramifiés ou cycliques), hétéroalkyle, aryle, hétéroaryle et alcényle substitués avec des substituants tels que des halogènes ou le deutérium, des groupes alkyle (également ramifiés ou cycliques), des groupes hétéroalkyle, aryle, hétéroaryle et d'autres groupes donneurs et accepteurs, tels que par exemple des amines, des carboxylates et leurs esters, et des groupes CF₃ ; les trois radicaux R individuels conduisant éventuellement à des systèmes cycliques annelés ;
ou
un ligand bidentate R₂D-B-DR₂ avec
D = radical phosphanyle/arsenyle/antimonyle de la forme R₂D, qui est relié par un pont B avec un radical D supplémentaire, le pont B étant une liaison directe ou un groupe alkylène, alcénylène, alcynylène ou arylène substitué ou non substitué, ou une combinaison des deux, ou -O-, -NR- ou -SiR₂-, les radicaux R étant chacun indépendamment les uns des autres hydrogène, halogène ou des substituants qui sont reliés par des atomes d'oxygène (-OR), d'azote (-NR₂) ou de silicium (-SiR₃), ainsi que des groupes alkyle (également ramifiés ou cycliques), hétéroalkyle, aryle, hétéroaryle, alcényle, alcynyle, ou des groupes alkyle (également ramifiés ou cycliques), hétéroalkyle, aryle, hétéroaryle et alcényle substitués avec des substituants tels que des halogènes ou le deutérium, des groupes alkyle (également ramifiés ou cycliques), des groupes hétéroalkyle, aryle, hétéroaryle et d'autres groupes donneurs et accepteurs, tels que par exemple des amines, des carboxylates et leurs esters, et des groupes CF₃ ; les deux radicaux R individuels conduisant éventuellement à des systèmes cycliques annelés ;
au moins un L étant différent de E∩N*;
N*∩E et/ou L comprenant éventuellement au moins un substituant pour l'amélioration du transport des porteurs de charges et/ou pour l'élévation de la solubilité du complexe de cuivre (I) dans un solvant organique.

2. Complexe de cuivre (I) selon la revendication 1, dans lequel N*∩E est choisi dans le groupe constitué par 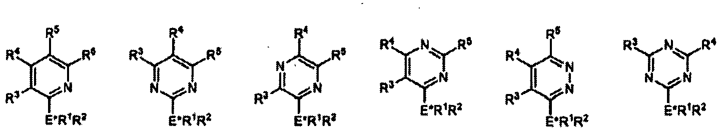 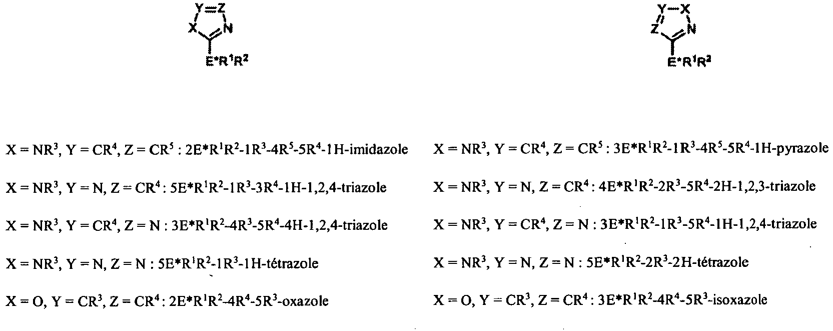 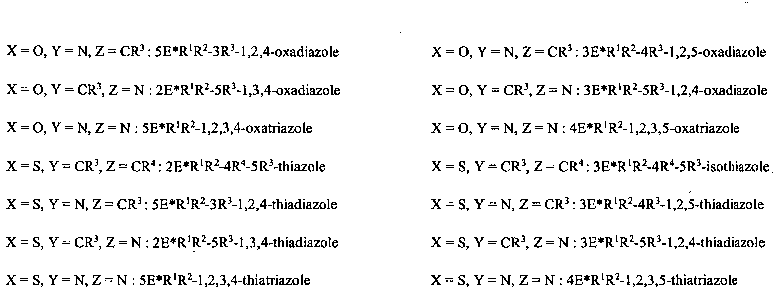 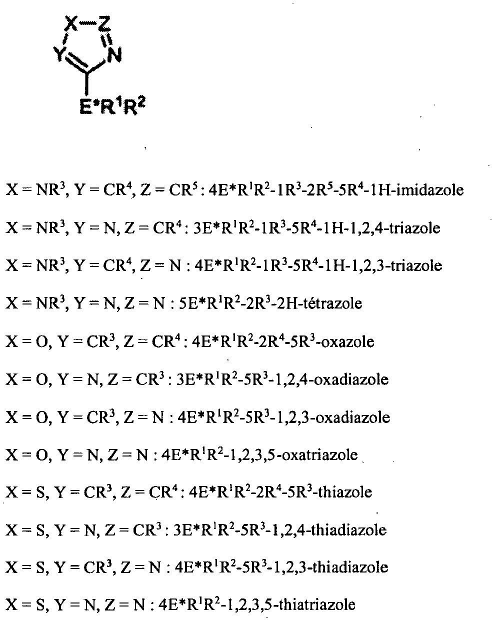 avec
E* = indépendamment les uns des autres P, As ou Sb,
X = indépendamment les uns des autres NR³, O ou S,
Y = indépendamment les uns des autres CR³, CR³ ou N,
Z = indépendamment les uns des autres CR⁴, CR⁵ ou N,
R¹ à R⁶ chacun indépendamment les uns des autres hydrogène, halogène ou des substituants qui sont reliés par des atomes d'oxygène (-OR), d'azote (-NR₂) ou de silicium (-SiR₃), ainsi que des groupes alkyle (également ramifiés ou cycliques), hétéroalkyle, aryle, hétéroaryle, alcényle, alcynyle, ou des groupes alkyle (également ramifiés ou cycliques), hétéroalkyle, aryle, hétéroaryle et alcényle substitués avec des substituants tels que des halogènes ou le deutérium, des groupes alkyle (également ramifiés ou cycliques), des groupes hétéroalkyle, aryle, hétéroaryle et d'autres groupes donneurs et accepteurs, tels que par exemple des amines, des carboxylates et leurs esters, et des groupes CF₃ ; R³ à R⁶ conduisant éventuellement à des systèmes cycliques annelés ;
et le ligand L comprenant ou étant constitué par :
deux ligands monodentates DR₃ éventuellement différents, avec
D = indépendamment les uns des autres P, As ou Sb,
les R dans DR₃ étant chacun indépendamment les uns des autres hydrogène, halogène ou des substituants, qui sont reliés par des atomes d'oxygène (-OR), d'azote (-NR₂) ou de silicium (-SiR₃), ainsi que des groupes alkyle (également ramifiés ou cycliques), hétéroalkyle, aryle, hétéroaryle, alcényle, alcynyle, ou des groupes alkyle (également ramifiés ou cycliques), hétéroalkyle, aryle, hétéroaryle et alcényle substitués avec des substituants tels que des halogènes ou le deutérium, des groupes alkyle (également ramifiés ou cycliques), des groupes hétéroalkyle, aryle, hétéroaryle et d'autres groupes donneurs et accepteurs, tels que par exemple des amines, des carboxylates et leurs esters, et des groupes CF₃ ; les trois radicaux R individuels conduisant éventuellement à des systèmes cycliques annelés ;
ou un ligand bidentate R₂D-B-DR₂, avec
D = indépendamment les uns des autres P, As ou Sb,
les R dans R₂D étant chacun indépendamment les uns des autres hydrogène, halogène ou des substituants, qui sont reliés par des atomes d'oxygène (-OR), d'azote (-NR₂) ou de silicium (-SiR₃), ainsi que des groupes alkyle (également ramifiés ou cycliques), hétéroalkyle, aryle, hétéroaryle, alcényle, alcynyle, ou des groupes alkyle (également ramifiés ou cycliques), hétéroalkyle, aryle, hétéroaryle et alcényle substitués avec des substituants tels que des halogènes ou le deutérium, des groupes alkyle (également ramifiés ou cycliques), des groupes hétéroalkyle, aryle, hétéroaryle et d'autres groupes donneurs et accepteurs, tels que par exemple des amines, des carboxylates et leurs esters, et des groupes CF₃, qui est relié par un pont B avec un radical D supplémentaire et forme ainsi un ligand bidentate, le pont B étant une liaison directe ou un groupe alkylène, alcénylène, alcynylène ou arylène substitué ou non substitué, ou une combinaison des deux, ou -O-, -NR- ou - SiR₂- ; les deux radicaux R individuels conduisant éventuellement à des systèmes cycliques annelés ; R₂D-B-DR₂ étant de préférence choisi parmi :

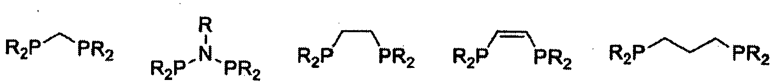

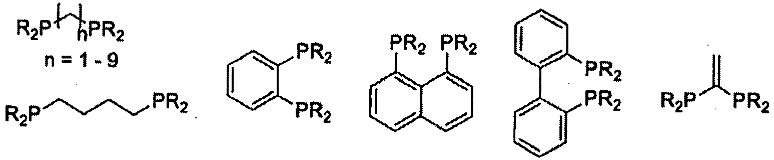

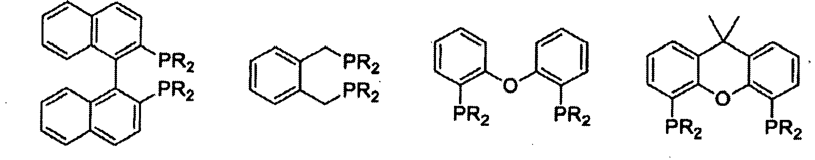

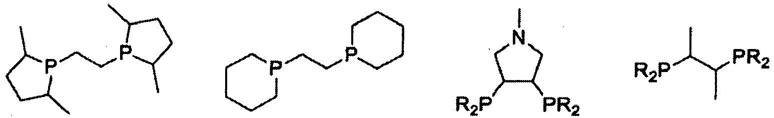

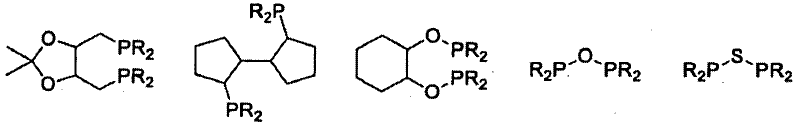

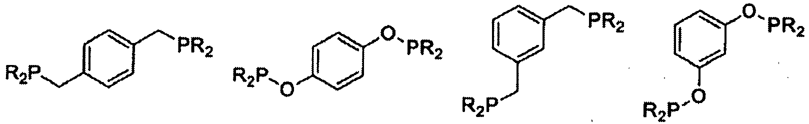

3. Complexe de cuivre (I) selon la revendication 1 ou 2, dans lequel le substituant pour l'élévation de la solubilité est choisi dans le groupe constitué par :
- les chaînes alkyle longues ramifiées ou non ramifiées ou cycliques d'une longueur de C1 à C30,
- les chaînes alcoxy longues ramifiées ou non ramifiées ou cycliques d'une longueur de C1 à C30,
- les chaînes perfluoroalkyle longues ramifiées ou non ramifiées ou cycliques d'une longueur de C1 à C30, et
- les polyéthers courts d'une longueur de chaîne de 3 à 50 unités de répétition,
et/ou dans leqel le substituant pour l'amélioration du transport des porteurs de charges est choisi dans le groupe constitué par les conducteurs d'électrons et les conducteurs de trous.

4. Procédé de fabrication d'un complexe de cuivre (I) selon les revendications 1 à 3, comprenant l'étape suivante :
la réalisation d'une réaction de N*∩E et L avec Cu(I)X,
avec
X* = Cl, Br, I, CN, OCN, SCN, alcynyle et/ou N₃ (indépendamment les uns des autres),
N*∩E = un ligand bivalent avec
E = radical phosphanyle/arsenyle/antimonyle de la forme R₂E (avec R = alkyle, aryle, hétéroaryle, alcoxyle, phénoxyle ou amide) ;
N* = fonction imine, qui fait partie d'un groupe aromatique, qui est de préférence choisi parmi pyridyle, pyridazinyle, pyrimidyle, pyrazinyle, triazinyle, tétrazinyle, oxazolyle, thiazolyle, imidazolyle, pyrazolyle, isoxazolyle, isothiazolyle, 1,2,3-triazolyle, 1,2,4-triazolyle, 1,2,4-oxadiazolyle, 1,2,4-thiadiazolyle, tétrazolyle, 1,2,3,4-oxatriazolyle, 1,2,3,4-thiatriazole, quinolyle, isoquinolyle, quinoxalyle, quinazolyle, qui sont éventuellement davantage substitués et/ou annelés ;
« ∩ » = au moins un atome de carbone, qui fait également partie du groupe aromatique, l'atome de carbone étant aussi bien directement voisin de l'atome d'azote de l'imine que de l'atome de phosphore, d'arsenic ou d'antimoine ; et
L sous la forme de deux ligands monodentates DR₃ indépendants l'un de l'autre avec
D = radical phosphanyle/arsenyle/antimonyle de la forme R₃D, les trois radicaux R étant chacun indépendamment les uns des autres hydrogène, halogène ou des substituants qui sont reliés par des atomes d'oxygène (-OR), d'azote (-NR₂) ou de silicium (-SiR₃), ainsi que des groupes alkyle (également ramifiés ou cycliques), hétéroalkyle, aryle, hétéroaryle, alcényle, alcynyle, ou des groupes alkyle (également ramifiés ou cycliques), hétéroalkyle, aryle, hétéroaryle et alcényle substitués avec des substituants tels que des halogènes ou le deutérium, des groupes alkyle (également ramifiés ou cycliques), des groupes hétéroalkyle, aryle, hétéroaryle et d'autres groupes donneurs et accepteurs, tels que par exemple des amines, des carboxylates et leurs esters, et des groupes CF₃ ; les trois radicaux R individuels conduisant éventuellement à des systèmes cycliques annelés ;
ou
sous la forme d'un ligand bidentate R₂D-B-DR₂ avec
D = radical phosphanyle/arsenyle/antimonyle de la forme R₂D, qui est relié par un pont B avec un radical D supplémentaire, le pont B étant une liaison directe ou un groupe alkylène, alcénylène, alcynylène ou arylène substitué ou non substitué, ou une combinaison des deux, ou -O-, -NR- ou -SiR₂-, les radicaux R étant chacun indépendamment les uns des autres hydrogène, halogène ou des substituants qui sont reliés par des atomes d'oxygène (-OR), d'azote (-NR₂) ou de silicium (-SiR₃), ainsi que des groupes alkyle (également ramifiés ou cycliques), hétéroalkyle, aryle, hétéroaryle, alcényle, alcynyle, ou des groupes alkyle (également ramifiés ou cycliques), hétéroalkyle, aryle, hétéroaryle et alcényle substitués avec des substituants tels que des halogènes ou le deutérium, des groupes alkyle (également ramifiés ou cycliques), des groupes hétéroalkyle, aryle, hétéroaryle et d'autres groupes donneurs et accepteurs, tels que par exemple des amines, des carboxylates et leurs esters, et des groupes CF₃ ; les deux radicaux R individuels conduisant éventuellement à des systèmes cycliques annelés.

5. Procédé selon la revendication 4, dans lequel la réaction est réalisée dans du dichlorométhane, de l'acétonitrile, du tétrahydrofurane, du diméthylsulfoxyde et/ou de l'éthanol.

6. Procédé selon la revendication 4 ou 5, comprenant en outre l'étape d'ajout d'éther diéthylique, de pentane, d'hexane, d'éther de méthyle et de tert.-butyle, de méthanol, d'éthanol et/ou d'eau pour l'obtention du complexe de cuivre (I) sous la forme d'un solide.

7. Procédé selon les revendications 4 à 6, comprenant en outre l'étape de substitution d'au moins un ligand N*∩E et/ou d'au moins un ligand L avec au moins un substituant pour l'élévation de la solubilité, qui peut être choisi dans le groupe constitué par :
- les chaînes alkyle longues ramifiées ou non ramifiées ou cycliques d'une longueur de C1 à C30,
- les chaînes alcoxy longues ramifiées ou non ramifiées ou cycliques d'une longueur de C1 à C30,
- les chaînes perfluoroalkyle ramifiées ou non ramifiées ou cycliques d'une longueur de C1 à C30, et
- les polyéthers courts.

8. Procédé selon les revendications 4 à 7, comprenant en outre l'étape de substitution d'au moins un ligand N*∩E et/ou L avec au moins un groupe fonctionnel pour l'amélioration du transport des porteurs de charges, qui est choisi parmi les conducteurs d'électrons et les conducteurs de trous.

9. Utilisation d'un complexe de cuivre (I) selon les revendications 1 à 3 en tant qu'émetteur ou absorbeur dans un composant optoélectronique.

10. Utilisation selon la revendication 9, dans laquelle le composant optoélectronique est choisi dans le groupe constitué par :
- les composants organiques électroluminescents (OLEDs),
- les cellules électrochimiques électroluminescentes,
- les capteurs OLED, notamment dans des capteurs à gaz et vapeur non isolés hermétiquement vers l'extérieur,
- les cellules solaires organiques,
- les transistors à effet de champ organiques,
- les lasers organiques et
- les éléments de descente en fréquence.

11. Utilisation selon la revendication 9 ou 10, **caractérisée en ce que** la proportion du complexe de cuivre (I) dans l'émetteur ou l'absorbeur est de 100 %.

12. Utilisation selon la revendication 9 ou 10, **caractérisée en ce que** la proportion du complexe de cuivre (I) dans l'émetteur ou l'absorbeur est de 1 % à 99 %.

13. Utilisation selon la revendication 9, 10 ou 12, **caractérisée en ce que** la concentration du complexe de cuivre (I) en tant qu'émetteur dans des composants optiques électroluminescents, notamment dans des OLEDs, est comprise entre 5 % et 80 %.

14. Composant optoélectronique, comprenant un complexe de cuivre (I) selon les revendications 1 à 3.

15. Composant optoélectronique selon la revendication 14, sous la forme d'un composant choisi dans le groupe constitué par un composant organique électroluminescent, une diode organique, une cellule solaire organique, un transistor organique, une diode organique électroluminescente, une cellule électrochimique électroluminescente, un transistor à effet de champ organique et un laser organique.

16. Procédé de fabrication d'un composant optoélectronique, selon lequel un complexe de cuivre (I) selon les revendications 1 à 3 est utilisé.

17. Procédé selon la revendication 16, **caractérisé par**
l'application d'un complexe de cuivre (I) selon les revendications 1 à 3 sur un support, l'application ayant notamment lieu par voie chimique humide, au moyen d'une suspension colloïdale ou par sublimation.

18. Procédé de modification des propriétés d'émission et/ou d'absorption d'un composant électronique, **caractérisé par**
l'introduction d'un complexe de cuivre (I) selon les revendications 1 à 3 dans un matériau de matrice pour la conduction d'électrons ou de trous dans un composant optoélectronique.

19. Utilisation d'un complexe de cuivre (I) selon les revendications 1 à 3, notamment dans un composant optoélectronique, pour la transformation d'un rayonnement UV ou d'une lumière bleue en une lumière visible, notamment en une lumière verte, jaune ou rouge (descente en fréquence).
